# EUROPEAN PATENT SPECIFICATION

(11) **EP 3 131 131 B1**
(45) Date of publication and mention of the grant of the patent: **25.08.2021**
(21) Application number: 15776932.4
(22) Date of filing: 30.03.2015
(51) Int. Cl.: H01L 51/54, C07D 209/86, C07D 209/88, C07D 409/14, C08G 61/00, C09K 11/06

(54) **LIGHT-EMISSION ELEMENT, AND COMPOSITION USED THEREIN**
LICHTEMISSIONSELEMENT UND DARIN VERWENDETE ZUSAMMENSETZUNG
ÉLÉMENT ÉLECTROLUMINESCENT ET COMPOSITION UTILISÉE DEDANS

(30) Priority: 09.04.2014 JP 2014080028
(43) Date of publication of application: 15.02.2017
(73) Proprietor: Sumitomo Chemical Company Limited, Tokyo 104-8260 (JP)
(72) Inventor: SASADA, Toshiaki, Tsukuba-shi Ibaraki 300-3294 (JP); TSUBATA, Yoshiaki, Tsukuba-shi Ibaraki 300-3294 (JP); YOKOYA, Seiichirou, Tsukuba-shi Ibaraki 300-3294 (JP)
(74) Representative: J A Kemp LLP
(86) International application number: PCT/JP2015/060679
(87) International publication number: WO 2015/156235

(56) References cited:
- WO-A1-2007/052431
- WO-A1-2009/102027
- WO-A1-2009/102027
- WO-A1-2013/102992
- WO-A1-2013/102992
- WO-A1-2013/108700
- JP-A- 2007 504 272
- JP-A- 2013 041 990
- JP-A- 2013 063 920
- JP-A- 2013 147 449
- JP-A- 2013 247 174
- JP-B2- 5 355 857

## Description

### Technical Field

The present invention relates to a light emitting device and a composition used in the same.

### Background Art

Light emitting devices such as an organic electroluminescent device (organic EL device) can be suitably used for applications of displays and lightings and are recently attracting attention, because of high external quantum efficiency and low driving voltage. This light emitting device has organic layers such as a light emitting layer and a charge transporting layer.

Patent document 1 discloses a light emitting device in which a metal complex A1 and a low molecular weight compound A1 represented by the following formulae are used in a light emitting layer. Patent document 2 discloses a light emitting device in which a metal complex A2 and a low molecular weight compound A2 represented by the following formulae are used in a light emitting layer.

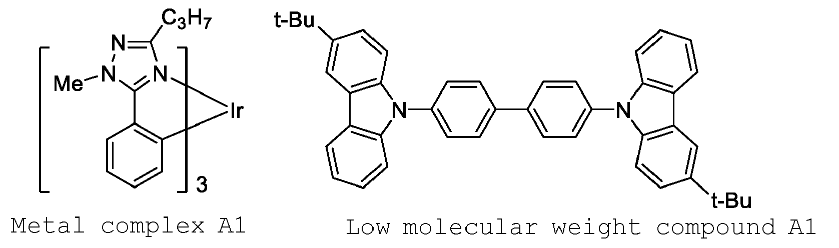

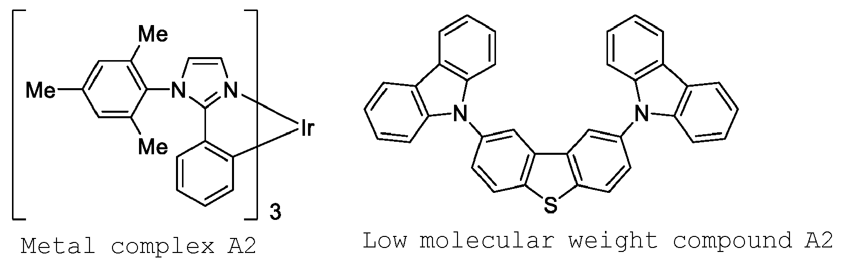

Patent document 3 describes an organic electroluminescent element characterized in that la light-emitting layer contains the following ortho-metal complex:

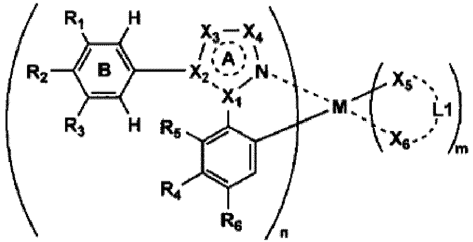

Patent document 4 describes an organic electroluminescent element including at least one organic layer containing a hexadentate ligand type ortho-metal iridium complex represented by the following general formula: 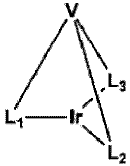 V represents a trivalent linking group having an aromatic heterocyclic and is linked with L₁ to L₃ by covalent bonds, and L₁ to L₃ represent specific aromatic nitrogen-containing heterocyclic compounds.

Patent document 5 describes materials for organic electroluminescent elements containing the following compound:

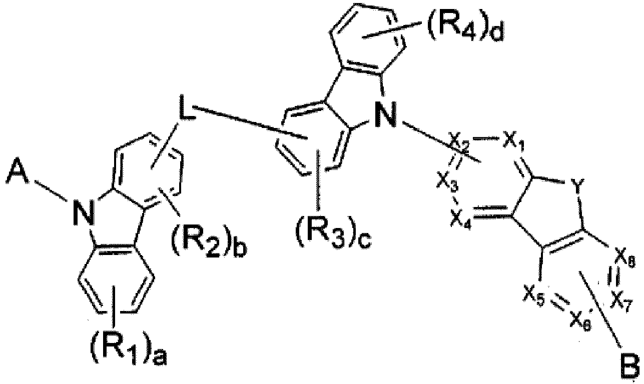

Patent document 6 describes a conjugated polymer that contains a specific structure as a repeating unit and is characterized by having an insolubilizing group serving as a substituent, a weight average molecular weight (Mw) of not less than 20,000, and a dispersity (Mw/Mn) of not more than 2.40.

Patent document 7 describes a light emitting diode comprising at least one layer of conductive doped polymer, at least one layer of organic semiconductor, and at least one buffer layer formed by crosslinking a polymer located, wherein the buffer layer is between the conductive doped polymer layer and the organic semiconductor layer.

### Prior Art Document

### Patent Document

Patent document 1: International Publication WO2004/101707
Patent document 2: JP-A No. 2010-135467
Patent document 3: JP 2013 041990 A
Patent document 4: JP 2013 247174 A
Patent document 5: WO 2013/102992 A1
Patent document 6: WO 2009/102027 A1
Patent document 7: JP 5 355857 B2

### Summary of the Invention

### Problems to be Solved by the Invention

The light emitting devices disclosed in Patent documents 1 and 2 described above, however, did not necessarily have sufficient external quantum efficiency.

Then, the present invention has an object of providing a light emitting device excellent in external quantum efficiency. Further, the present invention has an object of providing a composition which is useful for production of a light emitting device excellent in external quantum efficiency.

### Means for Solving the Problems

In a first aspect, the present invention provides a light emitting device comprising
an anode,
a cathode,
a first organic layer disposed between the anode and the cathode and
a second organic layer disposed between the anode and the cathode,
wherein the first organic layer is a layer obtained by using a composition comprising a compound represented by the formula (H-A) and a metal complex represented by the formula (1), and
the second organic layer is a layer obtained by using a polymer compound comprising a constitutional unit having a crosslinkable group: 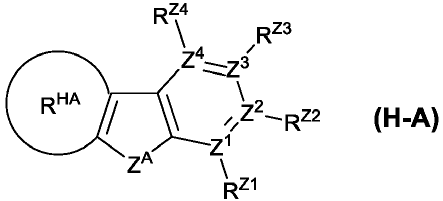 [wherein,
Z^{A} represents a group represented by -C(R^{ZA})₂-, a group represented by -Si(R^{ZA})₂-, a group represented by -N(R^{ZA})-, a group represented by -B(R^{ZA})-, a group represented by -P(R^{ZA})-, a group represented by -P(=O)(R^{ZA})-, a sulfur atom or an oxygen atom. R^{ZA} represents a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. When a plurality of R^{ZA} are present, they may be the same or different and may be combined together to form a ring together with the atoms to which they are attached.

Z¹, Z², Z³ and Z⁴ each independently represent a carbon atom or a nitrogen atom. At least one of Z¹, Z², Z³ and Z⁴ is a carbon atom.

R^{Z1}, R^{Z2}, R^{Z3} and R^{Z4} each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. R^{Z1} is not present when Z¹ is a nitrogen atom. R^{Z2} is not present when Z² is a nitrogen atom. R^{Z3} is not present when Z³ is a nitrogen atom. R^{Z4} is not present when Z⁴ is a nitrogen atom. At least one of R^{Z1}, R^{Z2}, R^{Z3} and R^{Z4} is a monovalent heterocyclic group represented by the formula (H-1).

The ring R^{HA} represents an aromatic hydrocarbon ring or an aromatic heterocyclic ring, and these rings each optionally have a substituent. When a plurality of the substituents are present, they may be the same or different and may be combined together to form a ring together with the atoms to which they are attached.

R^{Z1} and R^{Z2}, R^{Z2} and R^{Z3}, R^{Z3} and R^{Z4}, R^{Z1} and R^{ZA}, a substituent which the ring R^{HA} optionally has and R^{ZA}, and a substituent which the ring R^{HA} optionally has and R^{Z4} each may be combined together to form a ring together with the atoms to which they are attached.] 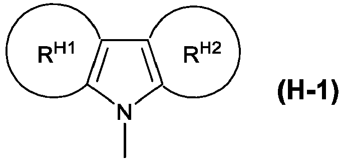 [wherein,
the ring R^{H1} and the ring R^{H2} each independently represent an aromatic hydrocarbon ring or an aromatic heterocyclic ring, and these rings each optionally have a substituent. When a plurality of the substituents are present, they may be the same or different and may be combined together to form a ring together with the atoms to which they are attached.] 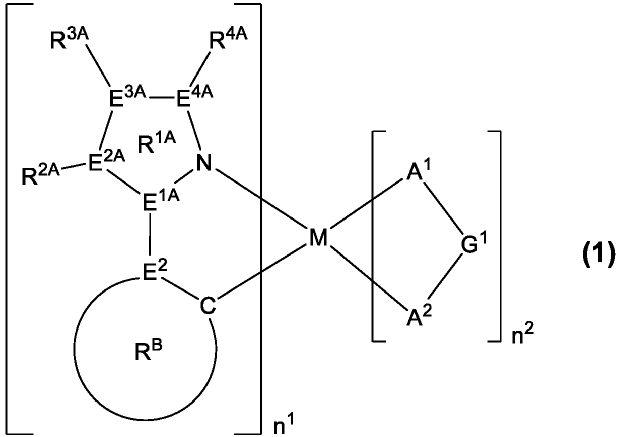 [wherein,
M represents a ruthenium atom, a rhodium atom, a palladium atom, an iridium atom or a platinum atom.

n¹ represents an integer of 1 or more, n² represents an integer of 0 or more, and n¹+n² is 2 or 3. n¹+n² is 3 when M is a ruthenium atom, a rhodium atom or an iridium atom, while n¹+n² is 2 when M is a palladium atom or a platinum atom.

E^{1A} represents a carbon atom, E^{2A}, E^{3A} and E^{4A} each independently represent a nitrogen atom or a carbon atom. Two of E^{2A}, E^{3A} and E^{4A} are a nitrogen atom and the remaining one is a carbon atom. When a plurality of E^{2A}, E^{3A} and E^{4A} are present, they may be the same or different at each occurrence.

E² represents a carbon atom or a nitrogen atom.

R^{2A} represents a hydrogen atom, an alkyl group, a cycloalkyl group, an alkoxy group, a cycloalkoxy group, an aryl group, an aryloxy group, a monovalent heterocyclic group, a halogen atom or a dendron, and these groups each optionally have a substituent. R^{3A} and R^{4A} each independently represent an alkyl group, a cycloalkyl group, an alkoxy group, a cycloalkoxy group, an aryl group, an aryloxy group, a monovalent heterocyclic group, a halogen atom or a dendron, and these groups each optionally have a substituent. When a plurality of R^{2A}, R^{3A} and R^{4A} are present, they may be the same or different at each occurrence. R^{2A} and R^{3A}, R^{3A} and R^{4A}, and a substituent which the ring R^{B} optionally has and R^{2A} each may be combined together to form a ring together with the atoms to which they are attached. R^{2A} may be either present or not present when E^{2A} is a nitrogen atom. R^{3A} may be either present or not present when E^{3A} is a nitrogen atom. R^{4A} may be either present or not present when E^{4A} is a nitrogen atom.

The ring R^{1A} represents a triazole ring constituted of a nitrogen atom, E^{1A}, E^{2A}, E^{3A} and E^{4A}.

The ring R^{B} represents a 5-membered or 6-membered aromatic hydrocarbon ring or a 5-membered or 6-membered aromatic heterocyclic ring, and these rings each optionally have a substituent. When a plurality of the substituents are present, they may be the same or different and may be combined together to form a ring together with the atoms to which they are attached. When a plurality of the rings R^{B} are present, they may be the same or different. E² is a carbon atom when the ring R^{B} is a 6-membered aromatic heterocyclic ring.

A¹-G¹-A² represents an anionic bidentate ligand, and G¹ represents an atomic group constituting a bidentate ligand together with A¹ and A². A¹ and A² each independently represent a carbon atom, an oxygen atom or a nitrogen atom, and these atoms each may be a carbon atom, an oxygen atom or a nitrogen atom constituting a ring. When a plurality of A¹-G¹-A² are present, they may be the same or different.].

In a second aspect, the present invention provides a composition comprising
a compound represented by the formula (H-B) and
a metal complex represented by the formula (1-A1): 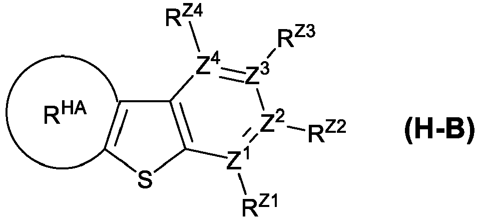 [wherein,
Z¹, Z², Z³ and Z⁴ each independently represent a carbon atom or a nitrogen atom. At least one of Z¹, Z², Z³ and Z⁴ is a carbon atom.

R^{Z1}, R^{Z2}, R^{Z3} and R^{Z4} each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. R^{Z1} is not present when Z¹ is a nitrogen atom. R^{Z2} is not present when Z² is a nitrogen atom. R^{Z3} is not present when Z³ is a nitrogen atom. R^{Z4} is not present when Z⁴ is a nitrogen atom. At least one of R^{Z1}, R^{Z2}, R^{Z3} and R^{Z4} is a monovalent heterocyclic group represented by the formula (H-1).

The ring R^{HA} represents an aromatic hydrocarbon ring or an aromatic heterocyclic ring, and these rings each optionally have a substituent. When a plurality of the substituents are present, they may be the same or different and may be combined together to form a ring together with the atoms to which they are attached.

R^{Z1} and R^{Z2}, R^{Z2} and R^{Z3}, R^{Z3} and R^{Z4}, R^{Z1} and R^{ZA}, and a substituent which the ring R^{HA} optionally has and R^{Z4} each may be combined together to form a ring together with the atoms to which they are attached.] 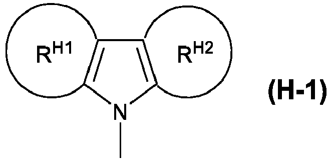 [wherein,
the ring R^{H1} and the ring R^{H2} each independently represent an aromatic hydrocarbon ring or an aromatic heterocyclic ring, and these rings each optionally have a substituent. When a plurality of the substituents are present, they may be the same or different and may be combined together to form a ring together with the atoms to which they are attached.] 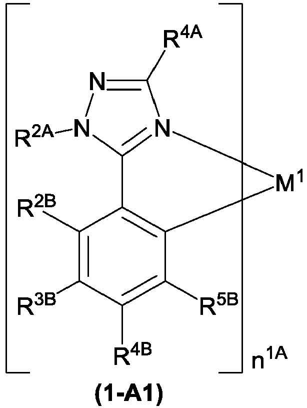 [wherein,
M¹ represents an iridium atom or a platinum atom.

n^{1A} represents an integer of 2 or 3, and n^{1A} is 3 when M¹ is iridium, while n^{1A} is 2 when M¹ is platinum.

R^{2A}, R^{2B}, R^{3B}, R^{4B} and R^{5B} each independently represent a hydrogen atom, an alkyl group, a cycloalkyl group, an alkoxy group, a cycloalkoxy group, an aryl group, an aryloxy group, a monovalent heterocyclic group, a halogen atom or a dendron, and these groups each optionally have a substituent. R^{4A} represents an alkyl group, a cycloalkyl group, an aryl group, a monovalent heterocyclic group or a dendron and these groups each optionally have a substituent. When a plurality of R^{2A}, R^{4A}, R^{2B}, R^{3B}, R^{4B} and R^{5B} are present, they may be the same or different at each occurrence. R^{2A} and R^{2B}, R^{2B} and R^{3B}, R^{3B} and R^{4B}, and R^{4B} and R^{5B} each may be combined together to form a ring together with the atoms to which they are attached, and at least one of R^{2B}, R^{3B} and R^{4B} is a dendron.].

### Effect of the Invention

The present invention can provide a light emitting device excellent in external quantum efficiency. Further, the present invention can provide a composition which is useful for production of a light emitting device excellent in external quantum efficiency.

### Modes for Carrying Out the Invention

Suitable embodiments of the present invention will be illustrated in detail below.

### <Explanation of common term>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a light hydrogen atom or a heavy hydrogen atom.

A solid line representing a bond to a central metal in a formula representing a metal complex denotes a coordinate bond or a covalent bond.

"Polymer compound" denotes a polymer having molecular weight distribution and having a polystyrene-equivalent number average molecular weight of 1×10³ to 1×10⁸.

A polymer compound may be any of a block copolymer, a random copolymer, an alternating copolymer and a graft copolymer, and may also be another embodiment.

An end group of a polymer compound is preferably a stable group because if a polymerization active group remains intact at the end, when the polymer compound is used for fabrication of a light emitting device, the light emitting property or luminance life possibly becomes lower. This end group is preferably a group having a conjugated bond to the main chain, and includes, for example, groups bonding to an aryl group or a monovalent heterocyclic group via a carbon-carbon bond.

"Low molecular weight compound" denotes a compound having no molecular weight distribution and having a molecular weight of 1×10⁴ or less.

"Constitutional unit" denotes a unit structure found once or more in a polymer compound.

"Alkyl group" may be any of linear or branched. The number of carbon atoms of the linear alkyl group is, not including the number of carbon atoms of a substituent, usually 1 to 50, preferably 3 to 30, more preferably 4 to 20. The number of carbon atoms of the branched alkyl groups is, not including the number of carbon atoms of a substituent, usually 3 to 50, preferably 3 to 30, more preferably 4 to 20.

The alkyl group optionally has a substituent, and examples thereof include a methyl group, an ethyl group, a propyl group, an isopropyl group, a butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and groups obtained by substituting a hydrogen atom in these groups with a cycloalkyl group, an alkoxy group, a cycloalkoxy group, an aryl group, a fluorine atom or the like, and the alkyl group having a substituent includes, for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl) propyl group and a 6-ethyloxyhexyl group.

The number of carbon atoms of a cycloalkyl group is, not including the number of carbon atoms of a substituent, usually 3 to 50, preferably 3 to 30, more preferably 4 to 20.

The cycloalkyl group optionally has a substituent, and examples thereof include a cyclohexyl group, a cyclohexylmethyl group and a cyclohexylethyl group.

"Aryl group" denotes an atomic group remaining after removing from an aromatic hydrocarbon one hydrogen atom linked directly to a carbon atom constituting the ring. The number of carbon atoms of the aryl group is, not including the number of carbon atoms of a substituent, usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and groups obtained by substituting a hydrogen atom in these groups with an alkyl group, a cycloalkyl group, an alkoxy group, a cycloalkoxy group, an aryl group, a fluorine atom or the like.

"Alkoxy group" may be any of linear or branched. The number of carbon atoms of the linear alkoxy group is, not including the number of carbon atoms of a substituent, usually 1 to 40, preferably 4 to 10. The number of carbon atoms of the branched alkoxy group is, not including the number of carbon atoms of a substituent, usually 3 to 40, preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and groups obtained by substituting a hydrogen atom in these groups with a cycloalkyl group, an alkoxy group, a cycloalkoxy group, an aryl group, a fluorine atom or the like.

The number of carbon atoms of a cycloalkoxy group is, not including the number of carbon atoms of a substituent, usually 3 to 40, preferably 4 to 10.

The cycloalkoxy group optionally has a substituent, and examples thereof include a cyclohexyloxy group.

The number of carbon atoms of "Aryloxy group" is, not including the number of carbon atoms of a substituent, usually 6 to 60, preferably 7 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group, a 1-pyrenyloxy group, and groups obtained by substituting a hydrogen atom in these groups with an alkyl group, a cycloalkyl group, an alkoxy group, a cycloalkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms of the monovalent heterocyclic group is, not including the number of carbon atoms of a substituent, usually 2 to 60, preferably 4 to 20.

The monovalent heterocyclic group optionally has a substituent, and examples thereof include a thienyl group, a pyrrolyl group, a furyl group, a pyridyl group, a piperidyl group, a quinolyl group, an isoquinolyl group, a pyrimidinyl group, a triazinyl group, and groups obtained by substituting a hydrogen atom in these groups with an alkyl group, a cycloalkyl group, an alkoxy group, a cycloalkoxy group or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear or branched. The number of carbon atoms of the linear alkenyl group, not including the number of carbon atoms of the substituent, is usually 2 to 30, preferably 3 to 20. The number of carbon atoms of the branched alkenyl group, not including the number of carbon atoms of the substituent, is usually 3 to 30, preferably 4 to 20.

The number of carbon atoms of a cycloalkenyl group, not including the number of carbon atoms of the substituent, is usually 3 to 30, preferably 4 to 20.

The alkenyl group and cycloalkenyl group each optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups having a substituent.

"Alkynyl group" may be any of linear or branched. The number of carbon atoms of the alkynyl group, not including the number of carbon atoms of the substituent, is usually 2 to 20, preferably 3 to 20. The number of carbon atoms of the branched alkynyl group, not including the number of carbon atoms of the substituent, is usually 4 to 30, preferably 4 to 20.

The number of carbon atoms of a cycloalkynyl group, not including the number of carbon atoms of the substituent, is usually 4 to 30, preferably 4 to 20.

The alkynyl group and cycloalkynyl group each optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexenyl group, a 5-hexenyl group, and these groups having a substituent.

"Arylene group" denotes an atomic group remaining after removing from an aromatic hydrocarbon two hydrogen atoms linked directly to carbon atoms constituting the ring. The number of carbon atoms of the arylene group is, not including the number of carbon atoms of a substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, preferably, groups represented by the formulae (A-1) to (A-20) . The arylene group includes groups obtained by linking a plurality of these groups. 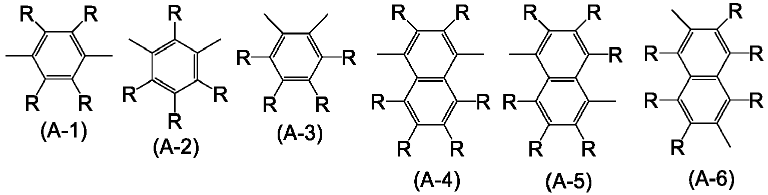 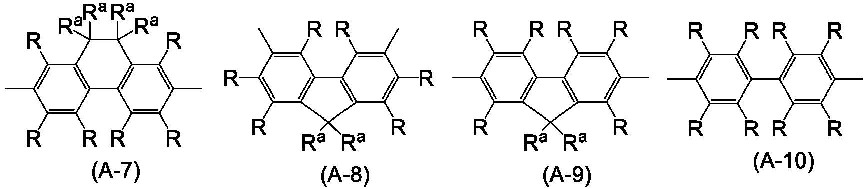 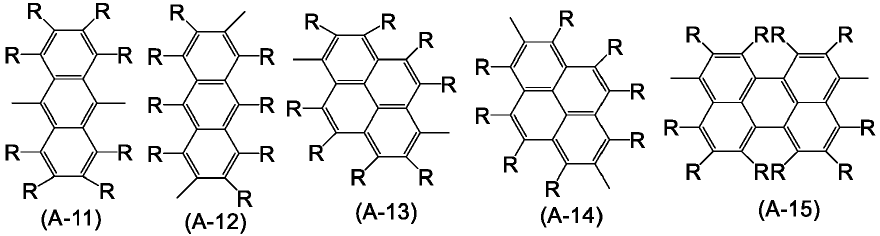 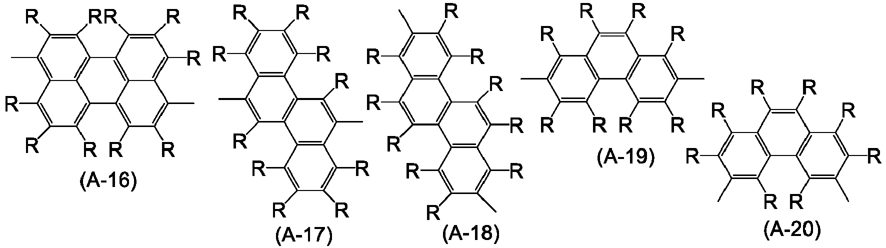 [wherein, R and R^{a} each independently represent a hydrogen atom, an alkyl group, a cycloalkyl group, an aryl group or a monovalent heterocyclic group. The plurality of R and R^{a} each may be the same or different, and groups R^{a} may be combined together to form a ring together with the atoms to which they are attached.]

The number of carbon atoms of the divalent heterocyclic group is, not including the number of carbon atoms of a substituent, usually 2 to 60, preferably 3 to 20, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the ring, preferably groups represented by the formulae (AA-1) to (AA-34). The divalent heterocyclic group includes groups obtained by linking a plurality of these groups. 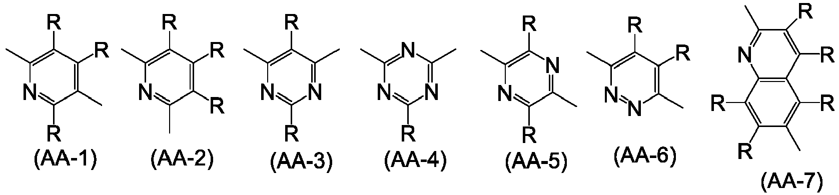 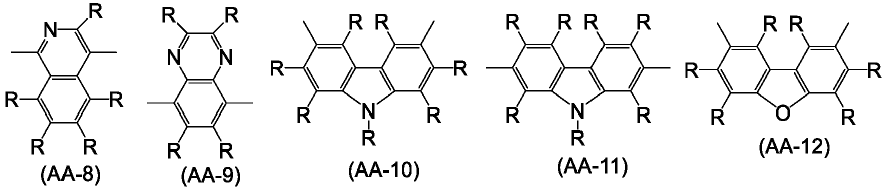 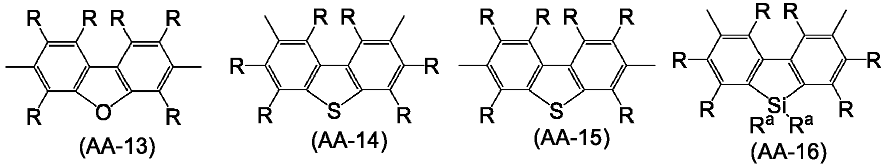 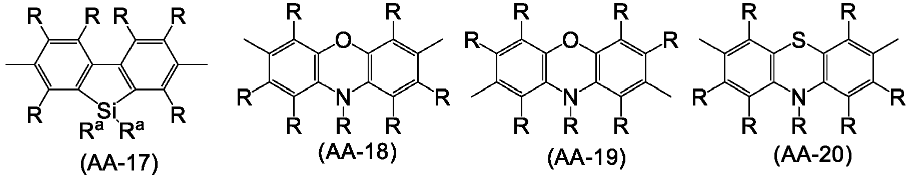 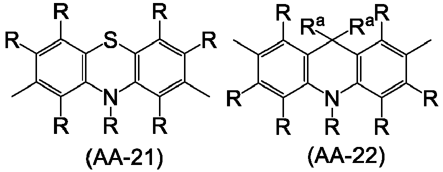 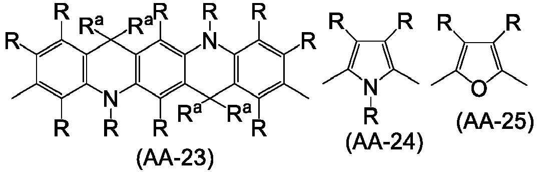 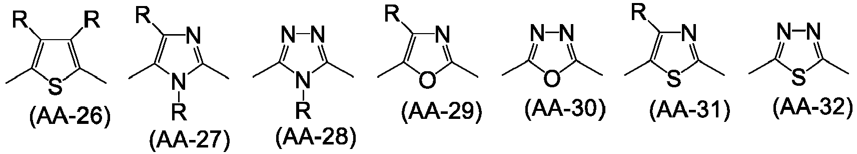 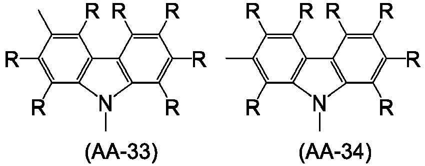 [wherein, R and R^{a} represent the same meaning as described above.]

"Crosslinkable group" is a group capable of forming a new bond by being subjected to a heating treatment, an ultraviolet irradiation treatment, a radical reaction and the like, and crosslinkable groups are preferably groups represented by the formulae (XL-1) to (XL-17) of Group A of crosslinkable group.

### (Group A of crosslinkable group)

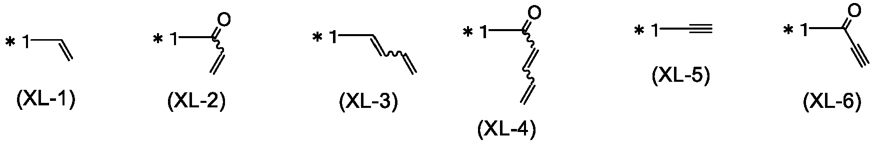

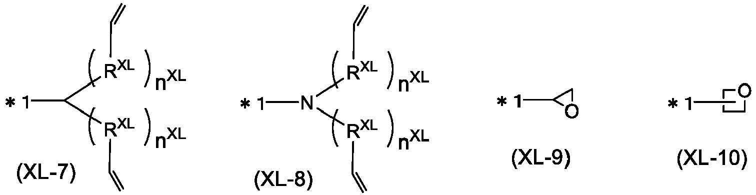

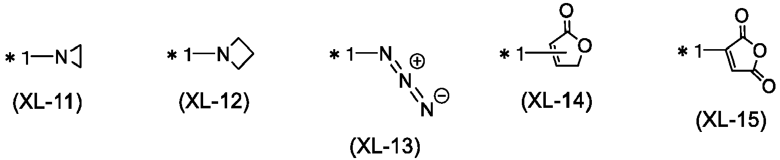

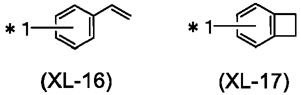

[wherein, R^{XL} represents a methylene group, an oxygen atom o r a sulfur atom, and n^{XL} represents an integer of 0 to 5. Wh en a plurality of R^{XL} are present, they may be the same or di fferent, and when a plurality of n^{XL} are present, they may b e the same or different. *1 represents a binding position. These crosslinkable groups each optionally have a substituen t.]

"Substituent" represents a halogen atom, a cyano group, an alkyl group, a cylcoalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substutuent may be a crosslinkable group or a dendron.

"Dendron" denotes a group having a regular dendritic branched structure having a branching point at an atom or ring (that is, a dendrimer structure). A compound having a dendron (hereinafter, referred to as "dendrimer") includes, for example, structures described in literatures such as International Publication WO02/067343, JP-A No. 2003-231692, International Publication WO2003/079736, International Publication WO2006/097717 and the like.

The dendron is preferably a group represented by the formula (D-A) or (D-B). 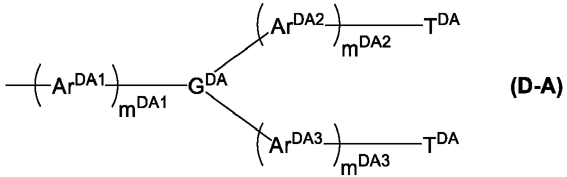 [wherein,
m^{DA1}, m^{DA2} and m^{DA3} each independently represent an integer of 0 or more.

G^{DA} represents a nitrogen atom, an aromatic hydrocarbon group or a heterocyclic group, and these groups each optionally have a substituent.

Ar^{DA1}, Ar^{DA2} and Ar^{DA3} each independently represent an arylene group or a divalent heterocyclic group, and these groups each optionally have a substituent. When a plurality of Ar^{DA1}, Ar^{DA2} and Ar^{DA3} are present, they may be the same or different at each occurrence.

T^{DA} represents an aryl group or a monovalent heterocyclic group, and these groups each optionally have a substituent. The plurality of T^{DA} may be the same or different.] 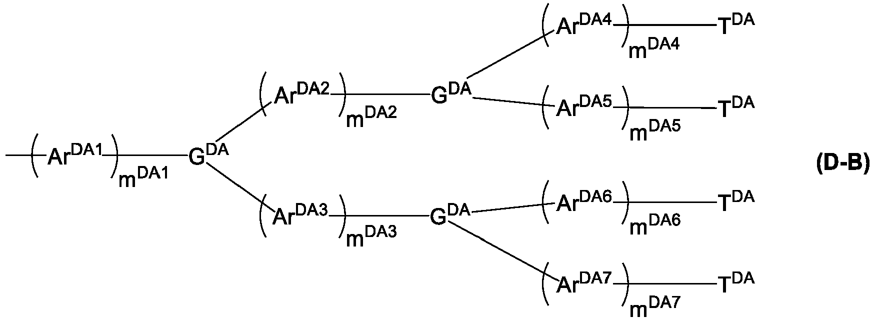 [wherein,
m^{DA1}, m^{DA2}, m^{DA3}, m^{DA4}, m^{DA5}, m^{DA6} and m^{DA7} each independently represent an integer of 0 or more.

G^{DA} represents a nitrogen atom, an aromatic hydrocarbon group or a heterocyclic group, and these groups each optionally have a substituent. The plurality of G^{DA} may be the same or different.

Ar^{DA1}, Ar^{DA2}, Ar^{DA3}, Ar^{DA4}, Ar^{DA5}, Ar^{DA6} and Ar^{DA7} each independently represent an arylene group or a divalent heterocyclic group, and these groups each optionally have a substituent. When a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence.

T^{DA} represents an aryl group or a monovalent heterocyclic group, and these groups each optionally have a substituent. The plurality of T^{DA} may be the same or different.]

m^{DA1}, m^{DA2}, m^{DA3}, m^{DA4}, m^{DA5}, m^{DA6} and m^{DA7} are usually an integer of 10 or less, preferably an integer of 5 or less, more preferably 0 or 1. It is preferable that m^{DA2}, m^{DA3}, m^{DA4}, m^{DA5}, m^{DA6} and m^{DA7} are the same integer, and it is more preferable that m^{DA1}, m^{DA2}, m^{DA3}, m^{DA4}, m^{DA5}, m^{DA6} and m^{DA7} are the same integer.

G^{DA} is preferably a group represented by the formula (GDA-11) to (GDA-15), and these groups each optionally have a substituent. 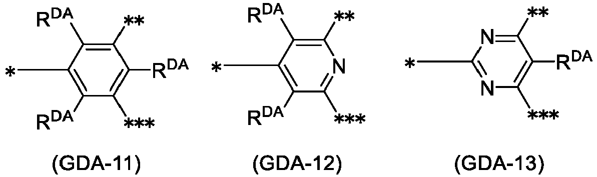 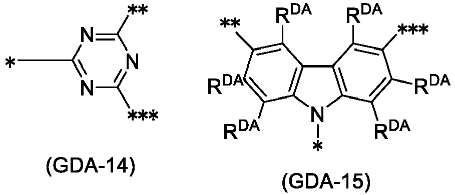 [wherein,
* represents a linkage to Ar^{DA1} in the formula (D-A), Ar^{DA1} in the formula (D-B), Ar^{DA2} in the formula (D-B) or Ar^{DA3} in the formula (D-B).
** represents a linkage to Ar^{DA2} in the formula (D-A), Ar^{DA2} in the formula (D-B), Ar^{DA4} in the formula (D-B) or Ar^{DA6} in the formula (D-B).
*** represents a linkage to Ar^{DA3} in the formula (D-A), Ar^{DA3} in the formula (D-B), Ar^{DA5} in the formula (D-B) or Ar^{DA7} in the formula (D-B).

R^{DA} represents a hydrogen atom, an alkyl group, a cycloalkyl group, an alkoxy group, a cycloalkoxy group, an aryl group or a monovalent heterocyclic group, and these groups each optionally have a substituent. When a plurality of R^{DA} are present, they may be the same or different.]

R^{DA} is preferably a hydrogen atom, an alkyl group, a cycloalkyl group, an alkoxy group or a cycloalkoxy group, more preferably a hydrogen atom, an alkyl group or cycloalkyl group, and these groups each optionally have a substituent.

It is preferable that Ar^{DA1}, Ar^{DA2}, Ar^{DA3}, Ar^{DA4}, Ar^{DA5}, Ar^{DA6} and Ar^{DA1} are groups represented by the formulae (ArDA-1) to (ArDA-3). 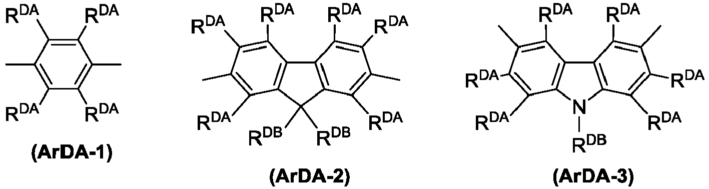 [wherein,
R^{DA} represents the same meaning as described above.

R^{DB} represents a hydrogen atom, an alkyl group, a cycloalkyl group, an aryl group or a monovalent heterocyclic group, and these groups each optionally have a substituent. When a plurality of R^{DB} are present, they may be the same or different.]

R^{DB} is preferably an alkyl group, a cycloalkyl group, an aryl group or a monovalent heterocyclic group, more preferably an aryl group or a monovalent heterocyclic group, further preferably an aryl group, and these groups each optionally have a substituent.

T^{DA} is preferably groups represented by the formulae (TDA-1) to (TDA-3). 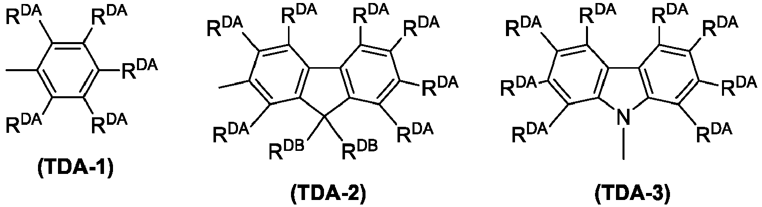 [wherein, R^{DA} and R^{DB} represent the same meaning described above.]

The group represented by the formula (D-A) is preferably a group represented by the formula (D-A1) to (D-A4), more preferably a group represented by the formula (D-A1) to (D-A3). 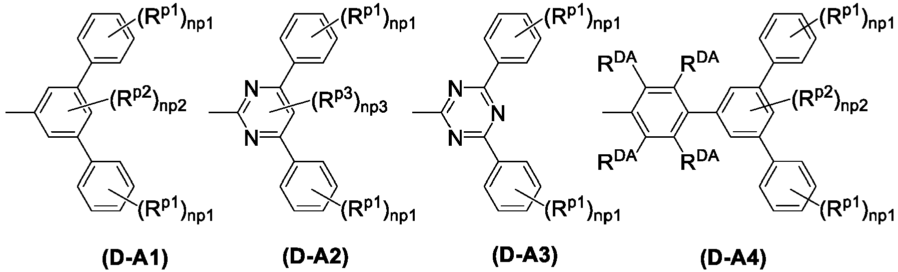 [wherein,
R^{DA} represents the same meaning as described above.

R^{p1}, R^{p2} and R^{p3} each independently represent an alkyl group, a cycloalkyl group, an alkoxy group, a cycloalkoxy group or a halogen atom. When a plurality of R^{p1} and RP2 are present, they may be the same or different at each occurrence.

np1 represents an integer of 0 to 5, np2 represents an integer of 0 to 3, and np3 represents 0 or 1. The plurality of np1 may be the same or different.]

The group represented by the formula (D-B) is preferably a group represented by the formula (D-B1) to (D-B3). 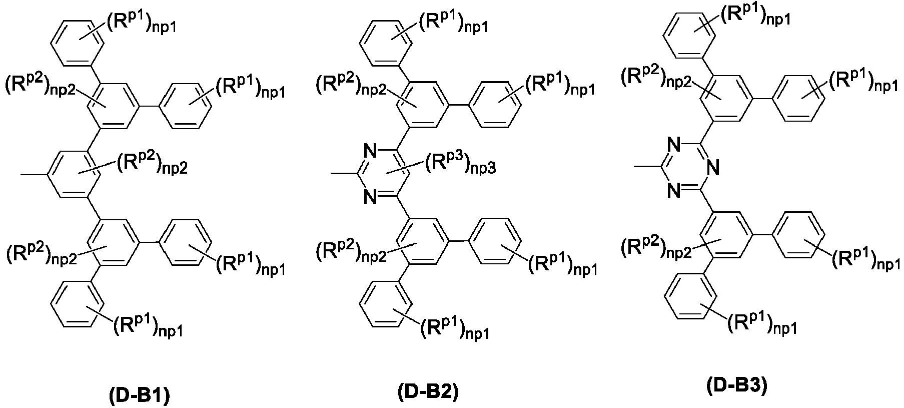 [wherein,
R^{p1}, R^{p2} and RP3 each independently represent an alkyl group, a cycloalkyl group, an alkoxy group, a cycloalkoxy group or a halogen atom. When a plurality of R^{p1} and R^{p2} are present, they may be the same or different at each occurrence.

np1 represents an integer of 0 to 5, np2 represents an integer of 0 to 3, and np3 represents 0 or 1. When a plurarity of np1 and np2 are present, they may be the same or different at each occurrence.]

np1 is preferably 0 or 1, more preferably 1. np2 is preferably 0 or 1, more preferably 0. np3 is preferably 0.

R^{p1}, R^{p2} and R^{p3} are preferably an alkyl group or a cycloalkyl group.

### <Light emitting device>

Next, the light emitting device of the present invention will be illustrated.

The light emitting device of the present invention is a light emitting device comprising an anode, a cathode, a first organic layer disposed between the anode and the cathode, and a second organic layer disposed between the anode and the cathode, wherein the first organic layer is a layer obtained by using a composition comprising a compound represented by the formula (H-A) and a metal complex represented by the formula (1), and the second organic layer is a layer obtained by using a polymer compound comprising a constitutional unit having a crosslinkable group.

"Obtained by using" regarding a relation between the first organic layer and a composition for forming the organic layer means that the first organic layer is formed by using the composition. The composition itself may be contained in the first organic layer, or materials contained in the composition may be crosslinked intramolecularly or intermolecularly or in both modes and contained in the first organic layer.

"Obtained by using" regarding a relation between the second organic layer and a polymer compound for forming the organic layer means that the second organic layer is formed by using the polymer compound. The polymer compound itself may be contained in the second organic layer, or the polymer compound may be crosslinked intramolecularly or intermolecularly or in both modes and contained in the second organic layer.

The method of forming the first organic layer and the second organic layer includes, for example, a vacuum vapor deposition method, and application methods typified by a spin coat method and an inkjet printing method.

When the first organic layer is formed by an application method, it is preferable to use an ink of the first organic layer described later. After formation of the first organic layer, materials contained in the composition can be crosslinked by heating or irradiation with light. When materials contained in the composition is crosslinked and contained in the first organic layer, the first organic layer is substantially insolubilized in a solvent. For this reason, the first organic layer can be suitably used for lamination of a light emitting device.

When the second organic layer is formed by an application method, it is preferable to use an ink of the second organic layer described later. After formation of the second organic layer, the polymer compound can be crosslinked by heating or irradiation with light. When the polymer compound is crosslinked and contained in the second organic layer, the second organic layer is substantially insolubilized in a solvent. For this reason, the second organic layer can be suitably used for lamination of light emitting device.

It is preferable for the light emitting device of the present invention that the polymer compound is crosslinked and contained in the second organic layer.

The temperature of heating for crosslinking is usually 25 to 300°C, preferably 50 to 250°C, more preferably 150 to 200°C.

The kind of light used for irradiation with light for crosslinking is, for example, ultraviolet light, near ultraviolet light and visible light.

### <First organic layer>

The first organic layer is a layer obtained by using a composition comprising a compound represented by the formula (H-A) and a metal complex represented by the formula (1) (hereinafter, referred to also as "composition of first organic layer".).

### [Compound represented by the formula (H-A)]

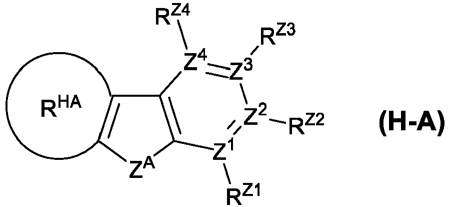

Z^{A} is preferably a group represented by -C(R^{ZA})₂-, a group represented by -N(R^{ZA})-, an oxygen atom or a sulfur atom, more preferably a group represented by -N(R^{ZA})-, an oxygen atom or a sulfur atom, further preferably a group represented by -N(R^{ZA})- or a sulfur atom, particularly preferably a sulfur atom, because the light emitting device of the present invention is more excellent in external quantum efficiency. That is, the compound represented by the formula (H-A) is preferably a compound represented by the formula (H-B).

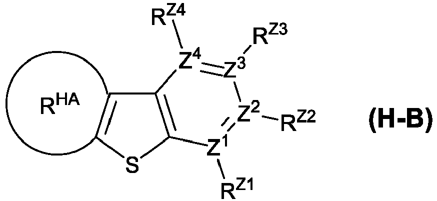

R^{ZA} is preferably an alkyl group, a cycloalkyl group, an aryl group or a monovalent heterocyclic group, more preferably an alkyl group, an aryl group or a monovalent heterocyclic group, further preferably an alkyl group or an aryl group, particularly preferably an alkyl group, and these groups each optionally have a substituent.

The aryl group represented by R^{ZA} is preferably a phenyl group, a fluorenyl group or a spirobifluorenyl group, more preferably a phenyl group, and these groups each optionally have a substituent.

The monovalent heterocyclic group represented by R^{ZA} is preferably a pyridyl group, a pyrimidinyl group, a triazinyl group, a dibenzothienyl group, a dibenzofuryl group, a carbazolyl group or an azacarbazolyl group, more preferably a pyridyl group, a dibenzothienyl group, a dibenzofuryl group or a carbazolyl group, and these groups each optionally have a substituent.

The substituent which R^{ZA} optionally has is preferably an alkyl group, a cycloalkyl group, an alkoxy group, a cycloalkoxy group, an aryl group, an aryloxy group or a monovalent heterocyclic group, more preferably an alkyl group, a cycloalkyl group, an aryl group or a monovalent heterocyclic group, further preferably an alkyl group, an aryl group or a monovalent heterocyclic group, and these groups each optionally further have a substituent.

It is preferable that at least three of Z¹, Z², Z³ and Z⁴ are a carbon atom, and it is more preferable that all of them are a carbon atom, because the light emitting device of the present invention is excellent in external quantum efficiency.

R^{Z1}, R^{Z2}, R^{Z3} and R^{Z4} are preferably a hydrogen atom, an alkyl group, a cycloalkyl group, an aryl group or a monovalent heterocyclic group, more preferably a hydrogen atom, an alkyl group, an aryl group or a monovalent heterocyclic group, further preferably a hydrogen atom, an aryl group or a monovalent heterocyclic group, particularly preferably a hydrogen atom or a monovalent heterocyclic group, because the light emitting device of the present invention is more excellent in external quantum efficiency, and these groups each optionally have a substituent. At least one of R^{Z1}, R^{Z2}, R^{Z3} and R^{Z4} is a monovalent heterocyclic group represented by the formula (H-1).

The examples and preferable range of the aryl group represented by R^{Z1}, R^{Z2}, R^{Z3} and R^{Z4} are the same as the examples and preferable range of the aryl group represented by R^{ZA}.

The examples and preferable range of the monovalent heterocyclic group represented by R^{Z1}, R^{Z2}, R^{Z3} and R^{Z4} are the same as the examples and preferable range of the monovalent heterocyclic group represented by R^{ZA}. At least one of R^{Z1}, R^{Z2}, R^{Z3} and R^{Z4} is a monovalent heterocyclic group represented by the formula (H-1).

It is preferable that R^{Z1} or R^{Z3} is a monovalent heterocyclic group represented by the formula (H-1), and it is more preferable that R^{Z3} is a monovalent heterocyclic group represented by the formula (H-1), because the light emitting device of the present invention is more excellent in external quantum efficiency.

The examples and preferable range of the substituent which R^{Z1}, R^{Z2}, R^{Z3} and R^{Z4} each optionally have are the same as the examples and preferable range of the substituent which R^{ZA} optionally has.

The ring R^{HA} is preferably a benzene ring, a fluorene ring, a pyridine ring, a diazabenzene ring or a carbazole ring, more preferably a benzene ring, a pyridine ring or a pyrimidine ring, further preferably a benzene ring or a pyridine ring, particularly preferably a benzene ring, because the light emitting device of the present invention is more excellent in external quantum efficiency, and these rings each optionally have a substituent.

The examples and preferable range of the substituent which the ring R^{HA} optionally has are the same as the examples and preferable range of the substituent which R^{ZA} optionally has.

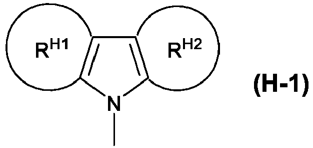

The examples and preferable range of the ring R^{H1} and the ring R^{H2} are the same as the examples and preferable range of the ring R^{HA}.

The monovalent heterocyclic group represented by the formula (H-1) is preferably a monovalent heterocyclic group represented by the formula (H-2), because the light emitting device of the present invention is more excellent in external quantum efficiency. 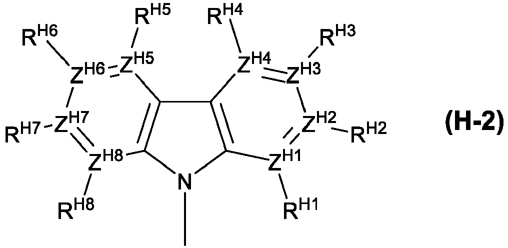 [wherein,
Z^{H1}, Z^{H2}, Z^{H3}, Z^{H4}, Z^{H5}, Z^{H6}, Z^{H7} and Z^{H8} each independently represent a carbon atom or a nitrogen atom.

R^{H1}, R^{H2}, R^{H3}, R^{H4}, R^{H5}, R^{H6}, R^{H7} and R^{H8} each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent.

R^{H1} is not present when Z^{H1} is a nitrogen atom. R^{H2} is not present when Z^{H2} is a nitrogen atom. R^{H3} is not present when Z^{H3} is a nitrogen atom. R^{H4} is not present when Z^{H4} is a nitrogen atom. R^{H5} is not present when Z^{H5} is a nitrogen atom. R^{H6} is not present when Z^{H6} is a nitrogen atom. R^{H7} is not present when Z^{H7} is a nitrogen atom. R^{H8} is not present when Z^{H8} is a nitrogen atom.

R^{H1} and R^{H2}, R^{H2} and R^{H3}, R^{H3} and R^{H4}, R^{H4} and R^{H5}, R^{H5} and R^{H6}, R^{H6} and R^{H7}, and R^{H7} and R^{H8} each may be combined together to form a ring together with the carbon atoms to which they are attached.]

It is preferable that at least six of Z^{H1}, Z^{H2}, Z^{H3}, Z^{H4}, Z^{H5}, Z^{H6}, Z^{H7} and Z^{H8} are a carbon atom, it is more preferable that at least seven of them are a carbon atom, it is further preferable that all of them are a carbon atom, because the light emitting device of the present invention is excellent in external quantum efficiency.

When two of Z^{H1}, Z^{H2}, Z^{H3}, Z^{H4}, Z^{H5}, Z^{H6}, Z^{H7} and Z^{H8} are a nitrogen atom, it is preferable that one of Z^{H1}, Z^{H2}, Z^{H3} and Z^{H4} is a nitrogen atom and one of Z^{H5}, Z^{H6}, Z^{H7} and Z^{H8} is a nitrogen atom.

When one of ZH¹, Z^{H2}, Z^{H3}, Z^{H4}, Z^{H5}, Z^{H6}, Z^{H7} and Z^{H8} is a nitrogen atom, it is preferable that Z^{H3} or Z^{H4} is a nitrogen atom.

R^{H1}, R^{H2}, R^{H3}, R^{H4}, R^{H5}, R^{H6}, R^{H7} and R^{H8} are preferably a hydrogen atom, an alkyl group, a cycloalkyl group, an aryl group or a monovalent heterocyclic group, more preferably a hydrogen atom, an alkyl group, an aryl group or a monovalent heterocyclic group, further preferably a hydrogen atom, an alkyl group or an aryl group, particularly preferably a hydrogen atom, because the light emitting device of the present invention is more excellent in external quantum efficiency, and these groups each optionally have a substituent.

The examples and preferable range of the substituent which R^{H1}, R^{H2}, R^{H3}, R^{H4}, R^{H5}, R^{H6}, R^{H7} and R^{H8} each optionally have are the same as the examples and preferable range of the substituent which R^{ZA} optionally has.

The monovalent heterocyclic group represented by the formula (H-2) is preferably a monovalent heterocyclic group represented by the formula (H-2-1) to the formula (H-2-6), more preferably a monovalent heterocyclic group represented by the formula (H-2-1) to the formula (H-2-3), further preferably a group represented by the formula (H-2-1). 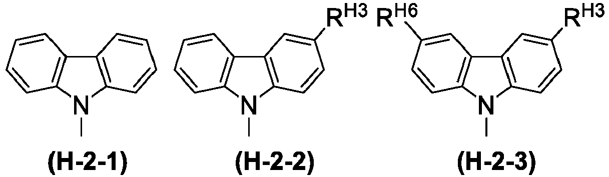 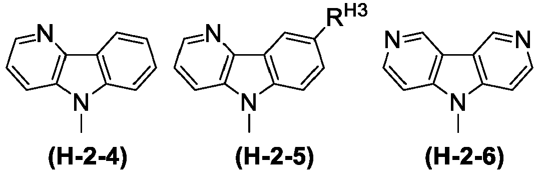 [wherein, R^{H3} and R^{H6} represent the same meaning as described above.]

Specific examples of the monovalent heterocyclic group represented by the formula (H-2) include monovalent heterocyclic groups represented by the formula (H-2-1') to the formula (H-2-11').

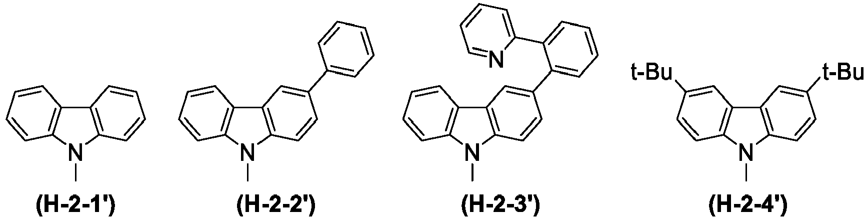

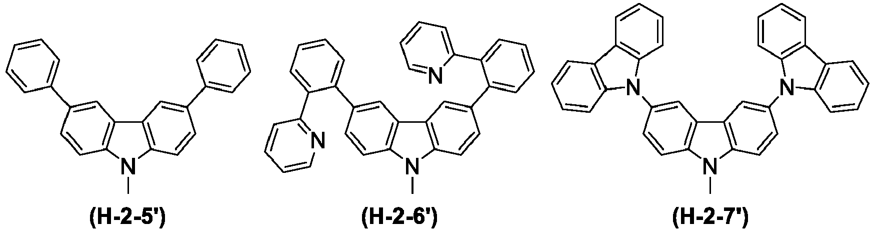

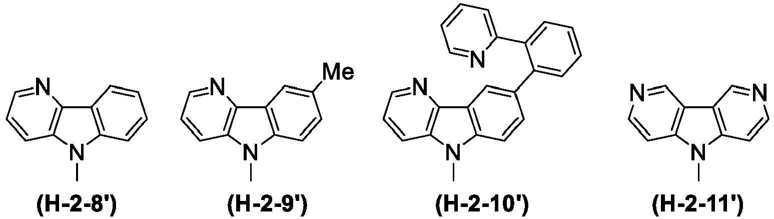

The compound represented by the formula (H-A) is preferably a compound represented by the formula (H-A1), because the light emitting device of the present invention is more excellent in external quantum efficiency. 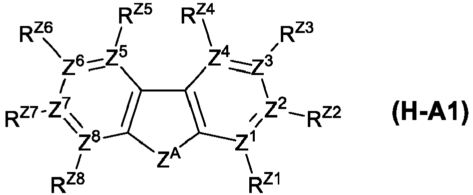 [wherein,
Z^{A}, Z¹, Z², Z³, Z⁴, R^{Z1}, R^{Z2}, R^{Z3} and R^{Z4} represent the same meaning as described above.

Z⁵, Z⁶, Z⁷ and Z⁸ each independently represent a carbon atom or a nitrogen atom.

R^{Z5}, R^{Z6}, R^{Z7} and R^{Z8} each independently represent a hydrogen atom, an alkyl group, a cycloalkyl group, an alkoxy group, a cycloalkoxy group, an aryl group, an aryloxy group, a monovalent heterocyclic group or a halogen atom, and these groups each optionally have a substituent. R^{Z5} is not present when Z⁵ is a nitrogen atom. R^{Z6} is not present when Z⁶ is a nitrogen atom. R^{Z7} is not present when Z⁷ is a nitrogen atom. R^{Z8} is not present when Z⁸ is a nitrogen atom.

R^{Z4} and R^{Z5}, R^{Z5} and R^{Z6}, R^{Z6} and R^{Z7}, R^{Z7} and R^{Z8}, and R^{Z8} and R^{ZA} each may be combined together to form a ring together with the atoms to which they are attached.]

The compound represented by the formula (H-A1) is preferably a compound represented by the formula (H-B1), because the light emitting device of the present invention is more excellent in external quantum efficiency. 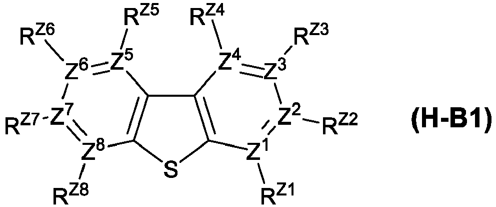 [wherein, Z¹, Z², Z³, Z⁴, Z⁵, Z⁶, Z⁷, Z⁸, R^{Z1}, R^{Z2}, R^{Z3}, R^{Z4}, R^{Z5}, R^{Z6}, R^{Z7} and R^{Z8} represent the same meaning as described above.]

It is preferable that at least three of Z⁵, Z⁶, Z⁷ and Z⁸ are a carbon atom, and it is more preferable that all of them are a carbon atom, because the light emitting device of the present invention is excellent in external quantum efficiency.

R^{Z5}, R^{Z6}, R^{Z7} and R^{Z8} represent preferably a hydrogen atom, an alkyl group, a cycloalkyl group, an aryl group or a monovalent heterocyclic group, more preferably a hydrogen atom, an alkyl group, an aryl group or a monovalent heterocyclic group, further preferably a hydrogen atom, an aryl group or a monovalent heterocyclic group, particularly preferably a hydrogen atom or a monovalent heterocyclic group, and these groups each optionally have a substituent.

The examples and preferable range of the aryl group represented by R^{Z5}, R^{Z6}, R^{Z7} and R^{Z8} are the same as the examples and preferable range of the aryl group represented by R^{ZA}.

The examples and preferable range of the monovalent heterocyclic group represented by R^{Z5}, R^{Z6}, R^{Z7} and R^{Z8} are the same as the examples and preferable range of the monovalent heterocyclic group represented by R^{ZA}.

It is preferable that at least one of R^{Z5}, R^{Z6}, R^{Z7} and R^{Z8} is a monovalent heterocyclic group represented by the formula (H-1), it is more preferable that R^{Z6} or R^{Z8} is a monovalent heterocyclic group represented by the formula (H-1), it is further preferable that R^{Z6} is a monovalent heterocyclic group represented by the formula (H-1), because the light emitting device of the present invention is more excellent in external quantum efficiency.

The examples and preferable range of the substituent which R^{Z5,} R^{Z6}, R^{Z7} and R^{Z8} each optionally have are the same as the examples and preferable range of the substituent which R^{ZA} optionally has.

The compound represented by the formula (H-A1) is preferably a compound represented by the formula (H-A2), because the light emitting device of the present invention is more excellent in external quantum efficiency. 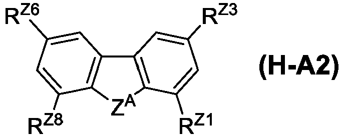 [wherein, Z^{A}, R^{Z1}, R^{Z3}, R^{Z6} and R^{Z8} represent the same meaning as described above. At least one of R^{Z1} and R^{Z3} is a monovalent heterocyclic group represented by the formula (H-1).]

The compound represented by the formula (H-A2) is preferably a compound represented by the formula (H-B2), because the light emitting device of the present invention is more excellent in external quantum efficiency. 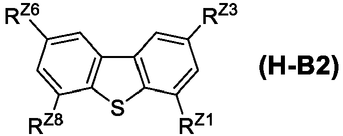 [wherein, R^{Z1}, R^{Z3}, R^{Z6} and R^{Z8} represent the same meaning as described above. At least one of R^{Z1} and R^{Z3} is a monovalent heterocyclic group represented by the formula (H-1).]

The compound represented by the formula (H-A) includes, for example, compounds represented by the formulae (H-A-1) to (H-A-5) and compounds represented by the formulae (H-A2-1) to (H-A2-25), preferably compounds represented by the formulae (H-A2-1) to (H-A2-15), more preferably compounds represented by the formulae (H-A2-1) to (H-A2-10). The compound represented by the formula (H-A2-1) to (H-A2-25) is a compound represented by the formula (H-A2). 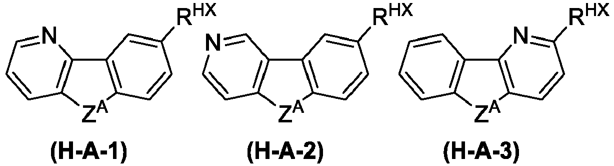 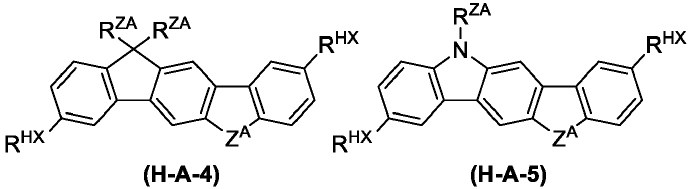 [wherein, Z^{A} and R^{ZA} represent the same meaning as described above. R^{HX} represents a group represented by the formula (H-1).]

The compound represented by the formula (H-A2) includes, for example, compounds represented by the formulae (H-A2-1) to (H-A2-25) .

**[Table 1]**

| formula | Z^{A} | R^{Z1} | R^{Z3} | R^{Z6} | R^{Z8} |
|---|---|---|---|---|---|
| (H-A2-1) | S | formula (H-1) | H | H | H |
| (H-A2-2) | S | H | formula (H-1) | H | H |
| (H-A2-3) | S | formula (H-1) | H | formula (H-1) | H |
| (H-A2-4) | S | H | formula (H-1) | formula (H-1) | H |
| (H-A2-5) | S | formula (H-1) | formula (H-1) | formula (H-1) | H |
| (H-A2-6) | S | formula (H-1) | formula (H-1) | formula (H-1) | formula (H-1) |
| (H-A2-7) | S | H | formula (H-1) | 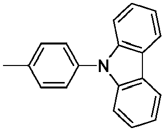 | H |
| (H-A2-8) | S | H | formula (H-1) | 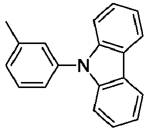 | H |
| (H-A2-9) | S | H | formula (H-1) | 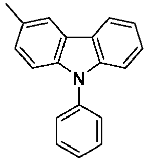 | H |
| (H-A2-10) | S | H | formula (H-1) | 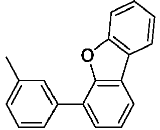 | H |

**[Table 2]**

| formula | Z^{A} | R^{Z1} | R^{Z3} | R^{Z6} | R^{Z8} |
|---|---|---|---|---|---|
| (H-A2-11) | 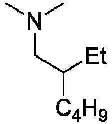 | H | formula (H-1) | H | H |
| (H-A2-12) | 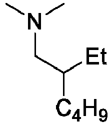 | H | formula (H-1) | formula (H-1) | H |
| (H-A2-13) | 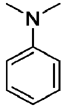 | H | formula (H-1) | formula (H-1) | H |
| (H-A2-14) | 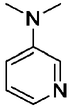 | H | formula (H-1) | 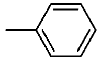 | H |
| (H-A2-15) | 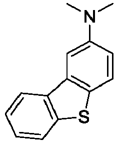 | H | formula (H-1) | H | H |
| (H-A2-16) | O | H | formula (H-1) | H | H |
| (H-A2-17) | O | H | formula (H-1) | formula (H-1) | H |
| (H-A2-18) | O | H | formula (H-1) | 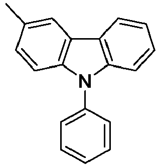 | H |
| (H-A2-19) | O | H | formula (H-1) | 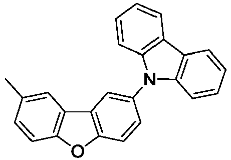 | H |

**[Table 3]**

| formula | Z^{A} | R^{Z1} | R^{Z3} | R^{Z6} | R^{Z8} |
|---|---|---|---|---|---|
| (H-A2-20) | 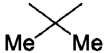 | H | formula (H-1) | H | H |
| (H-A2-21) | 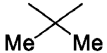 | H | formula (H-1) | formula (H-1) | H |
| (H-A2-22) | 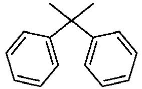 | H | formula (H-1) | H | H |
| (H-A2-23) | 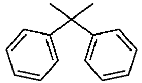 | H | formula (H-1) | formula (H-1) | H |
| (H-A2-24) | 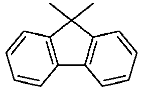 | H | formula (H-1) | H | H |
| (H-A2-25) | 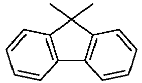 | H | formula (H-1) | formula (H-1) | H |

In Table 1 to Table 3, specific examples of the monovalent heterocyclic group represented by the formula (H-1) include monovalent heterocyclic groups represented by the formula (H-2-1') to the formula (H-2-11') described above.

The compound represented by the formula (H-A) can be synthesized, for example, according to methods described in International Publication WO2009/086028, International Publication WO2009/096202, JP-A No. 2009-46408 and JP-A No. 2009-267255.

Specifically, the compound represented by the formula (H-A) can be synthesized by subjecting a compound represented by the formula (H-A') and a compound represented by the formula (H-1') to a known coupling reaction such as the Buchwald-Hartwig reaction and the Ullmann reaction. In detail, a chlorine atom, a bromine atom, an iodine atom or, a carbon atom linking to a group represented by O-S(=O)₂R^{C1} in a compound represented by the formula (H-A'), and a nitrogen atom in a compound represented by the formula (H-1') are bound. 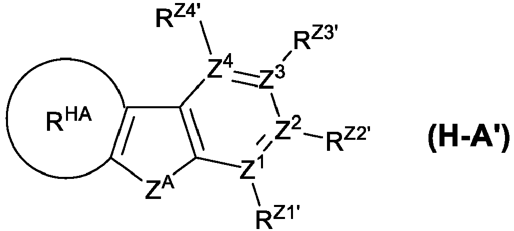 [wherein,
Z^{A}, Z¹, Z², Z³, Z⁴ and the ring R^{HA} represent the same meaning as described above.

R^{Z1'}, R^{Z2'}, R^{Z3'} and R^{Z4'} each independently represent a hydrogen atom, an alkyl group, a cycloalkyl group, an alkoxy group, a cycloalkoxy group, an aryl group, an aryloxy group, a monovalent heterocyclic group, a halogen atom or a group represented by O-S(=O)₂R^{C1} (wherein, R^{C1} represents an alkyl group, a cycloalkyl group or an aryl group, and these groups each optionally have a substituent.), and these groups each optionally have a substituent. R^{Z1'} is not present when Z¹ is a nitrogen atom. R^{Z2'} is not present when Z² is a nitrogen atom. R^{Z3'} is not present when Z³ is a nitrogen atom. R^{Z4}' is not present when Z⁴ is a nitrogen atom. At least one of R^{Z1'}, R^{Z2'}, R^{Z3'} and R^{Z4'} is a chlorine atom, a bromine atom, an iodine atom or a group represented by O-S(=O)₂R^{C1}.

R^{Z1'} and R^{Z2'}, R^{Z2'} and R^{Z3'}, R^{Z3'} and R^{Z4'}, R^{Z1'} and R^{ZA}, a substituent which the ring R^{HA} optionally has and R^{ZA'}, and a substituent which the ring R^{HA} optionally has and R^{Z4}' each may be combined together to form a ring together with the atoms to which they are attached.] 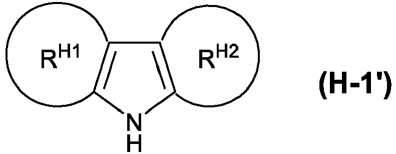 [wherein, the ring R^{H1} and the ring R^{H2} represent the same meaning as described above.]

The coupling reaction is conducted usually in the presence of a catalyst, a base and a reaction solvent. The catalyst, the base and the reaction solvent each may be used singly, or two or more of them may be used in combination.

The catalyst includes, for example, a palladium catalyst and a copper catalyst. The catalyst may be used in combination with an amine compound, a phosphorus compound and the like.

The base includes, for example, sodium carbonate, potassium carbonate, potassium tert-butoxide and sodium tert-butoxide.

The reaction solvent includes, for example, organic solvents such as tert-butanol, tetrahydrofuran, 1,4-dioxane, methylene chloride, chloroform, acetonitrile, toluene, xylene, tetrahydrofuran, 1,4-dioxane and N,N-dimethylformamide, and water.

The reaction temperature of the coupling reaction is usually -100 to 200°C. The reaction time of the coupling reaction is usually 30 minutes or more.

### [Metal complex represented by the formula (1)]

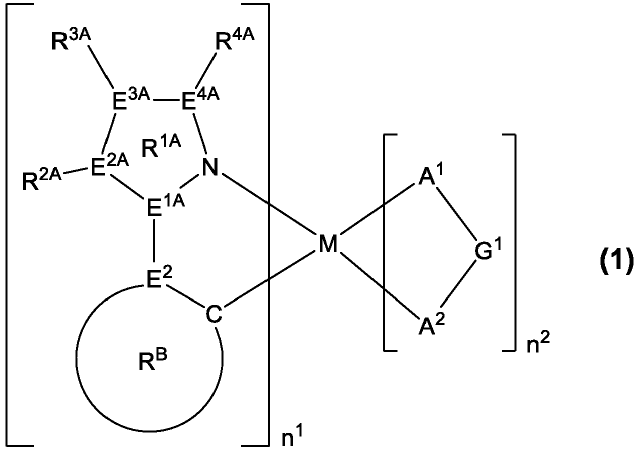

M is preferably an iridium atom or a platinum atom, more preferably an iridium atom, because the light emitting device of the present invention is excellent in luminance life.

When M is a ruthenium atom, a rhodium atom or an iridium atom, n¹ is preferably 2 or 3, more preferably 3.

When M is a palladium atom or a platinum atom, n¹ is preferably 2.

Two of E^{2A}, E^{3A} and E^{4A} are a nitrogen atom and the remaining one is a carbon atom. The ring R^{1A} is a triazole ring constituted of a nitrogen atom, E^{1A} (a carbon atom), E^{2A}, E^{3A} and E^{4A}. It is preferable that E^{2A} and E^{3A} are a nitrogen atom or E^{2A} and E^{4A} are a nitrogen atom, and it is more preferable that E^{2A} and E^{3A} are a nitrogen atom, because the light emitting device of the present invention is more excellent in external quantum efficiency.

When E^{2A} is a nitrogen atom and R^{2A} is present, R^{2A} is preferably an alkyl group, a cycloalkyl group, an aryl group, a monovalent heterocyclic group or a dendron, more preferably an alkyl group, an aryl group or a dendron, and these groups each optionally have a substituent.

When E^{2A} is a carbon atom, R^{2A} represents preferably a hydrogen atom, an alkyl group, a cycloalkyl group, an aryl group, a monovalent heterocyclic group or a dendron, more preferably a hydrogen atom, an alkyl group, an aryl group or a dendron, further preferably a hydrogen atom or an alkyl group, and these groups each optionally have a substituent.

When E^{3A} is a nitrogen atom and R^{3A} is present, R^{3A} is preferably an alkyl group, a cycloalkyl group, an aryl group, a monovalent heterocyclic group or a dendron, more preferably an alkyl group, an aryl group or a dendron, and these groups each optionally have a substituent.

When E^{3A} is a carbon atom, R^{3A} is preferably an alkyl group, a cycloalkyl group, an aryl group, a monovalent heterocyclic group or a dendron, more preferably an alkyl group, an aryl group or a dendron, further preferably an alkyl group, and these groups each optionally have a substituent.

When E^{4A} is a nitrogen atom and R^{4A} is present, R^{4A} is preferably an alkyl group, a cycloalkyl group, an aryl group, a monovalent heterocyclic group or a dendron, more preferably an alkyl group, an aryl group or a dendron, and these groups each optionally have a substituent.

When E^{4A} is a carbon atom, R^{4A} is preferably an alkyl group, a cycloalkyl group, an aryl group, a monovalent heterocyclic group or a dendron, more preferably an alkyl group, an aryl group or a dendron, further preferably an alkyl group, and these groups each optionally have a substituent.

The dendron represented by R^{2A}, R^{3A} and R^{4A} is preferably a group represented by the formula (D-A1) or (D-B1), more preferably a group represented by the formula (D-A1), because the light emitting device of the present invention is excellent in external quantum efficiency.

When E^{2A} is a nitrogen atom and R^{2A} is present, the dendron represented by R^{2A} is preferably a group represented by the formula (D-A1), (D-A4) or (D-B1), more preferably a group represented by the formula (D-A4), because the light emitting device of the present invention is excellent in external quantum efficiency.

When E^{3A} is a nitrogen atom and R^{3A} is present, the dendron represented by R^{3A} is preferably a group represented by the formula (D-A1), (D-A4) or (D-B1), more preferably a group represented by the formula (D-A4), because the light emitting device of the present invention is excellent in external quantum efficiency.

When E^{4A} is a nitrogen atom and R^{4A} is present, the dendron represented by R^{4A} is preferably a group represented by the formula (D-A1), (D-A4) or (D-B1), more preferably a group represented by the formula (D-A4), because the light emitting device of the present invention is excellent in external quantum efficiency.

E² is preferably a carbon atom, because synthesis of a metal complex represented by the formula (1) is easy.

The ring R^{B} is preferably a benzene ring, a naphthalene ring, a fluorene ring, a phenanthrene ring, a pyridine ring, a diazabenzene ring or a triazine ring, more preferably a benzene ring, a pyridine ring or a pyrimidine ring, further preferably a benzene ring, and these rings each optionally have a substituent.

The substituent which the ring R^{B} optionally has is preferably an alkyl group, a cycloalkyl group, an aryl group, a monovalent heterocyclic group, an alkoxy group, a cycloalkoxy group, an aryloxy group or a dendron, more preferably an alkyl group, a cycloalkyl group, an aryl group, a monovalent heterocyclic group or a dendron, further preferably an alkyl group, an aryl group or a dendron, particularly preferably an aryl group or a dendron, and these groups each optionally further have a substituent.

The examples and preferable range of the dendron as the substituent which the ring R^{B} optionally has are the same as the examples and preferable range of the dendron represented by R^{2A}, R^{3A} and R^{4A} .

The anionic bidentate ligand represented by A¹-G¹-A² includes, for example, ligands represented by the following formulae. 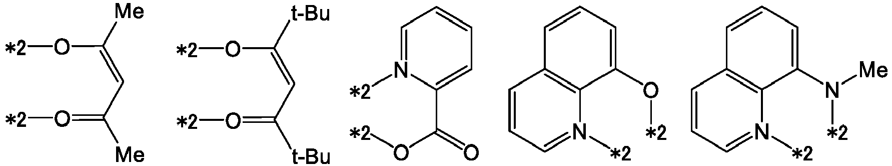 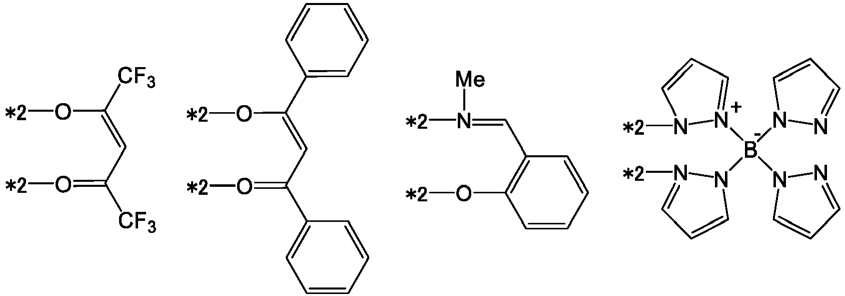 [wherein, *2 represents a site binding to M or M¹ described later.]

The anionic bidentate ligand represented by A¹-G¹-A² may be a ligand represented by the following formula. 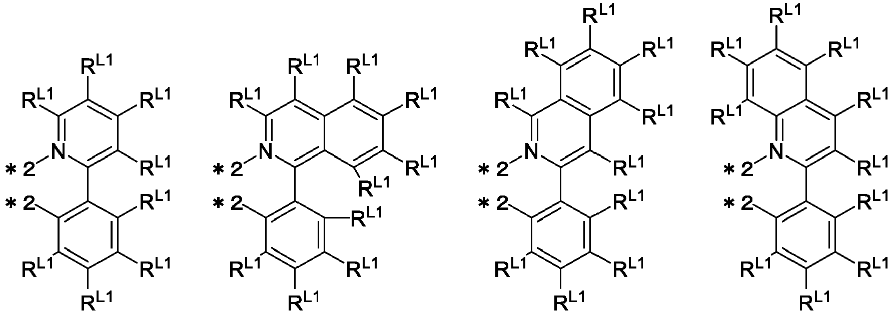 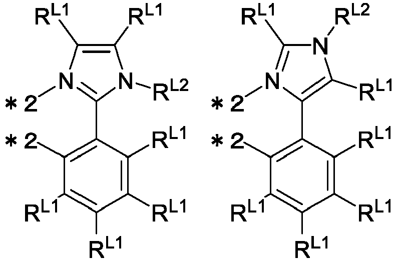 [wherein,
*2 represents the same meaning as described above.

R^{L1} represents a hydrogen atom, an alkyl group, a cycloalkyl group, an aryl group, a monovalent heterocyclic group, a halogen atom or a dendron, and these groups each optionally have a substituent. The plurality of R^{L1} may be the same or different.

R^{L2} represents an alkyl group, a cycloalkyl group, an aryl group, a monovalent heterocyclic group, a halogen atom or a dendron, and these groups each optionally have a substituent.]

R^{L1} represents preferably a hydrogen atom, an alkyl group, an aryl group, a fluorine atom or a dendron, and these groups each optionally have a substituent.

R^{L2} is preferably an alkyl group, an aryl group or a dendron, and these groups each optionally have a substituent.

The metal complex represented by the formula (1) is preferably a metal complex represented by the formula (1-A), because the light emitting device of the present invention is more excellent in external quantum efficiency. 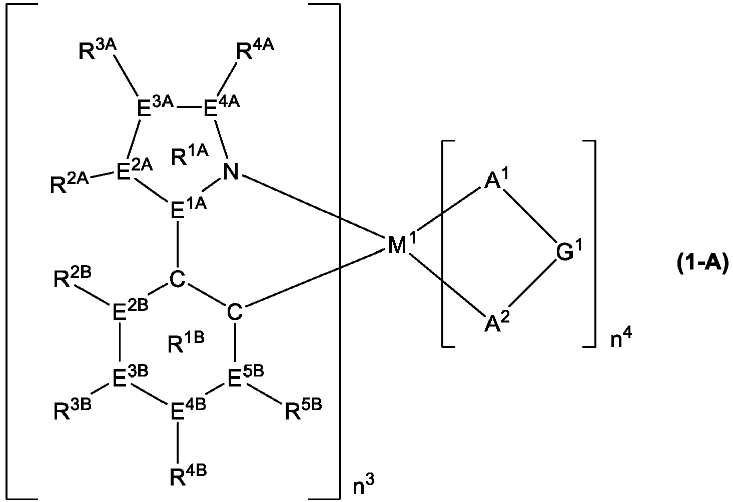 [wherein,

E^{1A}, E^{2A}, E^{3A}, E^{4A}, R^{2A}, R^{3A}, R^{4A}, the ring R^{1A} and A¹-G¹-A² represent the same meaning as described above.
M¹ represents an iridium atom or a platinum atom.

n³ represents an integer of 1 or more, n⁴ represents an integer of 0 or more, and n³+n⁴ is 2 or 3. n³+n⁴ is 3 when M¹ is an iridium atom, while n³+n⁴ is 2 when M¹ is a platinum atom.

E^{2B}, E^{3B}, E^{4B} and E^{5B} each independently represent a nitrogen atom or a carbon atom. When a plurality of E^{2B}, E^{3B}, E^{4B} and E^{5B} are present, they may be the same or different at each occurrence. R^{2B} is not present when E^{2B} is a nitrogen atom. R^{3B} is not present when E^{3B} is a nitrogen atom. R^{4B} is not present when E^{4B} is a nitrogen atom. R^{5B} is not present when E^{5B} is a nitrogen atom.

R^{2B}, R^{3B}, R^{4B} and R^{5B} each independently represent a hydrogen atom, an alkyl group, a cycloalkyl group, an alkoxy group, a cycloalkoxy group, an aryl group, an aryloxy group, a monovalent heterocyclic group, a halogen atom or a dendron, and these groups each optionally have a substituent. When a plurality of R^{2B}, R^{3B}, R^{4B} and R^{5B} are present, they may be the same or different at each occurrence. R^{2A} and R^{3A}, R^{3A} and R^{4A}, R^{2A} and R^{2B}, R^{2B} and R^{3B}, R^{3B} and R^{4B}, and R^{4B} and R^{5B} each may be combined together to form a ring together with the atoms to which they are attached.

The ring R^{1B} represents a benzene ring, a pyridine ring or a pyrimidine ring constituted of two carbon atoms, E^{2B}, E^{3B}, E^{4B} and E^{5B}.]

M¹ is preferably an iridium atom.

When M¹ is an iridium atom, n³ is preferably 2 or 3, more preferably 3.

When M¹ is a platinum atom, n³ is preferably 2.

When the ring R^{1B} is a pyridine ring, it is preferable that E^{3B}, E^{4B} or E^{5B} is a nitrogen atom, and it is more preferable that E^{3B} is a nitrogen atom.

When the ring R^{1B} is a pyrimidine ring, it is preferable that E^{2B} and E^{4B} or E^{3B} and E^{5B} are a nitrogen atom, and it is more preferable that E^{3B} and E^{5B} are a nitrogen atom.

The ring R^{1B} is preferably a benzene ring.

R^{2B} is preferably a hydrogen atom, an alkyl group, a cycloalkyl group, an alkoxy group, a cycloalkoxy group, an aryl group, a monovalent heterocyclic group, a fluorine atom or a dendron, more preferably a hydrogen atom, an alkyl group, an aryl group, a monovalent heterocyclic group or a fluorine atom, further preferably a hydrogen atom, an alkyl group or an aryl group, particularly preferably a hydrogen atom, and these groups each optionally have a substituent.

R^{3B} is preferably a hydrogen atom, an alkyl group, a cycloalkyl group, an alkoxy group, a cycloalkoxy group, an aryl group, a monovalent heterocyclic group or a dendron, more preferably a hydrogen atom, an alkyl group, an aryl group, a monovalent heterocyclic group or a dendron, further preferably a hydrogen atom, an alkyl group, an aryl group or a dendron, particularly preferably a hydrogen atom, an aryl group or a dendron, and these groups each optionally have a substituent.

R^{4B} is preferably a hydrogen atom, an alkyl group, a cycloalkyl group, an alkoxy group, a cycloalkoxy group, an aryl group, a monovalent heterocyclic group, a fluorine atom or a dendron, more preferably a hydrogen atom, an alkyl group, an aryl group, a monovalent heterocyclic group or a dendron, further preferably a hydrogen atom, an alkyl group, an aryl group or a dendron, particularly preferably a hydrogen atom, an aryl group or a dendron, and these groups each optionally have a substituent.

R^{5B} is preferably a hydrogen atom, an alkyl group, a cycloalkyl group, an alkoxy group, a cycloalkoxy group, an aryl group, a monovalent heterocyclic group, a fluorine atom or a dendron, more preferably a hydrogen atom, an alkyl group, an aryl group, a monovalent heterocyclic group or a dendron, further preferably a hydrogen atom or an alkyl group, particularly preferably a hydrogen atom, and these groups each optionally have a substituent.

The examples and preferable range of the dendron represented by R^{2B}, R^{3B}, R^{4B} and R^{5B} are the same as the examples and preferable range of the dendron represented by R^{2A}, R^{3A} and R^{4A}.

The metal complex represented by the formula (1-A) is preferably a metal complex represented by the formula (1-A1) or (1-A2), more preferably a metal complex represented by the formula (1-A1). 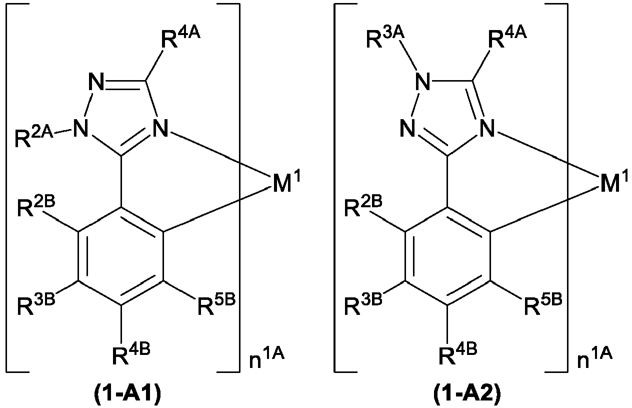 [wherein,
M¹, R^{2A}, R^{3A}, R^{4A}, R^{2B}, R^{3B}, R^{4B} and R^{5B} represent the same meaning as described above.

n^{1A} represents an integer of 2 or 3, and n^{1A} is 3 when M¹ is iridium, while n^{1A} is 2 when M¹ is platinum.]

The metal complex represented by the formula (1) includes, for example, metal complexes represented by the formulae (1-1) to (1-7), the formulae (1-A1-1) to (1-A1-18) and the formulae (1-A2-1) to (1-A2-12), preferably metal complexes represented by the formulae (1-A1-1) to (1-A1-18) or the formulae (1-A2-1) to (1-A2-12), more preferably metal complexes represented by the formulae (1-A1-1) to (1-A1-18). The metal complex represented by the formula (1-A1-1) to (1-A1-18) is a metal complex represented by the formula (1-A1) , and the metal complex represented by the formula (1-A2-1) to (1-A2-12) is a metal complex represented by the formula (1-A2).

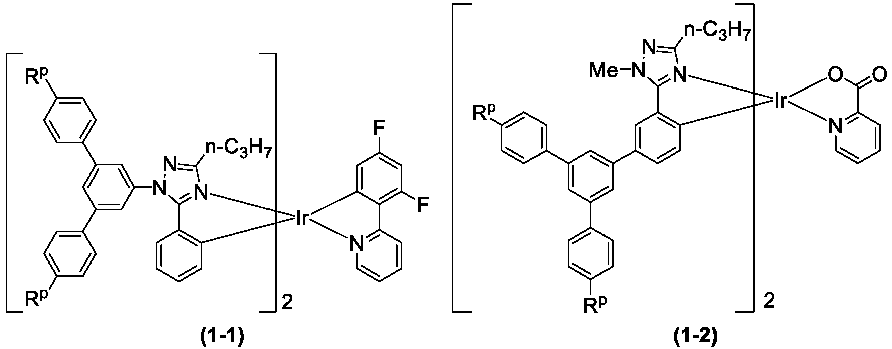

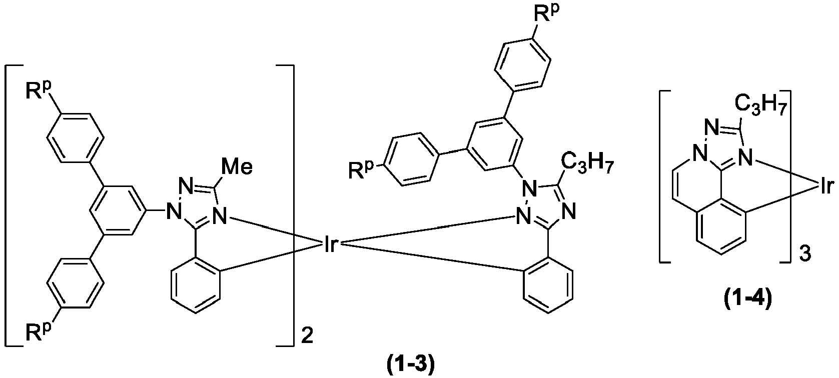

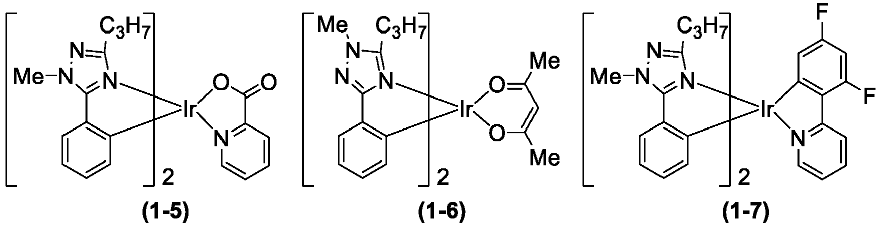

**[Table 4]**

| formula | M¹ | n^{1A} | R^{2A} | R^{4A} | R^{2B} | R^{3B} | R^{4B} | R^{5B} |
|---|---|---|---|---|---|---|---|---|
| (1-A1-1) | Ir | 3 | Me | C₃H₇ | H | H | H | H |
| (1-A1-2) | Ir | 3 | Me | C₃H₇ | F | H | F | H |
| (1-A1-3) | Ir | 3 | Me | C₃H₇ | H | H | CF₃ | H |
| (1-A1-4) | Ir | 3 | Me | C₃H₇ | H | 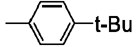 | H | H |
| (1-A1-5) | Ir | 3 | Me | C₃H₇ | H | formula (D-A-1) | H | H |
| (1-A1-6) | Ir | 3 | Me | C₃H₇ | H | formula (D-A-2) | H | H |
| (1-A1-7) | Ir | 3 | Me | C₃H₇ | H | formula (D-A-3) | H | H |
| (1-A1-8) | Ir | 3 | Me | C₃H₇ | H | formula (D-A-4) | H | H |
| (1-A1-9) | Ir | 3 | Me | C₃H₇ | H | H | formula (D-A-1) | H |

**[Table 5]**

| formula | M¹ | n^{1A} | R^{2A} | R^{4A} | R^{2B} | R^{3B} | R^{4B} | R^{5B} |
|---|---|---|---|---|---|---|---|---|
| (1-A1-10) | Ir | 3 | 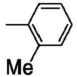 | C₃H₇ | H | H | H | H |
| (1-A1-11) | Ir | 3 | 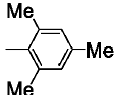 | C₃H₇ | H | formula (D-A-1) | H | H |
| (1-A1-12) | Ir | 3 | formula (D-A-1) | C₃H₇ | H | H | H | H |
| (1-A1-13) | Ir | 3 | formula (D-A-1) | C₃H₇ | H | H | F | H |
| (1-A1-14) | Ir | 3 | formula (D-A-1) | C₃H₇ | H | formula (D-A-1) | H | H |
| (1-A1-15) | Ir | 3 | Me | formula (D-A-1) | H | H | H | H |
| (1-A1-16) | Pt | 2 | Me | C₃H₇ | H | H | H | H |
| (1-A1-17) | Pt | 2 | Me | C₃H₇ | H | formula (D-A-1) | H | H |
| (1-A1-18) | Pt | 2 | formula (D-A-1) | C₃H₇ | H | H | H | H |

**[Table 6]**

| formula | M¹ | n^{1A} | R^{3A} | R^{4A} | R^{2B} | R^{3B} | R^{4B} | R^{5B} |
|---|---|---|---|---|---|---|---|---|
| (1-A2-1) | Ir | 3 | Me | C₃H₇ | H | H | H | H |
| (1-A2-2) | Ir | 3 | Me | C₃H₇ | F | H | F | H |
| (1-A2-3) | Ir | 3 | Me | C₃H₇ | H | 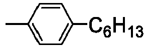 | H | H |
| (1-A2-4) | Ir | 3 | Me | C₃H₇ | H | formula (D-A-1) | H | H |
| (1-A2-5) | Ir | 3 | Me | C₃H₇ | H | formula (D-A-3) | H | H |
| (1-A2-6) | Ir | 3 | Me | C₃H₇ | H | formula (D-A-4) | H | H |
| (1-A2-7) | Ir | 3 | Me | C₃H₇ | H | H | formula (D-A-1) | H |
| (1-A2-8) | Ir | 3 | 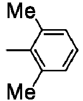 | C₃H₇ | H | H | H | H |
| (1-A2-9) | Ir | 3 | formula (D-A-2 ) | C₃H₇ | H | H | H | H |
| (1-A2-10) | Ir | 3 | formula (D-A-1) | C₃H₇ | H | formula (D-A-1) | H | H |
| (1-A2-11) | Pt | 2 | Me | C₃H₇ | H | H | H | H |
| (1-A2-12) | Pt | 2 | Me | C₃H₇ | H | formula (D-A-1) | H | H |

In Tables 4 to 6, the groups represented by the formulae (D-A-1) to (D-A-4) are as described below. 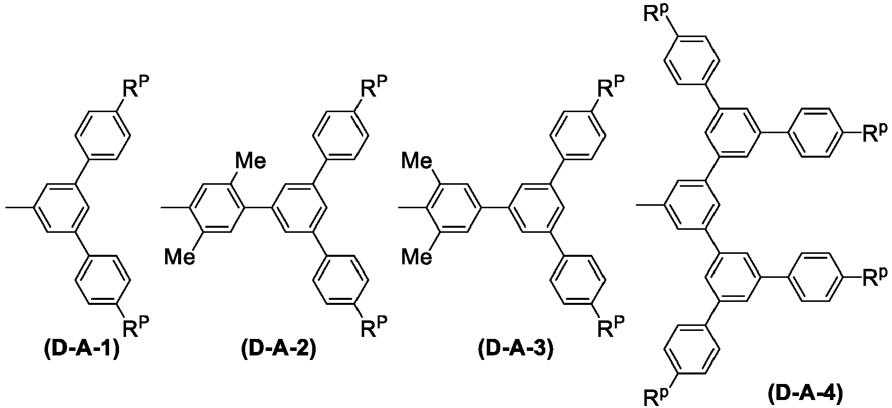 [wherein, R^{P} represents a hydrogen atom, an alkyl group, a cycloalkyl group, an alkoxy group or a cycloalkoxy group, and these groups each optionally have a substituent. The plurality of R^{P} may be the same or different.]

R^{P} is preferably a hydrogen atom or an alkyl group, more preferably an alkyl group, further preferably a methyl group, a tert-butyl group, a hexyl group, a 2-ethylhexyl group or a group represented by the formula (Rp-1), particularly preferably a tert-butyl group or a group represented by the formula (Rp-1).

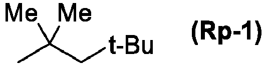

The metal complex represented by the formula (1) can be produced, for example, by methods described in "Journal of the American Chemical Society, Vol. 107, 1431-1432 (1985)", "Journal of the American Chemical Society, Vol. 106, 6647-6653 (1984)", International Publication WO2004/101707, JP-A No. 2013-147449, JP-A No. 2013-147450 and JP-A No. 2013-147451.

### [Composition of first organic layer]

The composition of the first organic layer comprises a compound represented by the formula (H-A) and a metal complex represented by the formula (1).

In the composition of the first organic layer, the compound represented by the formula (H-A) may be contained singly, or two or more of the compounds represented by the formula (H-A) may be contained. In the composition of the first organic layer, the metal complex represented by the formula (1) may be contained singly, or two or more of the metal complexes represented by the formula (1) may be contained.

In the composition of the first organic layer, the content of the metal complex represented by the formula (1) is usually 0.01 to 90 parts by weight when the sum of the compound represented by the formula (H-A) and the compound represented by the formula (1) is 100 parts by weight, and preferably 1 to 60 parts by weight, more preferably 10 to 40 parts by weight, further preferably 20 to 30 parts by weight, because the light emitting device of the present invention is more excellent in external quantum efficiency.

Claim 14 of the present invention claims a composition comprising a compound represented by the formula (H-B) and a metal complex represented by the formula (1-A1). When this composition is used in the first organic layer of a light emitting device, than the light emitting device is more excellent in external quantum efficiency.

In the composition of the first organic layer, at least one material selected from the group consisting of a hole transporting material, a hole injection material, an electron transporting material, an electron injection material, a light emitting material (different from the metal complex represented by the formula (1)), an antioxidant and a solvent may be further contained.

### [Hole transporting material]

The hole transporting material is classified into low molecular weight compounds and polymer compounds, and polymer compounds are preferable, and polymer compounds having a crosslinkable group are more preferable.

The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene and trinitrofluorenone, preferably fullerene.

In the composition of the first organic layer, the compounding amount of the hole transporting material is usually 1 to 400 parts by weight, preferably 5 to 150 parts by weight when the sum of the compound represented by the formula (H-A) and the metal complex represented by the formula (1) is 100 parts by weight.

The hole transporting material may be used singly, or two or more hole transporting materials may be used in combination.

### [Electron transporting material]

The electron transporting material is classified into low molecular weight compounds and polymer compounds. The electron transporting material optionally has a crosslinkable group.

The low molecular weight compound includes, for example, a metal complexe having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.

The polymer compound includes, for example, polyphenylene, polyfluorene and derivatives thereof. These polymer compounds may be doped with a metal.

In the composition of the first organic layer, the compounding amount of the electron transporting material is usually 1 to 400 parts by weight, preferably 5 to 150 parts by weight when the sum of the compound represented by the formula (H-A) and the metal complex represented by the formula (1) is 100 parts by weight.

The electron transporting material may be used singly, or two or more electron transporting materials may be used in combination.

### [Hole injection material and electron injection material]

The hole injection material and the electron injection material are each classified into low molecular weight compounds and polymer compounds. The hole injection material and the electron injection material each optionally have a crosslinkable group.

The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising an aromatic amine structure in the main chain or side chain.

In the composition of the first organic layer, the compounding amounts of the hole injection material and the electron injection material are each usually 1 to 400 parts by weight, preferably 5 to 150 parts by weight when the sum of the compound represented by the formula (H-A) and the metal complex represented by the formula (1) is 100 parts by weight.

The hole injection material and the electron injection material may each be used singly, or two or more of them may be used in combination.

### [Ion dope]

When the hole injection material or the electron injection material comprises an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with a suitable amount of ions.

The kind of the ion to be doped is an anion for a hole injection material and a cation for an electron injection material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ion to be doped may be used singly, or two or more ions to be doped may be used.

### [Light emitting material]

The light emitting material (different from a metal complex represented by the formula (1)) is classified into low molecular weight compounds and polymer compounds. The light emitting material optionally has a crosslinkable group.

The low molecular weight compound includes, for example, naphthalene and derivatives thereof, anthracene and derivatives thereof, perylene and derivatives thereof, and, triplet light emitting complexes having iridium, platinum or europium as the central metal.

The polymer compound includes, for example, polymer compounds comprising a phenylene group, a naphthalenediyl group, an anthracenediyl group, a fluorenediyl group, a phenanthrenediyl group, dihydrophenanthrenediyl group, a group represented by the formula (X), a carbazolediyl group, a phenoxazinediyl group, a phenothiazinediyl group, a pyrenediyl group and the like.

The light emitting material preferably comprises a triplet light emitting complex and a polymer compound.

The triplet light emitting complex includes, for example, metal complexes listed below.

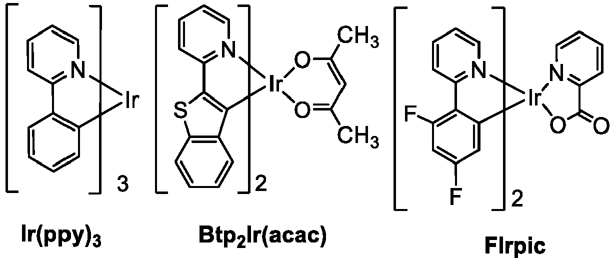

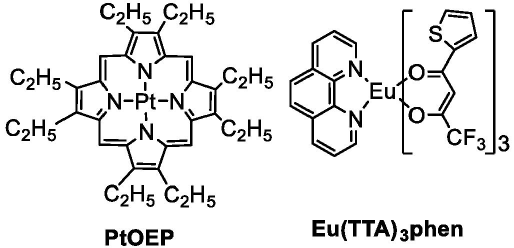

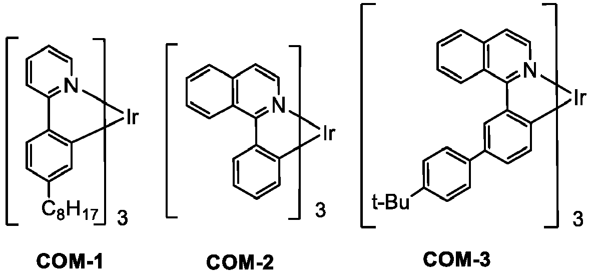

In the composition of the first organic layer, the compounding amount of the light emitting material is usually 0.1 to 400 parts by weight, preferably 5 to 150 parts by weight when the sum of the compound represented by the formula (H-A) and the metal complex represented by the formula (1) is 100 parts by weight.

The light emitting material may be used singly, or two or more light emitting materials may be used in combination.

### [Antioxidant]

The antioxidant may advantageously be one which is soluble in the same solvent as for a compound represented by the formula (H-A) and a metal complex represented by the formula (1) and does not disturb light emission and charge transportation, and the examples thereof include phenol-based antioxidants and phosphorus-based antioxidants.

In the composition of the first organic layer, the compounding amount of the antioxidant is usually 0.001 to 10 parts by weight when the sum of the compound represented by the formula (H-A) and the metal complex represented by the formula (1) is 100 parts by weight.

The antioxidant may be used singly, or two or more antioxidants may be used in combination.

### [Ink of first organic layer]

The composition of the first organic layer comprising a solvent (hereinafter, referred to also as "ink of first organic layer".) can be suitably used in application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method and a nozzle coat method.

The viscosity of the ink of the first organic layer may be adjusted depending on the kind of the application method, and when a solution goes through a discharge apparatus such as in an inkjet printing method, the viscosity is preferably in the range of 1 to 20 mPa·s at 25°C because curved aviation and clogging in discharging are unlikely.

As the solvent contained in the ink of the first organic layer, those capable of dissolving or uniformly dispersing solid components in the ink are preferable. The solvent includes, for example, chlorine-based solvents such as 1,2-dichloroethane, 1,1,2-trichloroethane, chlorobenzene and o-dichlorobenzene; ether solvents such as THF, dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-dodecane and bicyclohexyl; ketone solvents such as acetone, methylethylketone, cyclohexanone and acetophenone; ester solvents such as ethyl acetate, butyl acetate, ethylcellosolve acetate, methyl benzoate and phenyl acetate; poly-hydric alcohol solvents such as ethylene glycol, glycerin and 1,2-hexanediol and derivatives thereof; alcohol solvents such as isopropanol and cyclohexanol; sulfoxide solvents such as dimethyl sulfoxide; and amide solvents such as N-methyl-2-pyrrolidone and N,N-dimethylformamide. These solvents may be used singly, or two or more of them may be used in combination.

In the ink of the first organic layer, the compounding amount of the solvent is usually 1000 to 100000 parts by weight, preferably 2000 to 20000 parts by weight when the sum of the compound represented by the formula (H-A) and the metal complex represented by the formula (1) is 100 parts by weight.

### <Second organic layer>

The second organic layer is a layer obtained by using a polymer compound comprising a constitutional unit having a crosslinkable group (hereinafter, referred to also as "polymer compound of second organic layer".).

The second organic layer may also be a layer obtained by using a composition comprising the polymer compound of the second organic layer and the metal complex represented by the formula (1). In the composition comprising the polymer compound of the second organic layer and the metal complex represented by the formula (1), the content of the metal complex represented by the formula (1) is usually 0.1 to 50 parts by weight, preferably 0.5 to 40 parts by weight, more preferably 1 to 30 parts by weight when the sum of the metal complex represented by the formula (1) and the polymer compound of the second organic layer is 100 parts by weight.

### [Polymer compound of second organic layer]

The crosslinkable group which the constitutional unit contained in the polymer compound of the second organic layer has is preferably a crosslinkable group selected from Group A of crosslinkable group, more preferably a crosslinkable group represented by the formula (XL-1), (XL-3), (XL-5), (XL-7), (XL-9), (XL-10), (XL-16) or (XL-17), further preferably a crosslinkable group represented by the formula (XL-1), (XL-3), (XL-7), (XL-9), (XL-10), (XL-16) or (XL-17), particularly preferably a crosslinkable group represented by the formula (XL-1) or the formula (XL-17), especially preferably a crosslinkable group represented by the formula (XL-17), because the polymer compound of the second organic layer is excellent in crosslinkability.

The crosslinkable group which the constitutional unit contained in the polymer compound of the second organic layer has may be present singly, or two or more of the crosslinkable groups may be present.

The constitutional unit having a crosslinkable group contained in the polymer compound of the second organic layer is preferably a constitutional unit represented by the formula (2) or a constitutional unit represented by the formula (2') described later, and may also be a constitutional unit represented by the following formula.

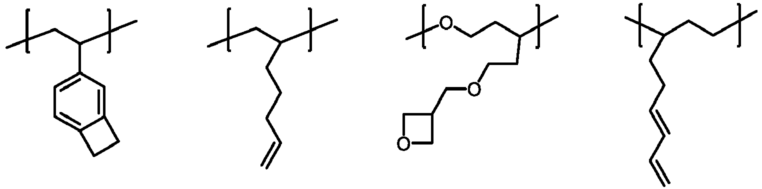

The constitutional unit having a crosslinkable group contained in the polymer compound of the second organic layer is preferably a constitutional unit represented by the formula (2) or a constitutional unit represented by the formula (2').

### [Constitutional unit represented by the formula (2)]

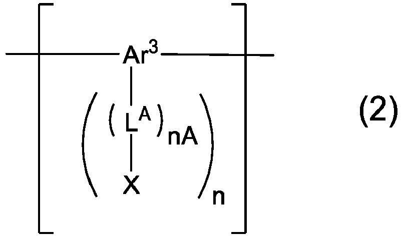

[wherein,
nA represents an integer of 0 to 5, and n represents, 1 or 2.

Ar³ represents an aromatic hydrocarbon group or a heterocyclic group, and these groups each optionally have a substituent.

L^{A} represents an alkylene group, a cycloalkylene group, an arylene group, a divalent heterocyclic group, a group represented by -NR' -, an oxygen atom or a sulfur atom, and these groups each optionally have a substituent. R' represents a hydrogen atom, an alkyl group, a cycloalkyl group, an aryl group or a monovalent heterocyclic group, and these groups each optionally have a substituent. When a plurality of L^{A} are present, they may be the same or different.

X represents a crosslinkable group selected from Group A of crosslinkable group. When a plurality of X are present, they may be the same or different.]

nA is preferably 0 to 2, more preferably 0 or 1, further preferably 0, because the light emitting device of the present invention is more excellent in external quantum efficiency.

n is preferably 2, because the light emitting device of the present invention is more excellent in external quantum efficiency.

Ar³ is preferably an aromatic hydrocarbon group which optionally has a substituent, because the light emitting device of the present invention is more excellent in external quantum efficiency.

The number of carbon atoms of the aromatic hydrocarbon group represented by Ar³, not including the number of carbon atoms of a substituent, is usually 6 to 60, preferably 6 to 30, more preferably 6 to 18.

The arylene group portion obtained by removing n substituents of the aromatic hydrocarbon group represented by Ar³ is preferably a group represented by the formula (A-1) to the formula (A-20), more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19), and these groups each optionally have a substituent.

The number of carbon atoms of the heterocyclic group represented by Ar³, not including the number of carbon atoms of a substituent, is usually 6 to 60, preferably 6 to 30, more preferably 6 to 18.

The divalent heterocyclic group portion obtained by removing n substituents of the heterocyclic group represented by Ar³ is preferably a group represented by the formula (AA-1) to the formula (AA-34).

The aromatic hydrocarbon group and the heterocyclic group represented by Ar³ each optionally have a substituent, and the substituent includes an alkyl group, a cycloalkyl group, an alkoxy group, a cycloalkoxy group, an aryl group, an aryloxy group, a halogen atom, a monovalent heterocyclic group and a cyano group.

The number of carbon atoms of the alkylene group represented by L^{A}, not including the number of carbon atoms of a substituent, is usually 1 to 10, preferably 1 to 5, more preferably 1 to 3. The number of carbon atoms of the cycloalkylene group represented by L^{A}, not including the number of carbon atoms of a substituent, is usually 3 to 10.

The alkylene group and the cycloalkylene group each optionally have a substituent, and the substituent includes, for example, a methylene group, an ethylene group, a propylene group, a butylene group, a hexylene group, a cyclohexylene group and an octylene group.

The substituent which the alkylene group and the cycloalkylene group represented by L^{A} each optionally have includes, for example, an alkyl group, a cycloalkyl group, an alkoxy group, a cycloalkoxy group, a halogen atom and a cyano group.

The arylene group represented by L^{A} optionally has a substituent. The arylene group includes, for example, an o-phenylene group, a m-phenylene group and a p-phenylene group. The arylene group is preferably a phenylene group or a fluorenediyl group, more preferably a m-phenylene group, a p-phenylene group, a fluorene-2,7-diyl group or a fluorene-9,9-diyl group. The substituent which the arylene group optionally has includes, for example, an alkyl group, a cycloalkyl group, an alkoxy group, a cycloalkoxy group, an aryl group, an aryloxy group, a monovalent heterocyclic group, a halogen atom, a cyano group and a crosslinkable group selected from Group A of crosslinkable group.

L^{A} is preferably an arylene group or an alkylene group, more preferably a phenylene group, a fluorenediyl group or an alkylene group, further preferably a phenylene group or an alkylene group, because production of the polymer compound of the second organic layer is easy, and these groups each optionally have a substituent.

The crosslinkable group represented by X is preferably a crosslinkable group represented by the formula (XL-1), (XL-3), (XL-7), (XL-9), (XL-10), (XL-16) or (XL-17), more preferably a crosslinkable group represented by the formula (XL-1) or the formula (XL-17), further preferably a crosslinkable group represented by the formula (XL-17), because the polymer compound of the second organic layer is excellent in crosslinkability.

The amount of the constitutional unit represented by the formula (2) is preferably 0.5 to 50 mol%, more preferably 3 to 30 mol%, further preferably 3 to 20 mol%, with respect to the total amount of constitutional units contained in the polymer compound of the second organic layer, because the polymer compound of the second organic layer is excellent in stability and crosslinkability.

The constitutional unit represented by the formula (2) may be contained singly or two or more of the constitutional units may be contained in the polymer compound of the second organic layer.

### [Constitutional unit represented by the formula (2')]

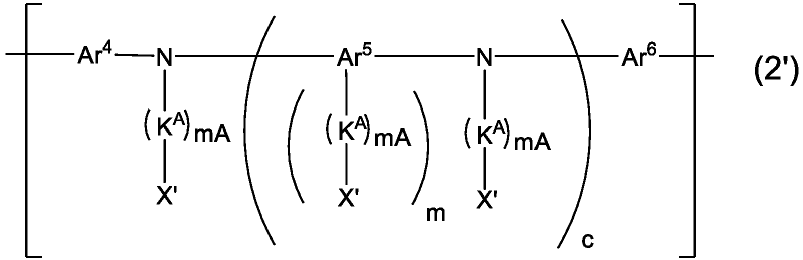

[wherein,
mA represents an integer of 0 to 5, m represents an integer of 1 to 4, and c represents an integer of 0 or 1. When a plurality of mA are present, they may be the same or different.

Ar⁵ represents an aromatic hydrocarbon group, a heterocyclic group or a group in which at least one aromatic hydrocarbon ring and at least one heterocyclic ring are bonded directly to each other, and these groups each optionally have a substituent.

Ar⁴ and Ar⁶ each independently represent an arylene group or a divalent heterocyclic group, and these groups each optionally have a substituent.

Each of Ar⁴ , Ar⁵ and Ar⁶ may be bonded directly or via an oxygen atom or a sulfur atom to a group that is different from that group and that is attached to the nitrogen atom to which that group is attached, thereby forming a ring.

K^{A} represents an alkylene group, a cycloalkylene group, an arylene group, a divalent heterocyclic group, a group represented by -NR' -, an oxygen atom or a sulfur atom, and these groups each optionally have a substituent. R' represents a hydrogen atom, an alkyl group, a cycloalkyl group, an aryl group or a monovalent heterocyclic group, and these groups each optionally have a substituent. When a plurality of K^{A} are present, they may be the same or different.

X' represents a crosslinkable group selected from Group A of crosslinkable group, a hydrogen atom, an alkyl group, a cycloalkyl group, an aryl group or a monovalent heterocyclic group, and these groups each optionally have a substituent. At least one X' is a crosslinkable group selected from Group A of crosslinkable group.]

mA is preferably 0 or 1, more preferably 0, because the light emitting device of the present invention is more excellent in external quantum efficiency.

m is preferably 2, because the light emitting device of the present invention is more excellent in external quantum efficiency.

c is preferably 0, because production of the polymer compound of the second organic layer is easy and because the light emitting device of the present invention is more excellent in external quantum efficiency.

Ar⁵ is preferably an aromatic hydrocarbon group which optionally has a substituent, because the light emitting device of the present invention is more excellent in external quantum efficiency.

The examples and preferable range of the arylene group portion obtained by removing m substituents of the aromatic hydrocarbon group represented by Ar⁵ are the same as the examples and preferable range of the arylene group represented by Ar^{X2} in the formula (X).

The examples and preferable range of the divalent heterocyclic group portion obtained by removing m substituents of the heterocyclic group represented by Ar⁵ are the same as the examples and preferable range of the divalent heterocyclic group portion represented by Ar^{X2} in the formula (X) described later.

The definition and examples of the divalent group obtained by removing m substituents of the group in which at least one aromatic hydrocarbon ring and at least one heterocyclic ring are bonded directly to each other represented by Ar⁵ are the same as the examples and preferable range of the divalent group in which at least one arylene group and at least one divalent heterocyclic group are bonded directly to each other represented by Ar^{X2} in the formula (X) described later.

Ar⁴ and Ar⁶ are preferably an arylene group optionally having a substituent, because the light emitting device of the present invention is more excellent in external quantum efficiency.

The examples and preferable range of the arylene group represented by Ar⁴ and Ar⁶ are the same as the examples and preferable range of the arylene group represented by Ar^{X1} and Ar^{X3} in the formula (X) descirbed later.

The examples and preferable range of the divalent heterocyclic group represented by Ar⁴ and Ar⁶ are the same as the examples and preferable range of the divalent heterocyclic group represented by Ar^{X1} and Ar^{X3} in the formula (X) described later.

The group represented by Ar⁴, Ar⁵ and Ar⁶ optionally has a substituent, and the substituent includes an alkyl group, a cycloalkyl group, an alkoxy group, a cycloalkoxy group, an aryl group, an aryloxy group, a halogen atom, a monovalent heterocyclic group and a cyano group.

The examples and preferable range of the alkylene group, the cycloalkylene group, the arylene group and the divalent heterocyclic group represented by K^{A} are the same as the examples and preferable range of the alkylene group, the cycloalkylene group, the arylene group and the divalent heterocyclic group represented by L^{A}, respectively.

K^{A} is preferably a phenylene group or a methylene group, because production of the polymer compound of the second organic layer is easy.

The crosslinkable group represented by X' is preferably a crosslinkable group represented by the formula (XL-1), (XL-3), (XL-7), (XL-9), (XL-10), (XL-16) or (XL-17), more preferably a crosslinkable group represented by the formula (XL-1) or the formula (XL-17), further preferably a crosslinkable group represented by the formula (XL-17), because the polymer compound of the second organic layer is excellent in crosslinkability.

The amount of the constitutional unit represented by the formula (2') is preferably 0.5 to 50 mol%, more preferably 3 to 30 mol%, further preferably 3 to 20 mol%, with respect to the total amount of constitutional units contained in the polymer compound of the second organic layer, because the polymer compound of the second organic layer is excellent in stability and because the polymer compound of the second organic layer is excellent in crosslinkability.

The constitutional unit represented by the formula (2') may be contained singly or two or more of the constitutional units may be contained in the polymer compound of the second organic layer.

### [Preferable embodiment of constitutional unit represented by the formula (2) or (2')]

The constitutional unit represented by the formula (2) includes, for example, constitutional units represented by the formula (2-1) to the formula (2-30), and the constitutional unit represented by the formula (2') includes, for example, constitutional units represented by the formula (2'-1) to the formula (2'-13) . Of them, preferable are constitutional units represented by the formula (2-1) to the formula (2-30), more preferable are constitutional units represented by the formula (2-1) to the formula (2-15), the formula (2-19), the formula (2-20), the formula (2-23), the formula (2-25) or the formula (2-30), further preferable are constitutional units represented by the formula (2-1) to the formula (2-9) or the formula (2-30), because the polymer compound of the second organic layer is excellent in crosslinkability.

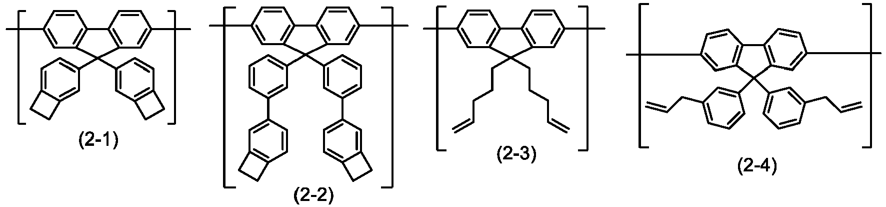

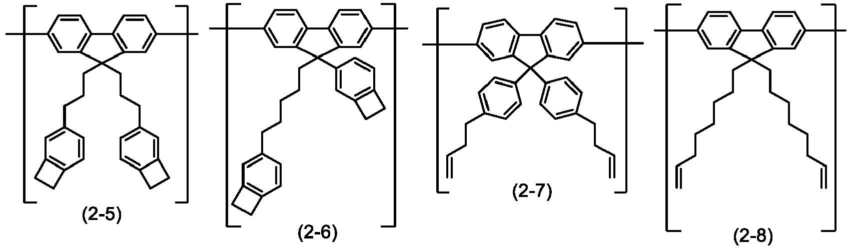

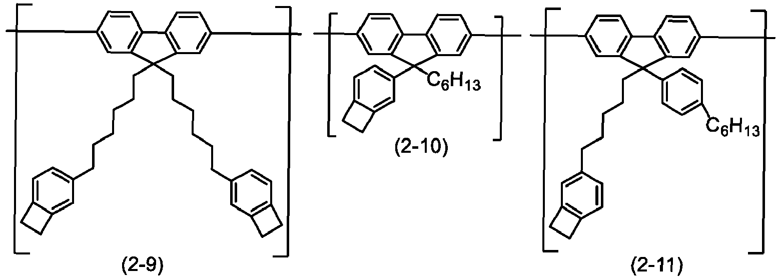

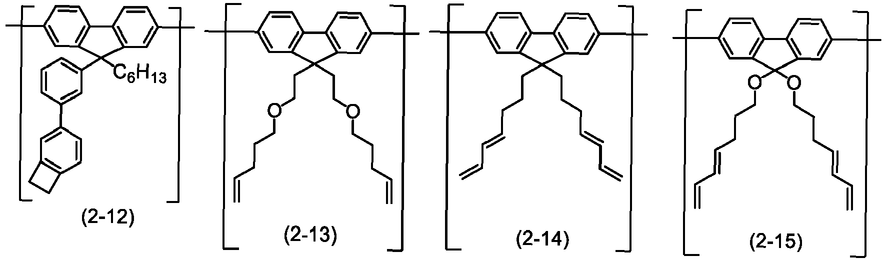

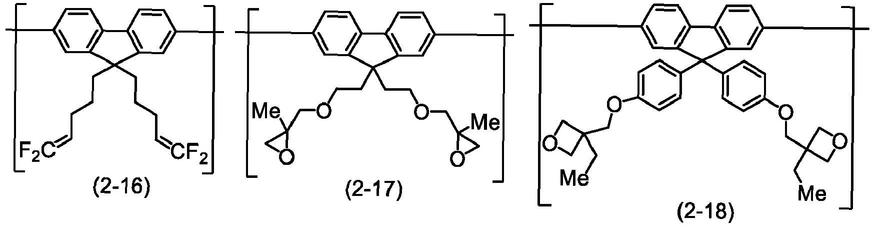

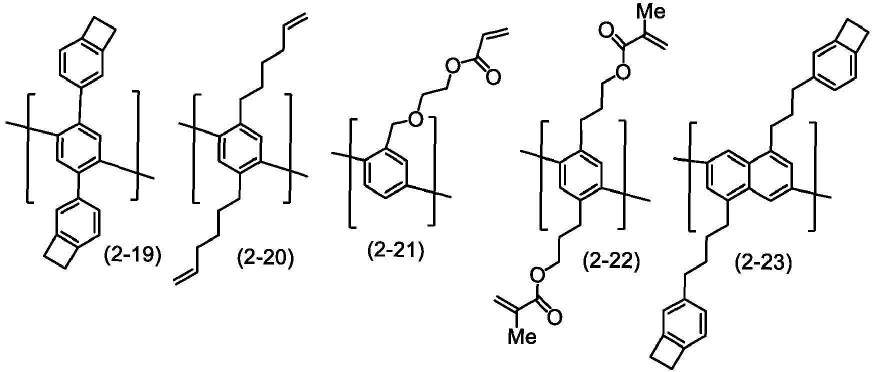

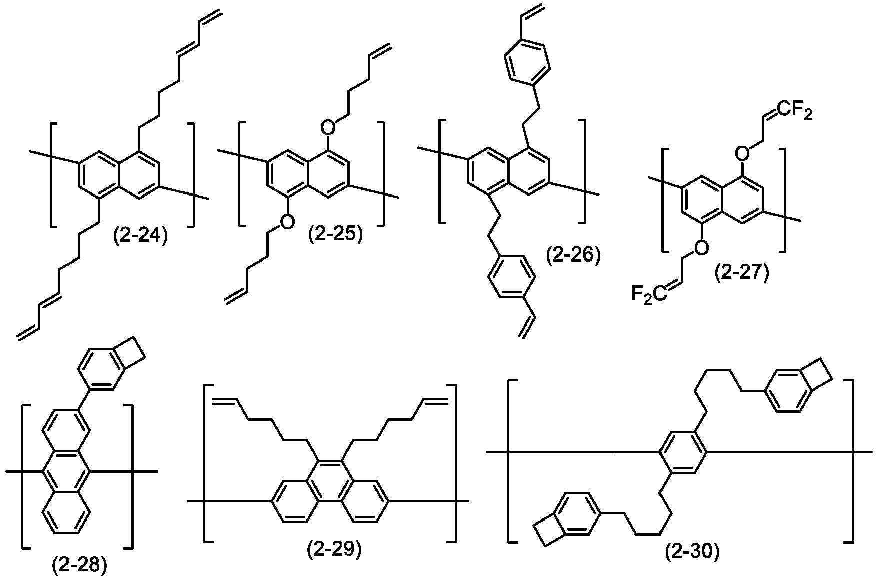

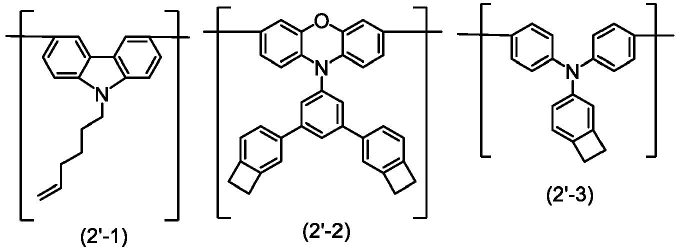

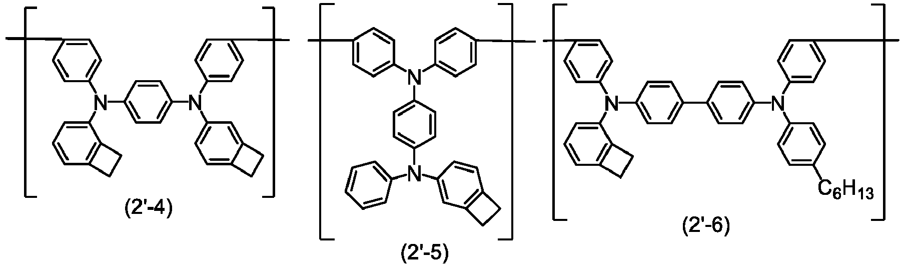

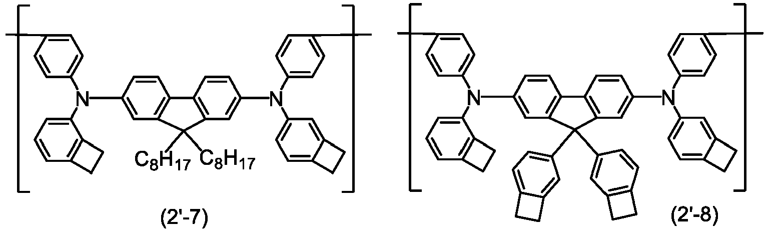

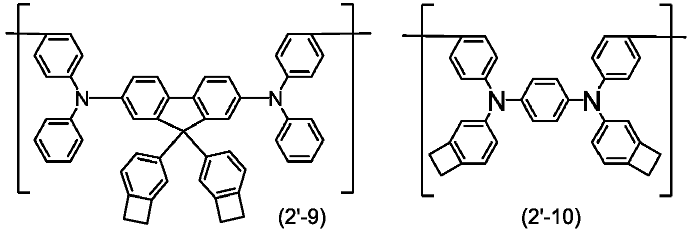

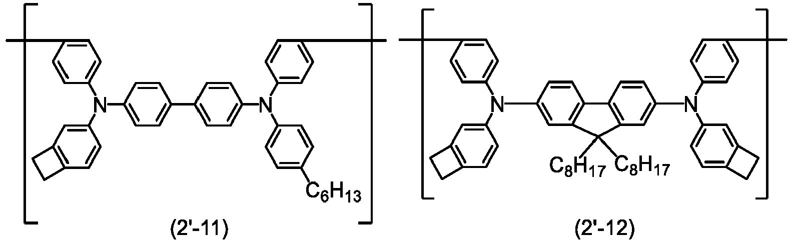

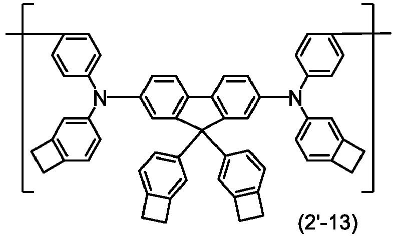

### [Other constitutional unit]

It is preferable that the polymer compound of the second organic layer further comprises a constitutional unit represented by the formula (X), because hole transportability is excellent. 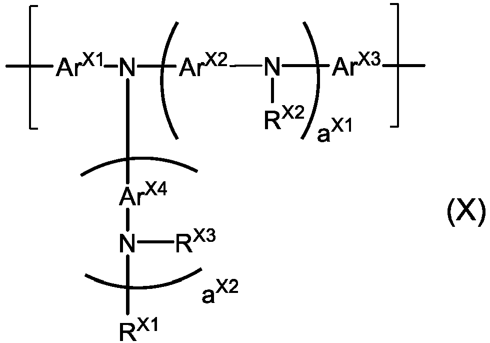 [wherein, a^{X1} and a^{X2} each independently represent an intege r of 0 or more. Ar^{X1} and Ar^{X3} each independently represent a n arylene group or a divalent heterocyclic ring group, and t hese groups each optionally have a substituent. Ar^{X2} and Ar ^{X4} each independently represent an arylene group, a divalent heterocyclic ring group or a divalent group in which at lea st one arylene group and at least one divalent heterocyclic ring group are bonded directly to each other, and these grou ps each optionally have a substituent. R^{X1}, R^{X2} and R^{X3} each independently represent a hydrogen atom, an alkyl group, a cycloalkyl group, an aryl group or a monovalent heterocyclic group, and these groups each optionally have a substituent. ]

a^{X1} is preferably 2 or less, more preferably 1, because the external quantum efficiency of the light emitting device of the present invention is excellent.

a^{X2} is preferably 2 or less, more preferably 0, because the external quantum efficiency of the light emitting device of the present invention is excellent.

R^{X1} , R^{X2} and R^{X3} are preferably an alkyl group, a cycloalkyl group, an aryl group or a monovalent heterocyclic group, more preferably an aryl group, and these groups each optionally have a substituent.

The arylene group represented by Ar^{X1} and Ar^{X3} is more preferably a group represented by the formula (A-1) or the formula (A-9), further preferably a group represented by the formula (A-1), and these groups each optionally have a substituent.

The divalent heterocyclic group represented by Ar^{X1} and Ar^{X3} is more preferably a group represented by the formula (AA-1), the formula (AA-2) or the formula (AA-7) to (AA-26), and these groups each optionally have a substituent.

Ar^{X1} and Ar^{X3} are preferably an arylene group optionally having a substituent.

The arylene group represented by Ar^{X2} and Ar^{X4} is more preferably a group represented by the formula (A-1) , the formula (A-6), the formula (A-7), the formula (A-9) to (A-11) or the formula (A-19), and these groups each optionally have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and the further preferable range of the arylene group and the divalent heterocyclic group in the divalent group in which at least one arylene group and at least one divalent heterocyclic group are bonded directly to each other represented by Ar^{X2} and Ar^{X4} are the same as the more preferable range and the further preferable range of the arylene group and the divalent heterocyclic group represented by Ar^{X1} and Ar^{X3}, respectively.

The divalent group in which at least one arylene group and at least one divalent heterocyclic group are bonded directly to each other represented by Ar^{X2} and Ar^{X4} includes, for example, groups represented by the following formulae, and they each optionally have a substituent. 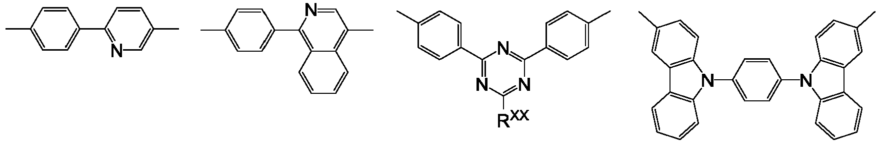 [wherein, R^{XX} represents a hydrogen atom, an alkyl group, a cycloalkyl group, an aryl group or a monovalent heterocyclic group, and these groups each optionally have a substituent.]

R^{XX} is preferably an alkyl group, a cycloalkyl group or an aryl group, and these groups each optionally have a substituent.

Ar^{X2} and Ar^{X4} are preferably an arylene group optionally having a substituent.

The substituent which the group represented by Ar^{X1} to Ar^{X4} and R^{X1} to R^{X3} optionally has is preferably an alkyl group, a cycloalkyl group or an aryl group, and these groups each optionally further have a substituent.

The constitutional unit represented by the formula (X) is preferably a constitutional unit represented by the formula (X-1) to (X-7), more preferably a constitutional unit represented by the formula (X-3) to (X-7), further preferably a constitutional unit represented by the formula (X-3) to (X-6) . 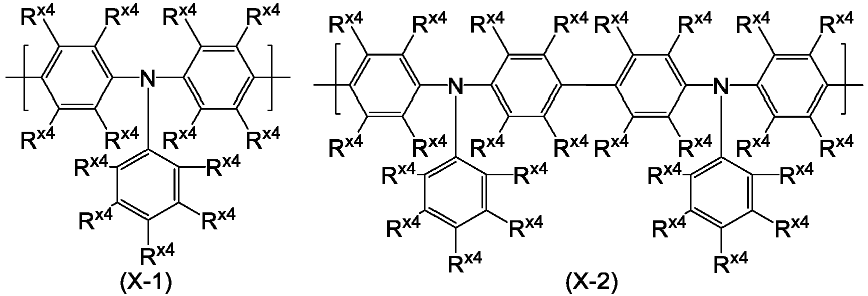 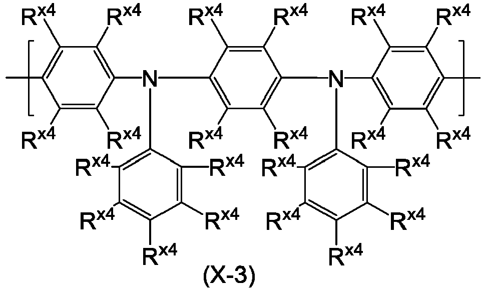 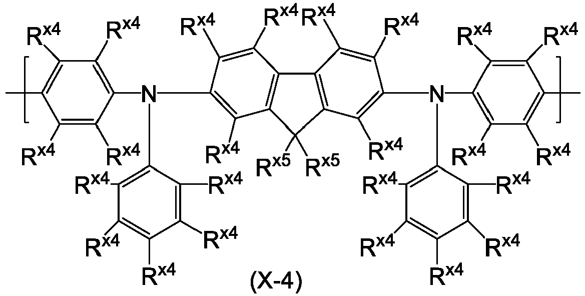 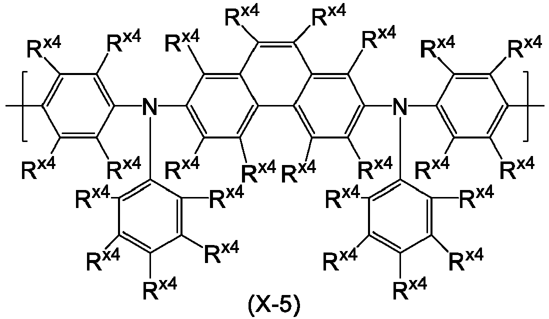 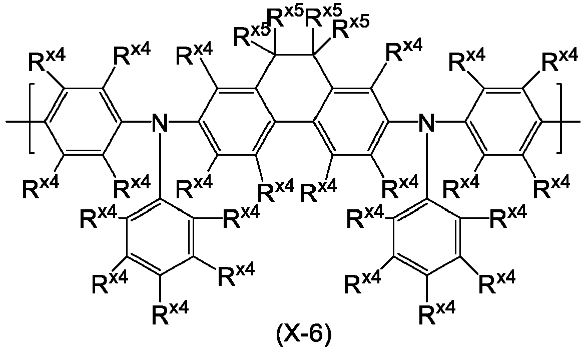 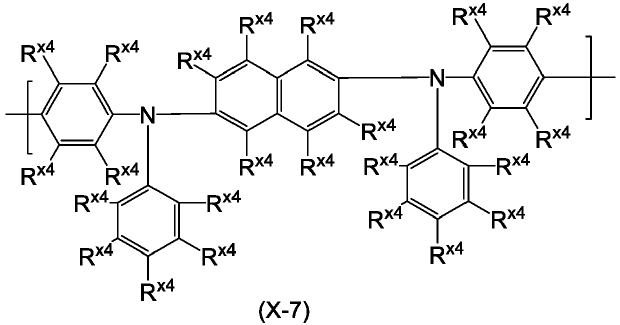 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and these groups each optionally have a substituent. The plurality of R^{X4} may be the same or different. The plurality of R^{X5} may be the same or different, and adjacent groups R^{X5} may be combined together to form a ring together with the carbon atoms to which they are attached.]

The content of the constitutional unit represented by the formula (X) is preferably 0.1 to 90 mol%, more preferably 5 to 70 mol%, further preferably 10 to 50 mol% with respect to the total content of constitutional units contained in the polymer compound of the second organic layer, because hole transportability is excellent.

The constitutional unit represented by the formula (X) includes, for example, constitutional units represented by the formulae (X1-1) to (X1-19), preferably constitutional units represented by the formulae (X1-6) to (X1-14).

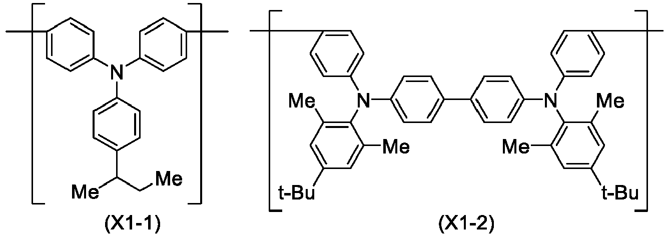

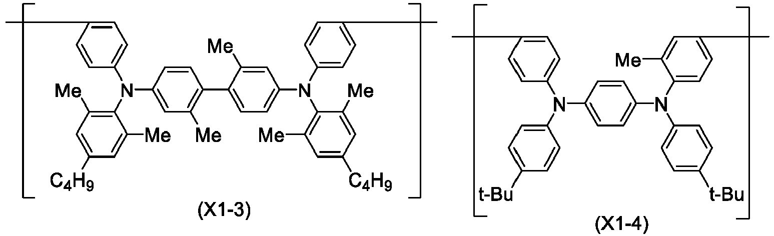

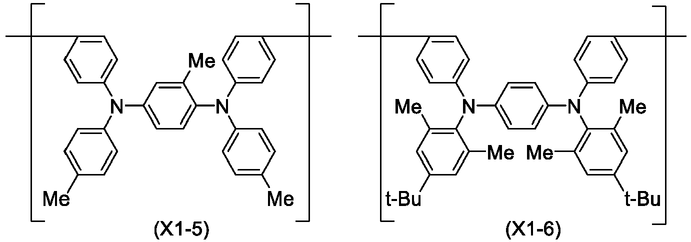

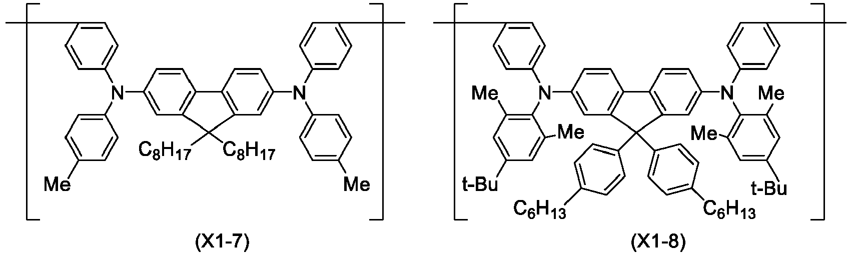

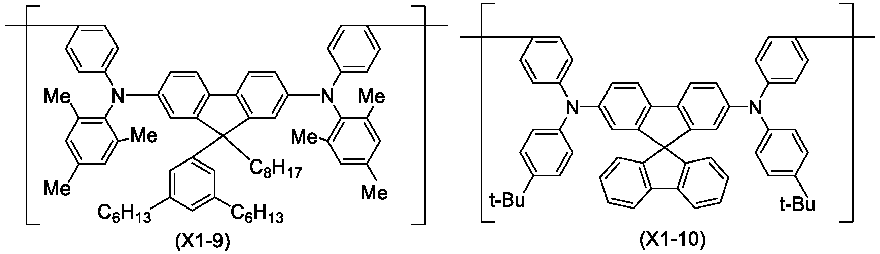

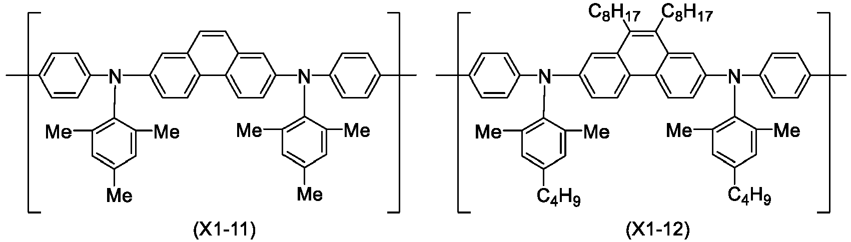

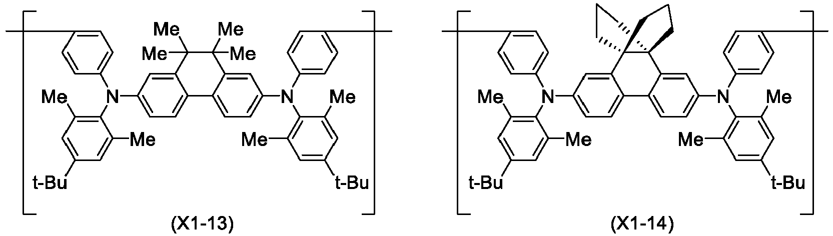

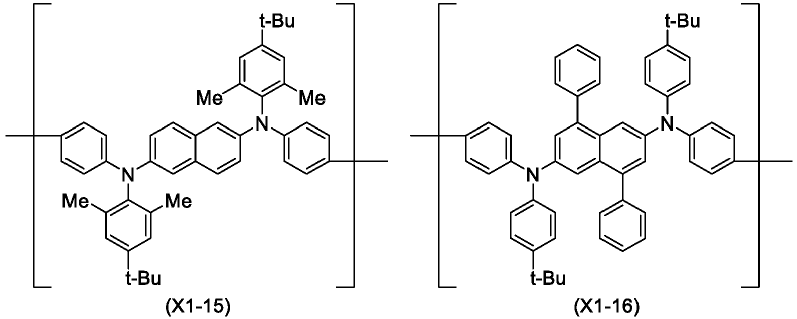

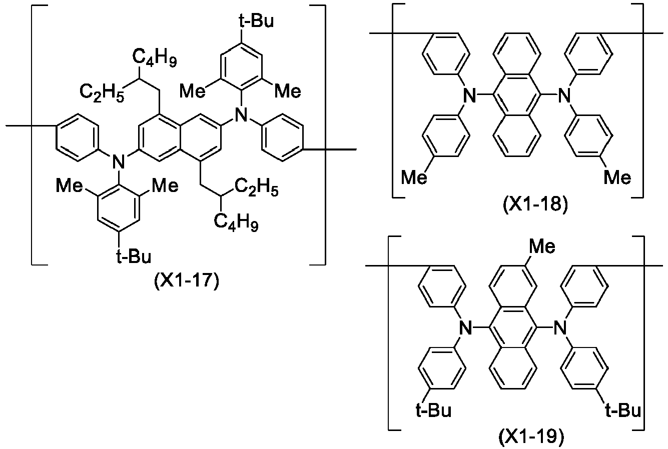

The constitutional unit represented by the formula (X) may be contained only singly or two or more units thereof may be contained in the polymer compound of the second organic layer.

It is preferable that the polymer compound of the second organic layer further comprises a constitutional unit represented by the formula (Y), because the external quantum efficiency of the light emitting device of the present invention is excellent.

It is preferable that the polymer compound of the second organic layer further comprises a constitutional unit represented by the formula (X) and a constitutional unit represented by the formula (Y), because the external quantum efficiency of the light emitting device of the present invention is excellent. 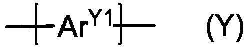 [wherein, Ar^{Y1} represents an arylene group, a divalent heterocyclic ring group or a divalent group in which at least one arylene group and at least one divalent heterocyclic ring group are bonded directly to each other, and these groups each optionally have a substituent.]

The arylene group represented by Ar^{Y1} is more preferably a group represented by the formula (A-1), the formula (A-6), the formula (A-7), the formula (A-9) to (A-11), the formula (A-13) or the formula (A-19), further preferably a group represented by the formula (A-1) , the formula (A-7), the formula (A-9) or the formula (A-19), and these groups each optionally have a substituent.

The divalent heterocyclic group represented by Ar^{Y1} is more preferably a group represented by the formula (AA-4), the formula (AA-10), the formula (AA-13), the formula (AA-15), the formula (AA-18) or the formula (AA-20), further preferably a group represented by the formula (AA-4), the formula (AA-10), the formula (AA-18) or the formula (AA-20), and these groups each optionally have a substituent.

The more preferable range and the further preferable range of the arylene group and the divalent heterocyclic group in the divalent group in which at least one arylene group and at least one divalent heterocyclic group are bonded directly to each other represented by Ar^{Y1} are the same as the more preferable range and the further preferable range of the arylene group and the divalent heterocyclic group represented by Ar^{Y1} described above, respectively.

The divalent group in which at least one arylene group and at least one divalent heterocyclic group are bonded directly to each other represented by Ar^{Y1} includes the same groups as the divalent group in which at least one arylene group and at least one divalent heterocyclic group are bonded directly to each other represented by Ar^{X2} and Ar^{X4} in the formula (X).

The substituent which the group represented by Ar^{Y1} optionally has is preferably an alkyl group, a cycloalkyl group or an aryl group, and these groups each optionally further have a substituent.

The constitutional unit represented by the formula (Y) includes, for example, constitutional units represented by the formulae (Y-1) to (Y-7), and from the standpoint of the external quantum efficiency of the light emitting device of the present invention preferable is a constitutional unit represented by the formula (Y-1) or (Y-2), from the standpoint of electron transportability of the polymer compound of the second organic layer preferable is a constitutional unit represented by the formula (Y-3) or (Y-4), and from the standpoint of hole transportability of the polymer compound of the second organic layer preferable are constitutional units represented by the formulae (Y-5) to (Y-7). 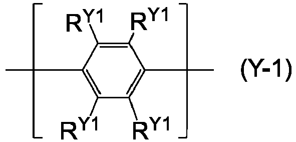 [wherein, R^{Y1} represents a hydrogen atom, an alkyl group, a cycloalkyl group, an alkoxyl group, a cycloalkoxy group, an aryl group or a monovalent heterocyclic group, and these groups each optionally have a substituent. The plurality of R^{Y1} may be the same or different, and adjacent groups R^{Y1} may be combined together to form a ring together with the carbon atoms to which they are attached.]

R^{Y1} is preferably a hydrogen atom, an alkyl group, a cycloalkyl group or an aryl group, and these groups each optionally have a substituent.

The constitional unit represented by the formula (Y-1) is preferably a constitutional unit represented by the formula (Y-1'). 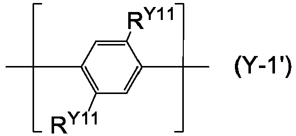 [wherein, R^{Y11} represents an alkyl group, a cycloalkyl group, an alkoxy group, a cycloalkoxy group, an aryl group or a monovalent heterocyclic group, and these groups each optionally have a substituent. The plurality of R^{Y1} may be the same or different.]

R^{Y11} is preferably an alkyl group, a cycloalkyl group or an aryl group, more preferably an alkyl group or a cycloalkyl group, and these groups each optionally have a substituent. 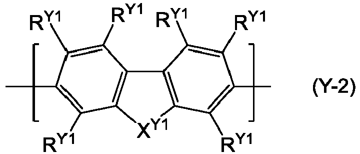 [wherein, R^{Y1} represents the same meaning as described above. X^{Y1} represents a group represented by -C(R^{Y2})₂-, -C(R^{Y2}) = C(R^{Y2})- or -C (R^{Y2})₂-C(R^{Y2})₂-. R^{Y2} represents a hydrogen atom, an alkyl group, a cycloalkyl group, an alkoxyl group, a cycloalkoxy group, an aryl group or a monovalent heterocyclic group, and these groups each optionally have a substituent. The plurality of R^{Y2} may be the same or different, and groups R^{Y2} may be combined together to form a ring together with the carbon atoms to which they are attached.]

R^{Y2} is preferably an alkyl group, a cycloalkyl group, an aryl group or a monovalent heterocyclic group, more preferably an alkyl group a cycloalkyl group or an aryl group, and these groups each optionally have a substituent.

Regarding the combination of two R^{Y2}s in the group represented by -C(R^{Y2})₂ - in X^{Y1}, it is preferable that the both are an alkyl group or a cycloalkyl group, the both are an aryl group, the both are a monovalent heterocyclic group, or one is an alkyl group or a cycloalkyl group and the other is an aryl group or a monovalent heterocyclic group, it is more preferable that one is an alkyl group or cycloalkyl group and the other is an aryl group, and these groups each optionally have a substituent. The two groups R^{Y2} may be combined together to form a ring together with the atoms to which they are attached, and when the groups R^{Y2} form a ring, the group represented by -C(R^{Y2})₂- is preferably a group represented by the formula (Y-A1) to (Y-A5), more preferably a group represented by the formula (Y-A4), and these groups each optionally have a substituent.

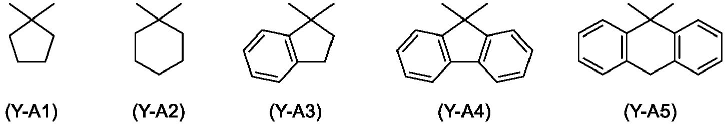

Regarding the combination of two R^{Y2}s in the group represented by -C(R^{Y2})=C(R^{Y2})- in X^{Y1}, it is preferable that the both are an alkyl group or cycloalkyl group, or one is an alkyl group or a cycloalkyl group and the other is an aryl group, and these groups each optionally have a substituent.

Four R^{Y2} s in the group represented by -C(R^{Y2})₂ -C(R^{Y2})₂ - in X^{Y1} are preferably an alkyl group or a cycloalkyl group optionally having a substituent. The plurality of R^{Y2} may be combined together to form a ring together with the atoms to which they are attached, and when the groups R^{Y2} form a ring, the group represented by -C(R^{Y2})₂-C(R^{Y2})₂- is preferably a group represented by the formula (Y-B1) to (Y-B5), more preferably a group represented by the formula (Y-B3), and these groups each optionally have a substituent. 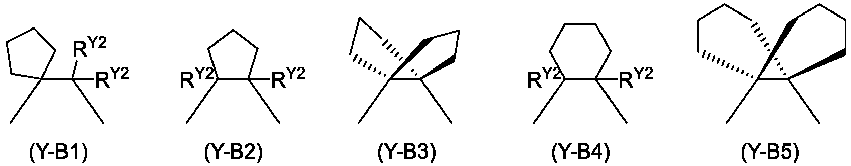 [wherein, R^{Y2} represents the same meaning as described above.]

It is preferable that the constitutional unit represented by the formula (Y-2) is a constitutional unit represented by the formula (Y-2'). 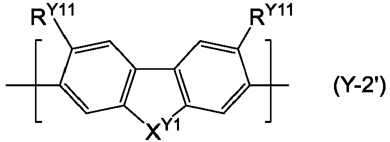 [wherein, R^{Y11} and X^{Y1} represent the same meaning as described above.] 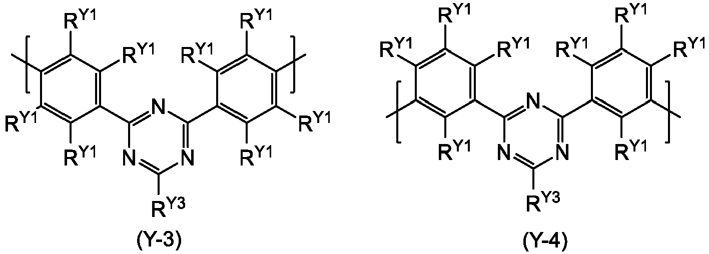 [wherein, R^{Y1} represents the same meaning as described above. R^{Y3} represents a hydrogen atom, an alkyl group, a cycloalkyl group, an alkoxy group, a cycloalkoxy group, an aryl group or a monovalent heterocyclic group, and these groups each optionally have a substituent.]

R^{Y3} is preferably an alkyl group, a cycloalkyl group, an alkoxy group, a cycloalkoxy group, an aryl group or a monovalent heterocyclic group, more preferably an aryl group, and these groups each optionally have a substituent. 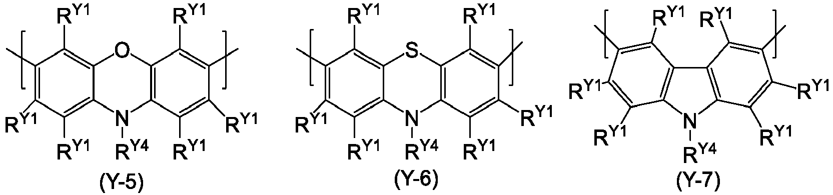 [wherein, R^{Y1} represents the same meaning as described above. R^{Y4} represents a hydrogen atom, an alkyl group, a cycloalkyl group, an alkoxy group, a cycloalkoxy group, an aryl group or a monovalent heterocyclic group, and these groups each optionally have a substituent.]

R^{Y4} is preferably an alkyl group, a cycloalkyl group, an alkoxy group, a cycloalkoxy group, an aryl group or a monovalent heterocyclic group, more preferably an aryl group, and these groups each optionally have a substituent.

The constitutional unit represented by the formula (Y) includes, for example, consititutional units represented by the formulae (Y-11) to (Y-55).

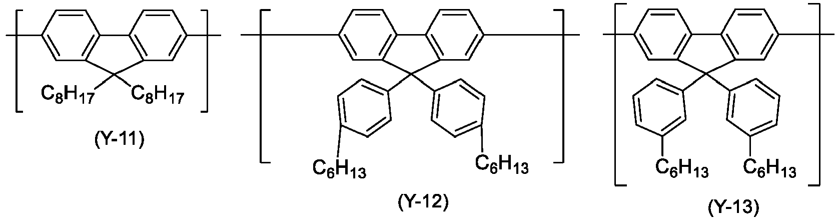

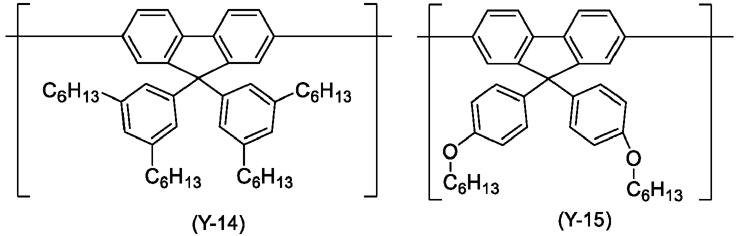

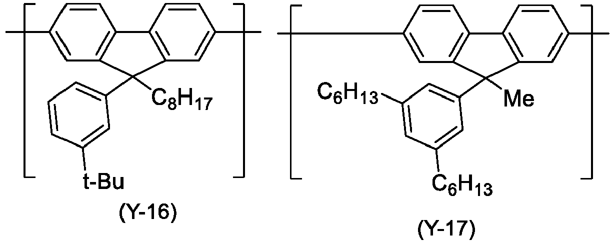

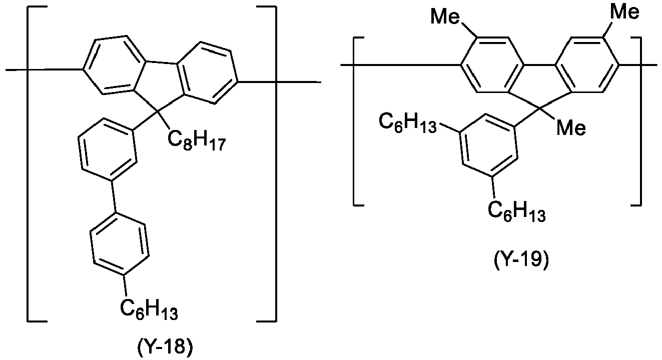

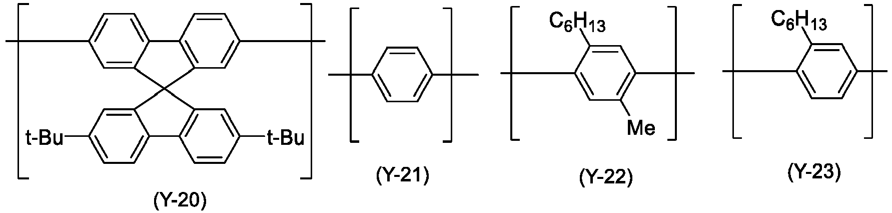

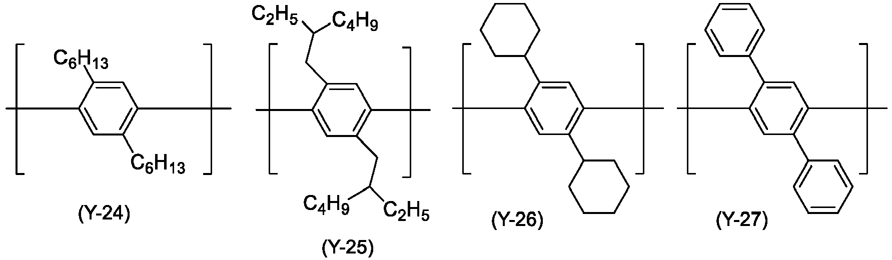

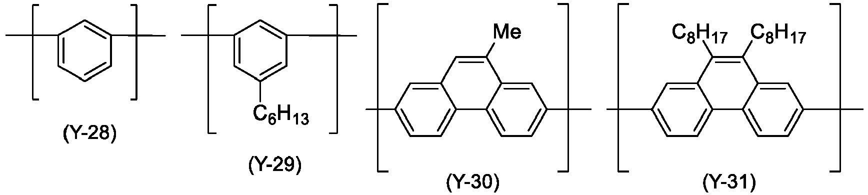

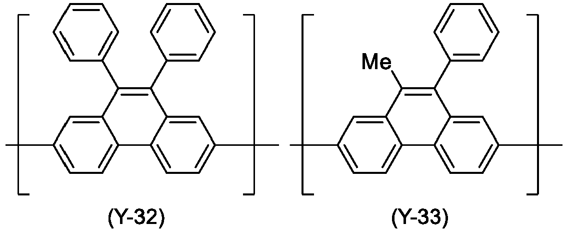

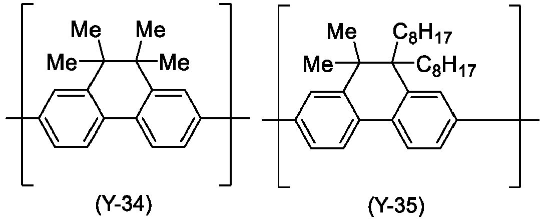

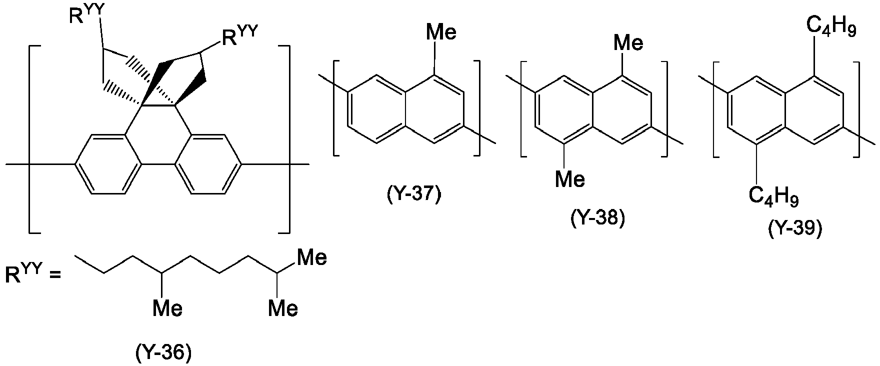

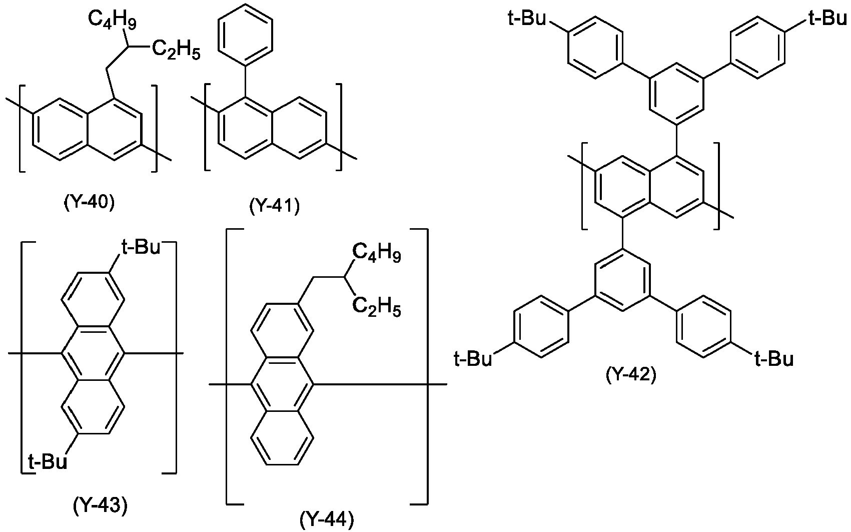

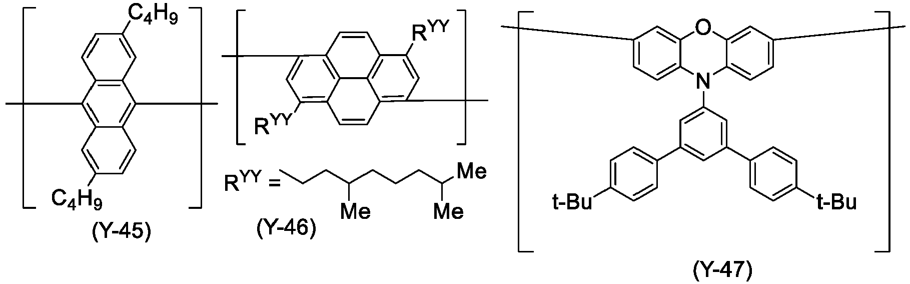

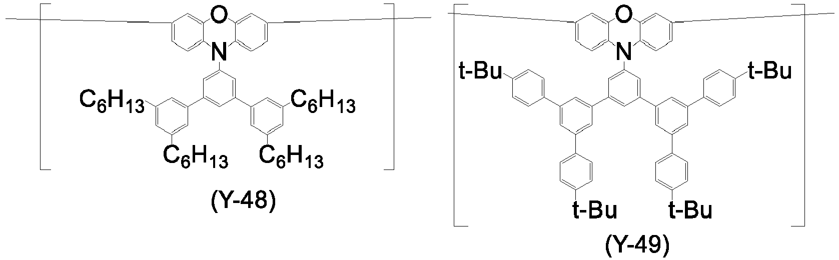

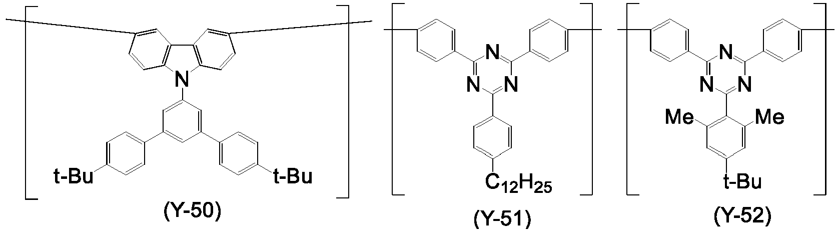

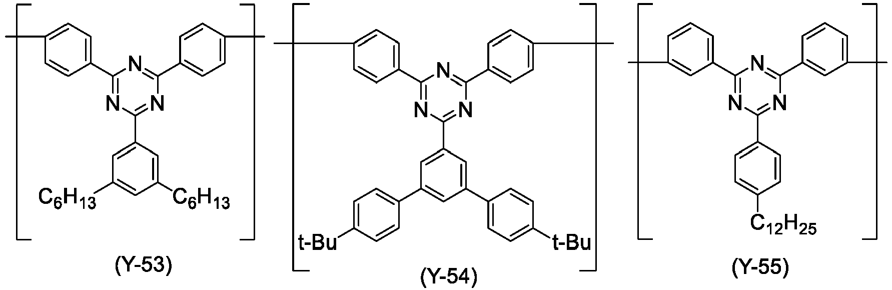

The content of the constitutional unit represented by the formula (Y) in which Ar^{Y1} is an arylene group is preferably 0.5 to 80 mol%, more preferably 30 to 60 mol% with respect to the total content of constitutional units contained in the polymer compound of the second organic layer, because the external quantum efficiency of the light emitting device of the present invention is excellent.

The content of the constitutional unit represented by the formula (Y) in which Ar^{Y1} is a divalent heterocyclic group or a divalent group in which at least one arylene group and at least one divalent heterocyclic group are bonded directly to each other is preferably 0.5 to 50 mol%, more preferably 3 to 40 mol% with respect to the total content of constitutional units contained in the polymer compound of the second organic layer, because the charge transportability of the light emitting device of the present invention is excellent.

The constitutional unit represented by the formula (Y) may be contained only singly or two or more units thereof may be contained in the polymer compound of the second organic layer.

The polymer compound of the second organic layer includes, for example, polymer compounds P-1 to P-9 shown in Table 7. "Other constitutional unit" denotes a constitutional unit other than constitutional units represented by the formula (2), the formula (2'), the formula (X) and the formula (Y).

**[Table 7]**

| polymer compound | constitutional unit and mole fraction thereof | | | | |
|---|---|---|---|---|---|
| | formula (2) | formula (2') | formula (X) | formula (Y) | other |
| | q | r | s | t | u |
| P-1 | 0.1 to 99.9 | 0 | 0.1 to 99.9 | 0 | 0 to 30 |
| P-2 | 0.1 to 99.9 | 0 | 0 | 0.1 to 99.9 | 0 to 30 |
| P-3 | 0 | 0.1 to 99.9 | 0.1 to 99.9 | 0 | 0 to 30 |
| P-4 | 0 | 0.1 to 99.9 | 0 | 0.1 to 99.9 | 0 to 30 |
| P-5 | 0.1 to 99.8 | 0.1 to 99.8 | 0.1 to 99.8 | 0 | 0 to 30 |
| P-6 | 0.1 to 99.8 | 0.1 to 99.8 | 0 | 0.1 to 99.8 | 0 to 30 |
| P-7 | 0.1 to 99.8 | 0 | 0.1 to 99.8 | 0.1 to 99.8 | 0 to 30 |
| P-8 | 0 | 0.1 to 99.8 | 0.1 to 99.8 | 0.1 to 99.8 | 0 to 30 |
| P-9 | 0.1 to 99.7 | 0.1 to 99.7 | 0.1 to 99.7 | 0.1 to 99.7 | 0 to 30 |

[in the table, q, r, s, t and u represent the mole fraction of each constitutional unit. q + r + s + t + u = 100 and, 70 ≤ q + r + s + t ≤ 100.]

The examples and preferable ranges of constitutional units represented by the formula (2), the formula (2'), the formula (X) and the formula (Y) in the polymer compounds P-1 to P-9 are as described above.

### <Production method of polymer compound of second organic layer>

The polymer compound of the second organic layer can be produced by using known polymerization methods described in Chem. Rev., vol. 109, pp. 897-1091 (2009) and the like, and the known polymerization methods include, for example, methods for causing polymerization by a coupling reaction using a transition metal catalyst such as the Suzuki reaction, the Yamamoto reaction, the Buchwald reaction, the Stille reaction, the Negishi reaction and the Kumada reaction.

In the above-described polymerization methods, the monomer charging method includes a method in which the total amount of monomers is charged in a lump into the reaction system, a method in which a part of monomers is charged and reacted, then, the remaining monomers are charged in a lump, continuously or in divided doses, a method in which monomers are charged continuously or in divided doses, and the like.

The transition metal catalyst includes a palladium catalyst and a nickel catalyst.

The post treatment of the polymerization reaction is conducted by using known methods, for example, a method in which water-soluble impurities are removed by liquid-separation, a method in which the reaction solution after the polymerization reaction is added to a lower alcohol such as methanol and the like, the deposited precipitate is filtrated, then, dried, and other methods, singly or in combination. When the purity of the polymer host is low, purification can be carried out by usual methods such as, for example, recrystallization, reprecipitation, continuous extraction using a Soxhlet extractor, column chromatography and the like.

### [Composition of second organic layer]

The second organic layer may be a layer obtained by using a composition comprising the polymer compound of the second organic layer and at least one material selected from the group consisting of a hole transporting material, a hole injection material, an electron transporting material, an electron injection material, a light emitting material, an antioxidant and a solvent (hereinafter, referred to also as "composition of second organic layer".).

The examples and preferable range of the hole transporting material, the electron transporting material, the hole injection material, the electron injection material and the light emitting material contained in the composition of the second organic layer are the same as the examples and preferable range of the hole transporting material, the electron transporting material, the hole injection material, the electron injection material and the light emitting material contained in the composition of the first organic layer. In the composition of the second organic layer, the compounding amount of each of the hole transporting material, the electron transporting material, the hole injection material, the electron injection material and the light emitting material is usually 1 to 400 parts by weight, preferably 5 to 150 parts by weight when the amount of the polymer compound of the second organic layer is 100 parts by weight.

The examples and preferable range of the antioxidant contained in the composition of the second organic layer are the same as the examples and preferable range of the antioxidant contained in the composition of the first organic layer. In the composition of the second organic layer, the compounding amount of the antioxidant is usually 0.001 to 10 parts by weight when the amount of the polymer compound of the second organic layer is 100 parts by weight.

### [Ink of second organic layer]

The composition of the second organic layer comprising a solvent (hereinafter, referred to also as "ink of second organic layer".) can be suitably used in application methods such as a spin coat method and an inkjet printing method, like the ink of the first organic layer.

The preferable range of the viscosity of the ink of the second organic layer is the same as the preferable range of the viscosity of the ink of the first organic layer.

The examples and preferable range of the solvent contained in the ink of the second organic layer are the same as the examples and preferable range of the solvent contained in the ink of the first organic layer.

In the ink of the second organic layer, the compounding amount of the solvent is usually 1000 to 100000 parts by weight, preferably 2000 to 20000 parts by weight when the amount of the polymer compound of the second organic layer is 100 parts by weight.

### <Layer constitution of light emitting device>

The light emitting device of the present invention comprises an anode, a cathode, a first organic layer disposed between the anode and the cathode and a second organic layer disposed between the anode and the cathode. The light emitting device of the present invention may have a layer other than the anode, the cathode, the first organic layer and the second organic layer.

In the light emitting device of the present invention, the first organic layer is usually a light emitting layer.

In the light emitting device of the present invention, the second organic layer is usually a second light emitting layer, a hole transporting layer or an electron transporting layer, more preferably a hole transporting layer. The second organic layer is a layer obtained by using the polymer compound of the second organic layer, and the polymer compound of the second organic layer may be used singly, or two or more of the polymer compounds may be used.

In the light emitting device of the present invention, it is preferable that the first organic layer and the second organic layer are adjacent, because the light emitting device of the present invention is more excellent in external quantum efficiency.

In the light emitting device of the present invention, the second organic layer is preferably a layer disposed between the anode and the first organic layer, more preferably a hole transporting layer disposed between the anode and the first organic layer, because the light emitting device of the present invention is more excellent in external quantum efficiency.

It is preferable that the light emitting device of the present invention has further a hole injection layer between the anode and the second organic layer disposed between the anode and the first organic layer, because the light emitting device of the present invention is further excellent in external quantum efficiency. Further, it is preferable that the light emitting device of the present invention has further at least one of an electron injection layer and an electron transporting layer between the cathode and the first organic layer disposed between the cathode and the second organic layer, because the light emitting device of the present invention is further excellent in external quantum efficiency.

The light emitting device of the present invention may further have an arbitrary layer such as a charge generating layer.

The specific layer constitution of the light emitting device of the present invention includes, for example, layer constitutions represented by the following (D1) to (D19) . The light emitting device of the present invention usually has a substrate, and an anode may be laminated on the substrate, or a cathode may be laminated on the substrate.
(D1) anode/second light emitting layer (second organic layer)/light emitting layer (first organic layer)/cathode
(D2) anode/light emitting layer (first organic layer)/second light emitting layer (second organic layer)/cathode
(D3) anode/light emitting layer (first organic layer)/electron transporting layer (second organic layer)/cathode
(D4) anode/hole injection layer/light emitting layer (first organic layer)/electron transporting layer (second organic layer)/electron injection layer/cathode
(D5) anode/hole injection layer/hole transporting layer/second light emitting layer/light emitting layer (first organic layer)/electron transporting layer (second organic layer)/electron injection layer/cathode
(D6) anode/hole injection layer/second light emitting layer (second organic layer)/light emitting layer (first organic layer)/electron injection layer/cathode
(D7) anode/hole injection layer/hole transporting layer/second light emitting layer (second organic layer) /light emitting layer (first organic layer)/electron transporting layer/electron injection layer/cathode
(D8) anode/hole transporting layer (second organic layer)/light emitting layer (first organic layer)/cathode
(D9) anode/hole transporting layer (second organic layer)/light emitting layer (first organic layer)/electron injection layer/cathode
(D10) anode/hole transporting layer (second organic layer)/light emitting layer (first organic layer)/electron transporting layer/cathode
(D11) anode/hole transporting layer (second organic layer)/light emitting layer (first organic layer)/electron transporting layer/electron injection layer/cathode
(D12) anode/hole injection layer/hole transporting layer (second organic layer)/light emitting layer (first organic layer)/cathode
(D13) anode/hole injection layer/hole transporting layer (second organic layer)/light emitting layer (first organic layer)/electron injection layer/cathode
(D14) anode/hole injection layer/hole transporting layer (second organic layer)/light emitting layer (first organic layer)/electron transporting layer/cathode
(D15) anode/hole injection layer/hole transporting layer (second organic layer)/light emitting layer (first organic layer)/electron transporting layer/electron injection layer/cathode
(D16) anode/second light emitting layer (second organic layer)/charge generating layer/light emitting layer (first organic layer)/cathode
(D17) anode/hole transporting layer (second organic layer)/light emitting layer (first organic layer)/charge generating layer/hole transporting layer/second light emitting layer/cathode
(D18) anode/hole transporting layer (second organic layer)/light emitting layer (first organic layer)/electron transporting layer/charge generating layer/hole transporting layer (second organic layer)/light emitting layer (first organic layer)/electron transporting layer/cathode
(D19) anode/hole injection layer/hole transporting layer (second organic layer)/light emitting layer (first organic layer)/electron transporting layer/charge generating layer/hole injection layer/hole transporting layer (second organic layer)/light emitting layer (first organic layer)/electron transporting layer/electron injection layer/cathode

In the above-described (D1) to (D19), "/" means that layers before and after it are adjacently laminated. Specifically, "hole transporting layer (second organic layer) /light emitting layer (first organic layer)" means that a hole transporting layer (second organic layer) and a light emitting layer (first organic layer) adjacently laminated.

Layer constitutions represented by the above-described (D6) to (D15) are preferable, and layer constitutions represented by the above-described (D12) to (D15) are more preferable, because the light emitting device of the present invention is more excellent in external quantum efficiency.

In the light emitting device of the present invention, if necessary, two or more of each of an anode, a cathode, a hole injection layer, a hole transporting layer, a light emitting layer, a second light emitting layer, an electron transporting layer, an electron injection layer and a charge generating layer may be provided.

When a plurality of anodes, cathodes, hole injection layers, hole transporting layers, light emitting layers, second light emitting layers, electron transporting layers, electron injection layers and charge generating layers are present, they may be the same or different at each occurrence.

The thickness of an anode, a cathode, a hole injection layer, a hole transporting layer, a light emitting layer, a second light emitting layer, an electron transporting layer, an electron injection layer and a charge transporting layer is usually 1 nm to 1 µm, preferably 2 nm to 500 nm, further preferably 5 nm to 150 nm.

In the light emitting device of the present invention, the order, the number and the thickness of layers to be laminated may be advantageously adjusted in view of the external quantum efficiency and the device life of the light emitting device.

### [Light emitting layer]

The light emitting layer is usually a first organic layer. The first organic layer is a layer obtained by using the composition of the first organic layer as described above.

### [Second light emitting layer]

The second light emitting layer is usually a second organic layer or a layer formed by using a light emitting material, preferably a layer formed by using a light emitting material. The second organic layer is a layer obtained by using the polymer compound of the second organic layer, as described above. The light emitting material used for formation of the second light emitting layer includes, for example, light emitting materials which the composition of the first organic layer may comprise described above.

### [Hole transporting layer]

The hole transporting layer is usually a second organic layer or a layer formed by using a hole transporting material, preferably a second organic layer. The second organic layer is a layer obtained by using the polymer compound of the second organic layer, as described above. The hole transporting material used for formation of the hole transporting layer includes, for example, hole transporting materials which the composition of the first organic layer may comprise described above.

### [Electron transporting layer]

The electron transporting layer is usually a second organic layer or a layer formed by using an electron transporting material, preferably a layer obtained by using an electron transporting material. The second organic layer is a layer obtained by using the polymer compound of the second organic layer as described above. The electron transporting material used for formation of the electron transporting layer includes, for example, electron transporting materials which the composition of the first organic layer may comprise described above.

When the light emitting device of the present invention has an electron transporting layer and the electron transporting layer is not a second organic layer, a polymer compound comprising at least one constitutional unit selected from the group consisting of a constitutional unit represented by the formula (ET-1) and a constitutional unit represented by the formula (ET-2) is preferable as the electron transporting material used for formation of an electron transporting layer. 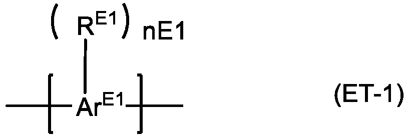 [wherein,
nE1 represents an integer of 1 or more.

Ar^{E1} represents an aromatic hydrocarbon group or a heterocyclic group, and these groups each optionally have a substituent other than R^{E1}.

R^{E1} represents a group represented by the formula (ES-1) . When a plurality of R^{E1} are present, they may be the same or different.]

-R^{E3}-{(Q^{E1})_{nE3}-Y^{E1}(M^{E1})_{aE1}(Z^{E1})_{bE1}}_{mE1} (ES-1)

[wherein,
nE3 represents an integer of 0 or more, aE1 represents an integer of 1 or more, bE1 represents an integer of 0 or more, and mE1 represents an integer of 1 or more. When a plurality of nE3, aE1 and bE1 are present, they may be the same or different at each occurrence. mE1 is 1 when R^{E3} is a single bond. aE1 and bE1 are selected so that the charge of the group represented by the formula (ES-1) is 0.

R^{E3} represents a single bond, a hydrocarbon group, a heterocyclic group or -O-R^{E3'} (R^{E3'} represents a hydrocarbon group or a heterocyclic group.), and these groups each optionally have a substituent.

Q^{E1} represents an alkylene group, a cycloalkylene group, an arylene group, an oxygen atom or a sulfur atom, and these groups each optionally have a substituent. When a plurality of Q^{E1} are present, they may be the same or different.

Y^{E1} represents -CO₂⁻, -SO₃⁻, -SO₂⁻ or PO3²⁻. When a plurality of Y^{E1} are present, they may be the same or different.

M^{E1} represents an alkali metal cation, an alkaline earth metal cation or an ammonium cation, and this ammonium cation optionally has a substituent. When a plurality of M^{E1} are present, they may be the same or different.

Z^{E1} represents F⁻, Cl⁻, Br⁻, I⁻, OH-, B(R^{E4})₄⁻, R^{E4}SO₃⁻, R^{E4}COO⁻, NO₃⁻, SO₄²⁻, HSO₄⁻, PO₄³⁻, HPO₄²⁻, H₂PO₄⁻, BF₄⁻ or PF₆⁻ . R^{E4} represents an alkyl group, a cycloalkyl group or an aryl group, and these groups each optionally have a substituent. When a plurality of Z^{E1} are present, they may be the same or different.]

nE1 is usually an integer of 1 to 4, preferably 1 or 2.

The aromatic hydrocarbon group or the heterocyclic group represented by Ar^{E1} is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE1 hydrogen atoms bonding directly to atoms constituting the ring, and may have a substituent other than R^{E1}.

The substituent other than R^{E1} which Ar^{E1} optionally has includes a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group, a cycloalkynyl group, a carboxyl group and a group represented by the formula (ES-3) .

-O-(C_{n'}H_{2n'}O)ₙₓ-C_{m'}H_{2m'+1} (ES-3)

[wherein, n' , m' and nx each independently represent an integer of 1 or more.]

nE3 is usually an integer of 0 to 10, preferably an integer of 0 to 8, more preferably an integer of 0 to 2.

aE1 is usually an integer of 1 to 10, preferably an integer of 1 to 5, more preferably 1 or 2.

bE1 is usually an integer of 0 to 10, preferably an integer of 0 to 4, more preferably 0 or 1.

mE1 is usually an integer of 1 to 5, preferably 1 or 2, more preferably 0 or 1.

When R^{E3} is -O-R^{E3'}, the group represented by the formula (ES-1) is a group represented by the following formula.

-O-R^{E3'}-{(Q^{E1})_{nE3}-Y^{E1}(M^{E1})_{aE1}(Z^{E1})b_{E1}}_{mE1}

R^{E3} is preferably a hydrocarbon group or a heterocyclic group, more preferably an aromatic hydrocarbon group or an aromatic heterocyclic ring group, further preferably an aromatic hydrocarbon group.

The substituent which R^{E3} optionally has includes an alkyl group, a cycloalkyl group, an aryl group, a monovalent heterocyclic group and a group represented by the formula (ES-3), and a group represented by the formula (ES-3) is preferable.

Q^{E1} is preferably an alkylene group, an arylene group or an oxygen atom, more preferably an alkylene group or an oxygen atom.

Y^{E1} is preferably -CO₂⁻, -SO₂⁻ or PO₃²⁻, more preferably -CO₂⁻ .

The alkali metal cation represented by M^{E1} includes, for example, Li⁺, Na⁺, K⁺, Rb⁺, Cs⁺, preferably K⁺, Rb⁺ or Cs⁺, more preferably Cs⁺.

The alkaline earth metal cation represented by M^{E1} includes, for example, Be²⁺, Mg²⁺, Ca²⁺, Sr²⁺, Ba²⁺, preferably Mg²⁺, Ca²⁺, Sr²⁺ or Ba²⁺, more preferably Ba²⁺.

M^{E1} is preferably an alkali metal cation or an alkaline earth metal cation, more preferably an alkali metal cation.

Z^{E1} is preferably F⁻, Cl⁻, Br⁻, I⁻, OH⁻, B(R^{E4})₄⁻, R^{E4} SO₃⁻, R^{E4}COO⁻ or NO₃⁻. more preferably F⁻, Cl⁻, Br⁻, I⁻, OH⁻, R^{E4}SO₃⁻ or R^{E4}COO⁻. R^{E4} is preferably an alkyl group.

The group represented by the formula (ES-1) includes, for example, groups represented by the following formulae. 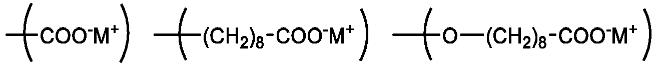 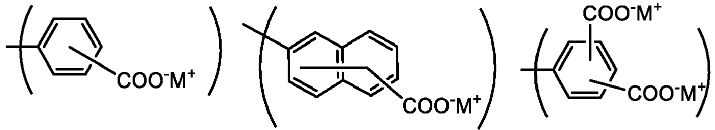 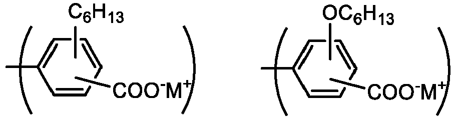 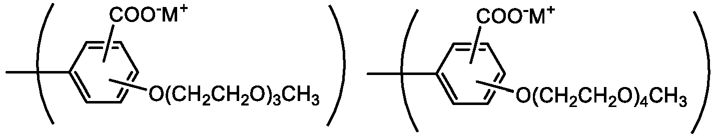 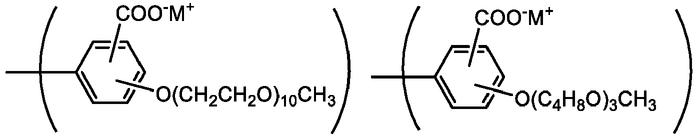 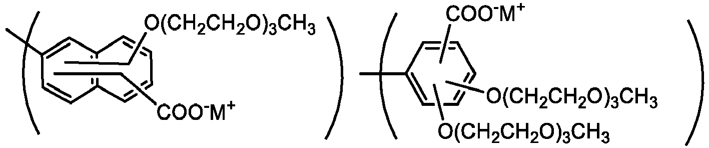 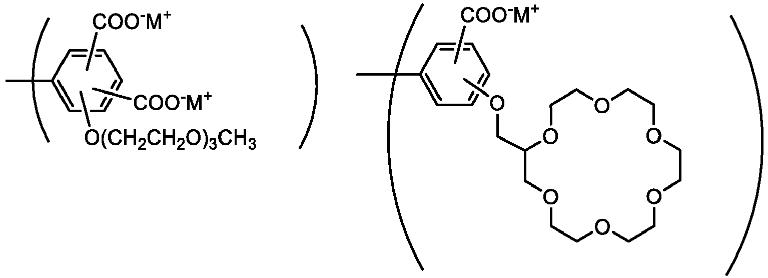 [wherein, M⁺ represents Li⁺, Na⁺, K⁺, Cs⁺ or N(CH₃)₄⁺. When a plurality of M⁺ are present, they may be the same or different.] 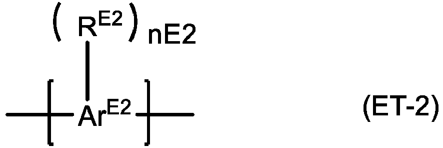 [wherein,
nE2 represents an integer of 1 or more.

Ar^{E2} represents an aromatic hydrocarbon group or a heterocyclic group, and these groups each optionally have a substituent other than R^{E2}.

R^{E2} represents a group represented by the formula (ES-2). When a plurality of R^{E2} are present, they may be the same or different.]

-R^{E5}-{(Q^{E2})_{nE4}-Y^{E2}(M^{E2})_{aE2}(Z^{E2})_{bE2}}_{mE2} (ES-2)

[wherein,
nE4 represents an integer of 0 or more, aE2 represents an integer of 1 or more, bE2 represents an integer of 0 or more, and mE2 represents an integer of 1 or more. When a plurality of nE4, aE2 and bE2 are present, they may be the same or different at each occurrence. mE2 is 1 when R^{E5} is a single bond. aE2 and bE2 are selected so that the charge of the group represented by the formula (ES-2) is 0.

R^{E5} represents a single bond, a hydrocarbon group, a heterocyclic group or -O-R^{E5'} (R^{E5'} represents a hydrocarbon group or a heterocyclic group.), and these groups each optionally have a substituent.

Q^{E2} represents an alkylene group, a cycloalkylene group, an arylene group, an oxygen atom or a sulfur atom, and these groups each optionally have a substituent. When a plurality of Q^{E2} are present, they may be the same or different.

Y^{E2} represents -C⁺R^{E6}₂, -N⁺R^{E6}₃, -P⁺R^{E6}₃, -S⁺R^{E6}₂ or I+R^{E6}₂. R^{E6} represents a hydrogen atom, an alkyl group, a cycloalkyl group or an aryl group, and these groups each optionally have a substituent. The plurality of R^{E6} may be the same or different. When a plurality of Y^{E2} are present, they may be the same or different.

M^{E2} represents F⁻, Cl⁻, Br⁻, I⁻, OH⁻, B(R^{E7})₄⁻, R^{E7}SO₃⁻, R^{E7}COO⁻, BF₄⁻, SbCl₆⁻ or SbF₆⁻. R^{E7} represents an alkyl group, a cycloalkyl group or an aryl group, and these groups each optionally have a substituent. When a plurality of M^{E2} are present, they may be the same or different.

Z^{E2} represents an alkali metal cation or an alkaline earth metal cation. When a plurality of Z^{E2} are present, they may be the same or different.]

nE2 is usually an integer of 1 to 4, preferably 1 or 2.

The aromatic hydrocarbon group or the heterocyclic group represented by Ar^{E2} is preferably a group obtained by removing from a 1,4-phenylene group, a 1,3-phenylene group, a 1,2-phenylene group, a 2,6-naphthalenediyl group, a 1,4-naphthalenediyl group, a 2,7-fluorenediyl group, a 3,6-fluorenediyl group, a 2,7-phenanthrenediyl group or a 2,7-carbazoledilyl group nE2 hydrogen atoms bonding directly to atoms constituting the ring, and optionally has a substituent other than R^{E2}.

The substituent other than R^{E2} which Ar^{E2} optionally has is the same as the substituent other than R^{E1} which Ar^{E1} optionally has.

nE4 is usually an integer of 0 to 10, preferably an integer of 0 to 8, more preferably an integer of 0 to 2.

aE2 is usually an integer of 1 to 10, preferably an integer of 1 to 5, more preferably 1 or 2.

bE2 is usually an integer of 0 to 10, preferably an integer of 0 to 4, more preferably 0 or 1.

mE2 is usually an integer of 1 to 5, preferably 1 or 2, more preferably 0 or 1.

When R^{E5} is -O-R^{E5'}, the group represented by the formula (ES-2) is a group represented by the following formula.

-O-R^{E5'}-{(Q^{E1})_{nE3}-Y^{E1}(ME1)_{aE1}(Z^{E1})_{bE1}}_{mE1}

R^{E5} is preferably a hydrocarbon group or a heterocyclic group, more preferably an aromatic hydrocarbon group or an aromatic heterocyclic ring group, further preferably an aromatic hydrocarbon group.

The substituent which R^{E5} optionally has includes an alkyl group, a cycloalkyl group, an aryl group, a monovalent heterocyclic group and a group represented by the formula (ES-3), and a group represented by the formula (ES-3) is preferable.

Q^{E2} is preferably an alkylene group, an arylene group or an oxygen atom, more preferably an alkylene group or an oxygen atom.

Y^{E2} is preferably -C⁺RE⁶₂, -N⁺R^{E6}₃, -P⁺R^{E6}₃ or S⁺R^{E6}₂, more preferably -N⁺R^{E6}₃. R^{E6} is preferably a hydrogen atom, an alkyl group or an aryl group, more preferably a hydrogen atom or an alkyl group.

M^{E2} is preferably F⁻, Cl⁻, Br⁻, I⁻, B(R^{E7})₄⁻, R^{E7}SO₃⁻, R^{E7}COO⁻, BF₄⁻ or SbF⁶⁻, more preferably Br⁻, I⁻, B(R^{E7}₄⁻, R^{E7}COO⁻ or SbF⁶⁻. An alkyl group is preferable as R^{E7}.

The alkali metal cation represented by Z^{E2} includes, for example, Li⁺, Na⁺, K⁺, Rb⁺, Cs⁺, preferably Li⁺, Na⁺ or K⁺.

The alkaline earth metal cation represented by Z^{E2} includes, for example, Be²⁺, Mg²⁺, Ca²⁺, Sr²⁺, Ba²⁺, preferably Mg²⁺ or ca²⁺.

Z^{E2} is preferably an alkali metal cation.

The group represented by the formula (ES-2) includes, for example, groups represented by the following formulae. 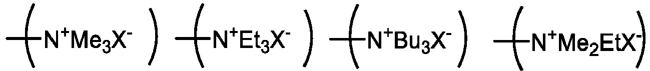 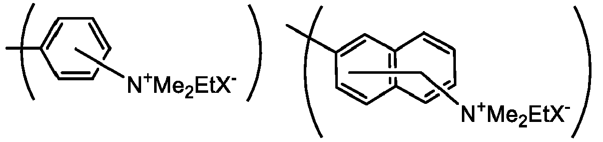 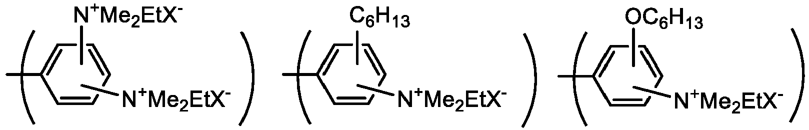 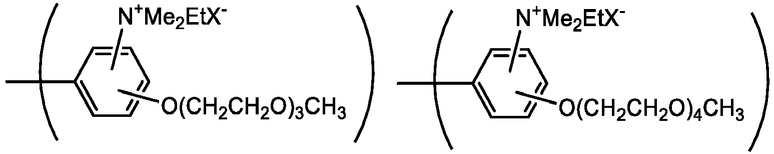 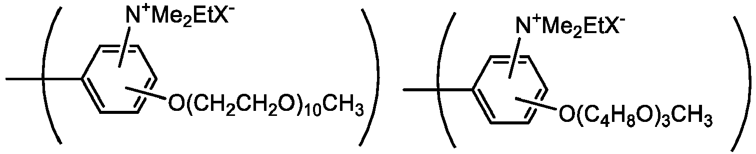 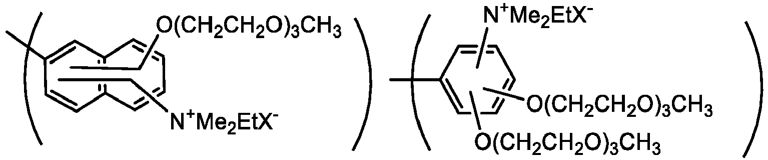 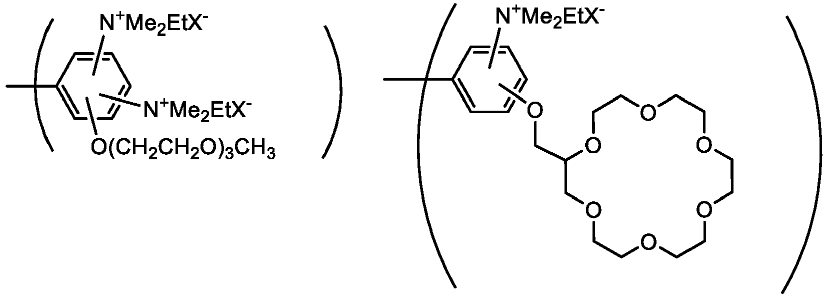 [wherein, X⁻ represents F⁻, Cl⁻ , Br⁻, I⁻, B(C₆H₅)₄⁻, CH₃COO⁻ or CF₃SO₃⁻. When a plurality of X⁻ are present, they may be the same or different.]

The constitutional unit represented by the formula (ET-1) and the formula (ET-2) includes, for example, constitutional units represented by the formula (ET-31) to the formula (ET-34) described below.

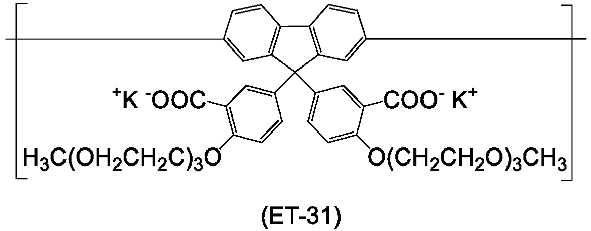

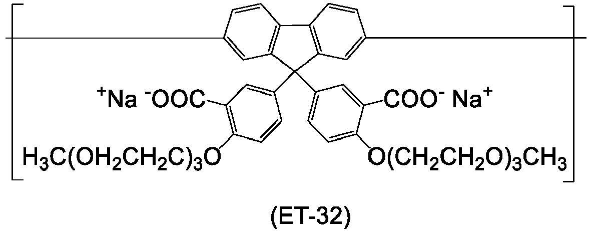

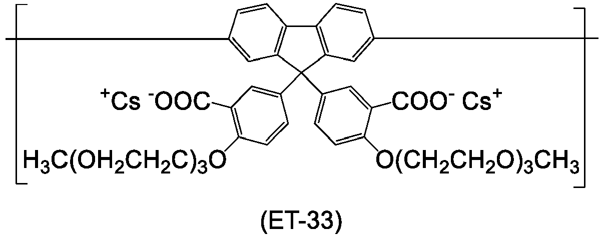

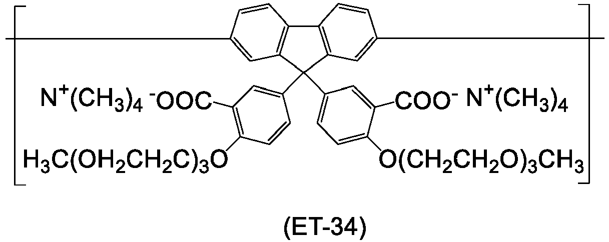

### [Hole injection layer and electron injection layer]

The hole injection layer is usually a layer formed by using a hole injection material. The hole injection material used for formation of the hole injection layer includes, for example, hole injection materials which the composition of the first organic layer may comprise described above.

The electron injection layer is usually a layer formed by using an electron injection material. The electron injection material used for formation of the electron injection layer includes, for example, electron injection materials which the composition of the first organic layer may comprise described above.

### [Charge generating layer]

The charge generating layer is usually a layer formed by using a charge generating material. The charge generating material used for formation of the charge generating layer includes, for example, layers obtained by using a metal oxide such as vanadium oxide, molybdenum oxide and tungsten oxide; layers obtained by using a composition comprising the metal oxide and an aromatic amine compound typified by 1,1-bis[4-[N,N-di(p-tolyl)amino]phenyl]cyclohexane (TAPC), 4,4'-bis[N- (m-tolyl)-N-phenylamino]biphenyl (TPD), N,N'-di(1-naphthyl)-N,N'-diphenylbenzidine (NPB) and the like; and layers obtained by using a composition comprising an aromatic amine compound typified by TAPC, TPD, NPB and the like and an electron-accepting substance typified by fullerene, tetrafluorotetracyanoquinodimethane, tetracyanoethylene and the like.

### [Substrate/electrode]

The substrate in the light emitting device may advantageously be a substrate on which an electrode can be formed and which does not chemically change in forming an organic layer, and is a substrate made of a material such as, for example, glass, plastic and silicon. In the case of an opaque substrate, it is preferable that an electrode most remote from the substrate is transparent or semi-transparent.

The material of the anode includes, for example, electrically conductive metal oxides and semi-transparent metals, preferably, indium oxide, zinc oxide and tin oxide; electrically conductive compounds such as indium·tin·oxide (ITO) and indium·zinc·oxide; a composite of silver, palladium and copper (APC); NESA, gold, platinum, silver and copper.

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

In the light emitting device, at least one of the anode and the cathode is usually transparent or semi-transparent, and it is preferable that the anode is transparent or semi-transparent.

Methods for forming the anode and the cathode include, for example, vacuum vapor deposition method, sputtering method, ion plating method, plating method, lamination method and the like.

### [Production method of light emitting device]

The method of forming a light emitting layer, a second light emitting layer, a hole transporting layer, an electron transporting layer, a hole injection layer, an electron injection layer and a charge generating layer in the light emitting device of the present invention includes, for example, a vacuum vapor deposition method from a powder and a method of film formation from a solution or melted state when a low molecular weight compound is used, and includes, for example, a method of film formation from a solution or melted state when a polymer compound is used.

The light emitting layer, the second light emitting layer, the hole transporting layer, the electron transporting layer, the hole injection layer, the electron injection layer and the charge generating layer can be formed by application methods typified by a spin coat method and an inkjet printing method using inks containing the composition of the first organic layer, the polymer compound of the second organic layer, the light emitting material, the hole transporting material, the electron transporting material, the hole injection material, the electron injection material and the charge generating material described above, respectively.

When the material used for formation of a hole injection layer, the material used for formation of a hole transporting layer, the material used for formation of a light emitting layer, the material used for formation of a second light emitting layer, the material used for formation of an electron transporting layer, the material used for formation of an electron injection layer and the material used for formation of a charge generating layer are dissolvable in a solvent used in forming a layer adjacent to a hole injection layer, a hole transporting layer, a light emitting layer, a second light emitting layer, an electron transporting layer, an electron injection layer and a charge generating layer, respectively, in fabrication of a light emitting device, it is preferable that the materials have a crosslinkable group to avoid dissolution of the materials in the solvent. Each layer is formed using a material having a crosslinkable group, then, the crosslinkable group can be crosslinked to insolubilize the layer.

### [Use of light emitting device]

For obtaining planar light emission by using a light emitting device of the present invention, a planar anode and a planar cathode are disposed so as to overlap with each other. Patterned light emission can be produced by a method of placing a mask with a patterned window on the surface of a planer light emitting device, a method of forming an extremely thick layer intended to be a non-light emitting, thereby having the layer essentially no-light emitting or a method of forming an anode, a cathode or both electrodes in a patterned shape. By forming a pattern with any of these methods and disposing certain electrodes so as to switch ON/OFF independently, a segment type display capable of displaying numbers and letters and the like is provided. For producing a dot matrix display, both an anode and a cathode are formed in a stripe shape and disposed so as to cross with each other. Partial color display and multi-color display are made possible by a method of printing separately certain polymer compounds showing different emission or a method of using a color filter or a fluorescence conversion filter. The dot matrix display can be passively driven, or actively driven combined with TFT and the like. These displays can be used in computers, television sets, portable terminals and the like. The planar light emitting device can be suitably used as a planer light source for backlight of a liquid crystal display or as a planar light source for illumination. If a flexible substrate is used, it can be used also as a curved light source and a curved display.

### EXAMPLES

The present invention will be illustrated further in detail by examples below, but the present invention is not limited to these examples.

In the present examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as described below.

### [Measurement condition]

The polymer compound to be measured was dissolved in THF at a concentration of about 0.05 wt%, and 10 µL of the solution was injected into SEC. As the mobile phase of SEC, tetrahydrofuran was used and allowed to flow at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

Measurement of liquid chromatograph mass spectrometry (LC-MS) was carried out according to the following method.

A measurement sample was dissolved in chloroform or THF so as to give a concentration of about 2 mg/mL, and about 1 µL of the solution was injected into LC-MS (manufactured by Agilent Technologies, trade name: 1100LCMSD). As the mobile phase of LC-MS, acetonitrile and THF were used while changing the ratio thereof and allowed to flow at a flow rate of 0.2 mL/min. As the column, L-column 2 ODS (3 µm) (manufactured by Chemicals Evaluation and Research Institute, internal diameter: 2.1 mm, length: 100 mm, particle size: 3 µm) was used.

Measurement of NMR was carried out according to the following method.

5 to 10 mg of a measurement sample was dissolved in about 0.5 mL of deuterated chloroform (CDCl₃), deuterated tetrahydrofuran (THF-d₈) , deuterated acetone (CD₃- (C=O) -CD₃), deuterated N,N-dimethylformamide (DMF-d₇), deuterated toluene (C₆D₅-CD₃), deuterated methanol (CD₃OD), deuterated ethanol (CD₃CD₂OD), deuterated 2-pronanol (CD₃-CDOD-CD₃) or deuterated methylene chloride (CD₂Cl₂), and measurement was performed using an NMR apparatus (manufactured by Agilent, trade name: INOVA 300 or MERCURY 400VX).

As the index of the purity of a compound, a value of the high performance liquid chromatography (HPLC) area percentage was used. This value is a value in high performance liquid chromatography (HPLC, manufactured by Shimadzu Corp., trade name: LC-20A) at 254 nm, unless otherwise stated. In this operation, the compound to be measured was dissolved in THF or chloroform so as to give a concentration of 0.01 to 0.2 wt%, and depending on the concentration, 1 to 10 µL of the solution was injected into HPLC. As the mobile phase of HPLC, acetonitrile and THF were used and allowed to flow at a flow rate of 1 mL/min as gradient analysis of acetonitrile/THF = 100/0 to 0/100 (volume ratio) . As the column, Kaseisorb LC ODS 2000 (manufactured by Tokyo Chemical Industry Co., Ltd.) or an ODS column having an equivalent performance was used. As the detector, a photo diode array detector (manufactured by Shimadzu Corp., trade name: SPD-M20A) was used.

### <Synthesis Example 1> Synthesis of metal complexes 1, 2 and 3

Metal complexes 1 and, 2 were synthesized according to a method described in JP-A No. 2013-147551.

A metal complex 3 was synthesized according to a method described in International Publication WO2006/121811. Metal complex 3 is not according to the present invention.

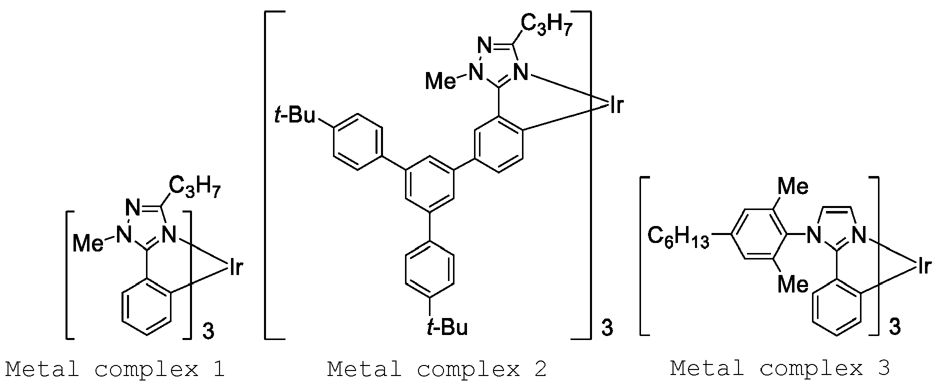

### <Synthesis Example 2> Synthesis of metal complex 4

### <Synthesis Example 2-1> Synthesis of compound S1

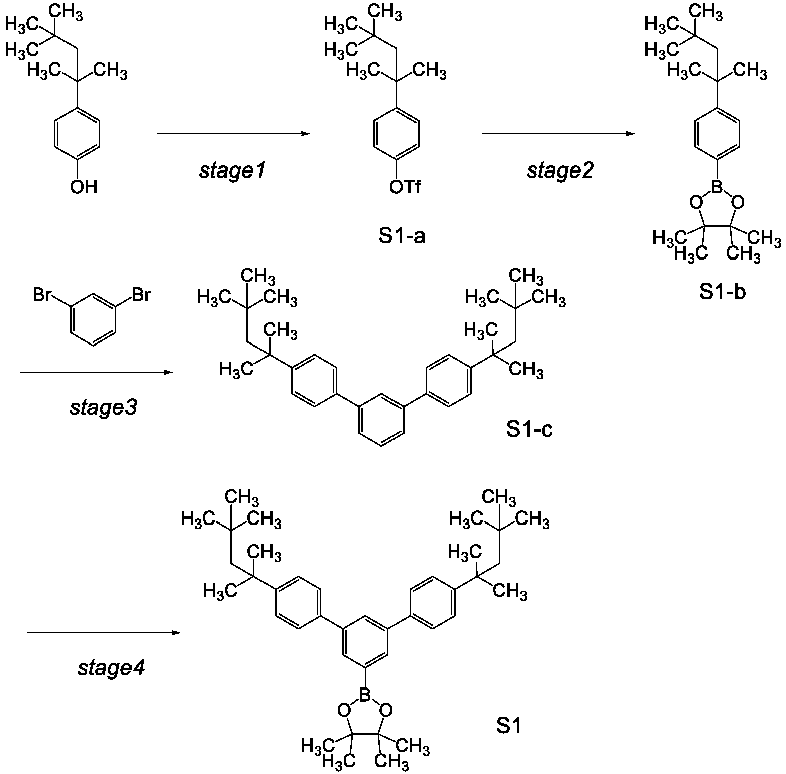

### <Stage 1>

The atmosphere in a reaction vessel was turned into a nitrogen gas stream, then, 4-tert-octylphenol (250.00 g, manufactured by Aldrich), N,N-dimethyl-4-aminopyridine (177.64 g) and dichloromethane (3100 mL) were added, and this mixture was cooled down to 5°C with ice. Thereafter, trifluoromethanesulfonic anhydride (376.06 g) was dropped into this over a period of 45 minutes. After completion of dropping, the mixture was stirred for 30 minutes under ice cool, then, returned to room temperature and further stirred for 1.5 hours. To the resultant reaction mixture was added hexane (3100 mL), and this reaction mixture was filtrated using 410 g of silica gel, and further, the silica gel was washed with a mixed solvent (2.5 L) of hexane/dichloromethane (1/1 (by volume)). The resultant filtrate and the wash solution were concentrated, to obtain a compound S1-a (410.94 g, HPLC purity: 99.7%) as a colorless oil.

### <Stage 2>

The atmosphere in a reaction vessel was turned into a nitrogen gas stream, then, the compound S1-a (410.94 g), bis(pinacolato)diboron (338.47 g), potassium acetate (237.83 g), 1,4-dioxane (2600 mL), palladium acetate (4.08 g) and tricyclohexylphosphine (10.19 g) were added, and the mixture was refluxed for 2 hours. After cooling down to room temperature, the resultant reaction mixture was filtrated and the filtrate was collected, and further, the filtrated substance was washed with 1, 4-dioxane (2.5 L), and the resultant filtrate and the wash solution were concentrated. The resultant residue was dissolved into a mixed solvent of hexane/dichloromethane (1/1 (by volume)), and the solution was filtrated using 770 g silica gel, and further, the silica gel was washed with a mixed solvent (2.5 L) of hexane/dichloromethane (1/1 (by volume)). The resultant filtrate and the wash solution were concentrated, and to the resultant residue was added methanol (1500 mL), and the mixture was ultrasonically cleaned for 30 minutes. Thereafter, this was filtrated to obtain a compound Sl-b (274.27 g). The filtrate and the wash solution were concentrated, and methanol was added, and the mixture was ultrasonically cleaned and filtrated, and such an operation was repeated, to obtain a compound Sl-b (14.29 g). The total yielded amount of the resultant compound Sl-b was 288.56 g.

### <Stage 3>

The atmosphere in a reaction vessel was turned into a nitrogen gas stream, then, 1,3-dibromobenzene (102.48 g), the compound Sl-b (288.56 g), toluene (2100 mL), a 20 wt% tetraethyl ammonium hydroxide aqueous solution (962.38 g) and bis(triphenylphosphine)palladium(II) dichloride (3.04 g) were added, and the mixture was refluxed for 7 hours. After cooling down to room temperature, the aqueous layer and the organic layer were separated, and the organic layer was collected. To this aqueous layer was added toluene (1 L), and the organic layer was further extracted. The resultant organic layers were combined, and this mixture was washed with a mixed aqueous solution of distilled water/saturated saline (1.5 L/1.5 L). The resultant organic layer was filtrated through 400 g silica gel, and further, the silica gel was washed with toluene (2 L) . The resultant solution was concentrated, and the resultant residue was dissolved in hexane. This solution was purified by silica gel column chromatography. Impurities were eluted with a developing solvent hexane, then, developed with a mixed solvent of hexane/dichloromethane (10/1 (by volume)). The each resultant fraction was concentrated under reduced pressure to remove the solvent, obtaining a colorless crystalline compound Sl-c (154.08 g, HPLC purity: 99.1%) and a coarse compound Sl-c (38.64 g, HPLC purity: 83%). This coarse compound Sl-c was column-purified again under the same developing conditions, and the solvent was distilled off under reduced pressure, to obtain a compound Sl-c (28.4 g, HPLC purity: 99.6%). The total yielded amount the resultant compound Sl-c was 182.48 g.

### <Stage 4>

The atmosphere in a reaction vessel was turned into a nitrogen gas stream, then, the compound Sl-c (182, 48 g), bis(pinacolato)diboron (112.09 g), 4,4'-di-tert-butyl-2,2'-dipyridyl (3.23 g), cyclohexane (2000 mL) and bis(1,5-cyclooctadiene)di-µ-methoxydiiridium(I) (3.99 g) were added, and the mixture was refluxed for 2 hours. After cooling with air down to room temperature, silica gel (220 g) was added over a period of 20 minutes while stirring the resultant reaction mixture. The resultant suspension was filtrated through 440 g of silica gel, and further, the silica gel was washed with dichloromethane (2 L), and the solution was concentrated. To the resultant residue were added methanol (1100 mL) and dichloromethane (110 mL), and the mixture was refluxed for 1 hour. After cooling down to room temperature, this was filtrated. The resultant filtrated substance was washed with methanol (500 mL), and the resultant solid was dried, to obtain a compound S1 (220.85 g).
¹H-NMR (CDCl₃, 300 MHz): δ (ppm) = 8.00 (s, 2H), 7.92 (s, 1H), 7.60 (d, J = 8.5Hz, 4H), 7.44 (d, J = 8.5Hz, 4H), 1.78 (s, 4H), 1.41 (s, 12H), 1.37 (s, 12H), 0.75 (s, 18H).

### <Synthesis Example 2-2> Synthesis of compound S2

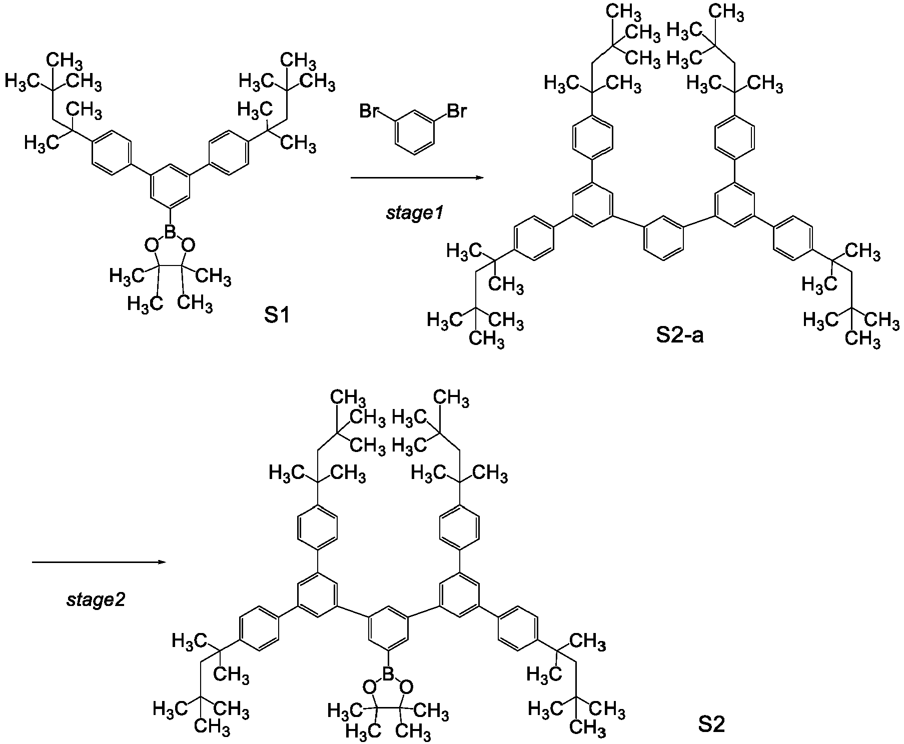

### <Stage 1>

The atmosphere in a reaction vessel was turned into a nitrogen gas stream, then, the compound S1 (91.49 g), m-dibromobenzene (17.70 g) and toluene (478 mL) were added, and the mixture was bubbled with a nitrogen gas for 20 minutes. Thereafter, to this were added a 20 wt% tetraethyl ammonium hydroxide aqueous solution (166 mL) and bis(triphenylphosphine)palladium(II) dichloride (0.26 g), and the mixture was refluxed for 6.5 hours. After cooling down to room temperature, the organic layer was separated from the resultant reaction solution, and this organic layer was washed with water (300 mL) and saturated saline (300 mL) in this order. The resultant organic layer was dried over sodium sulfate, then, the solvent was distilled off under reduced pressure. The resultant residue was dissolved into a mixed solvent of hexane/chloroform (20/1 (by volume)), and the solution was purified by silica gel column chromatography, and concentrated under reduced pressure, to remove the solvent. To the resultant residue were added methanol (845 mL) and chloroform (56 mL), and the mixture was refluxed for 30 minutes. The resultant solution was cooled to obtain a precipitate which was then filtrated and dried, to obtain a compound S2-a (74.40 g).

### <Stage 2>

The atmosphere in a reaction vessel was turned into a nitrogen gas stream, then, the compound S2-a (74.40 g), bis(pinacolato)diboron (21.13 g), 4,4'-di-tert-butyl-2,2'-dipyridyl (609 mg), cyclohexane (734 mL) and bis(1,5-cyclooctadiene)di-p-methoxydiiridium(I) (752 mg) were added, and the mixture was refluxed for 8 hours. After cooling with air down to room temperature, then, to the resultant reaction solution was added silica gel (83.93 g), and it was purified by silica gel column chromatography (developing solvent: a mixed solvent of dichloromethane/acetonitrile (100/1 (by volume))). Thereafter, the solvent was distilled off under reduced pressure, and the resultant residue was dissolved in toluene (420 mL), and this solution was heated at 50°C. Thereafter, acetonitrile (839 mL) was dropped into this, and the deposited solid was filtrated. The resultant solid was refluxed in a mixed solvent of hexane/acetonitrile (1/1 (by volume)) for 30 minutes, then, cooled down to room temperature and the precipitate was collected by filtration, and dried, to obtain a compound S2 (68.53 g).
¹H-NMR (CDCl₃, 300 MHz) : δ (ppm) = 8.14 (d, J = 1.8Hz, 2H), 8.09 (m, 1H), 7.85 (d, J = 1.6Hz, 4H), 7.82 (m, 2H), 7.64 (d, J = 8.5Hz, 8H), 7.48 (d, J = 8.5Hz, 8H), 1.79 (s, 8H), 1.42 (s, 24H), 1.39 (s, 12H), 0.77 (s, 36H).

### (Synthesis Example 2-3) Synthesis of compound IL1

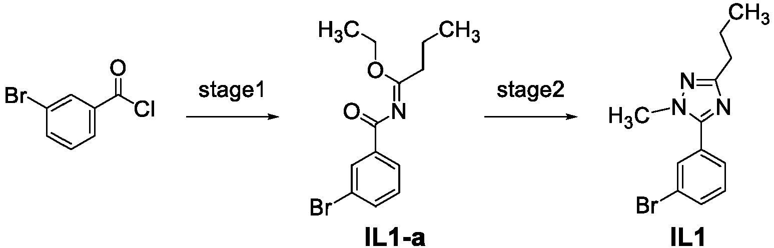

### <Stage 1>

An inert gas atmosphere was prepared in a reaction vessel, then, 3-bromobenzoyl chloride (117 g), ethyl butylimidate hydrochloride (81 g) and chloroform (3732 ml) were added, and they were mixed by stirring at room temperature, and triethylamine (113 g) was dropped at room temperature over a period of 2 hours, and further, the mixture was stirred at room temperature for 2 hours, to obtain a reaction liquid. The resultant reaction liquid was concentrated under reduced pressure, then, the reaction product was extracted into an organic layer using water (700 ml) and chloroform (1000 ml), and the resultant organic layer was washed with water (700 ml) and saturated saline (700 ml) in series, then, dried over anhydrous magnesium sulfate. Thereafter, the inorganic salt was removed by filtration, and the resultant filtrate was concentrated, to obtain a mixture (197.57 g) containing a compound IL1-a as a yellow oil. The purity by HPLC was 98.24%.

### <Stage 2>

An inert gas atmosphere was prepared in a reaction vessel, then, a mixture (197.57 g) containing a compound IL1-a, and chloroform (2666 ml) were added, and they were mixed by stirring at room temperature, and a solution prepared by adding methylhydrazine (21.61 g) to water (21.61 g) was dropped slowly while keeping the temperature of the reaction liquid around room temperature, then, the mixture was stirred for 2 hours at room temperature, to obtain a reaction liquid. The resultant reaction liquid was washed with water (1000 ml) twice, then, the resultant organic layer was dried over anhydrous magnesium sulfate. The inorganic salt was removed by filtration, and further, the solvent was removed by concentration under reduced pressure, to obtain a mixture (171 g) containing a compound IL1. An operation of purifying the resultant mixture by silica gel column chromatography (developing solvent; a mixed solvent of dichloromethane/ethyl acetate) was repeated twice, to obtain 92.9 g of a compound IL1 (HPLC area percentage value: 98.91%, yield based on bromobenzoyl chloride: 62.2%) as a yellow oil.
¹H-NMR (300 MHz, CDCl₃) δ (ppm) = 1.01 (t, 9Hz, 3H), 1.65-1.85 (m, 2H), 2.71 (t, 6Hz, 2H), 3.93 (s, 3H), 7.30-7.45 (m, 1H), 7.55-7.65 (m, 2H), 7.84 (s, 1H).

### (Synthesis Example 2-4) Synthesis of metal complex IM1

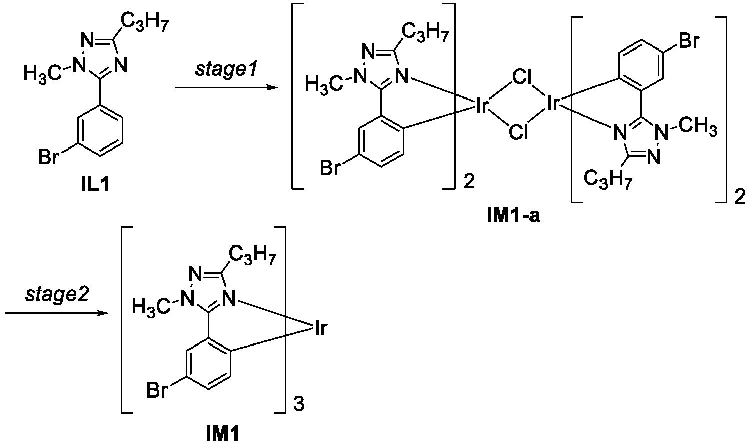

### <Stage 1>

A nitrogen gas atmosphere was prepared in a reaction vessel, then, iridium chloride trihydrate (20 g) and a compound IL1 (39.73 g) were added, and further, ethoxyethanol (794 ml) previously bubbled with an argon gas and water (265 ml) previously bubbled with an argon gas were added, and further, the mixture was bubbled with an argon gas for 20 minutes while stirring, to remove dissolved oxygen. Thereafter, the mixture was stirred under reflux for 22 hours while heating by using an oil bath of 125°C, to obtain a reaction liquid. The resultant reaction liquid was cooled down to room temperature, then, water (794 g) was added, and the mixture was stirred vigorously, and the deposited precipitate was isolated as a solid by filtration, and the resultant solid was washed with water (300 ml) and hexane (300 ml) in this order, and dried under reduced pressure at 50°C, to obtain an intended coarse compound IM1-a (40.61 g) as a yellow powder. The purity by HPLC was 98.24%.

### <Stage 2>

A nitrogen gas atmosphere was prepared in a reaction vessel, then, a coarse compound IM1-a (40.61 g), a compound IL1 (95.34 g) synthesized by the same method as described above, diethylene glycol dimethyl ether (567 ml) and silver trifluoroacetate (29.15 g) were added, and further, the mixture was bubbled with a nitrogen gas for 20 minutes while stirring, to remove dissolved oxygen. Thereafter, this was stirred for 22 hours while heating by using an oil bath of 170°C, to obtain a reaction liquid. The resultant reaction liquid was cooled, then, a solid was removed by filtration, to the resultant filtrate was added water (567 g) and the mixture was stirred, and the deposited precipitate was isolated as a solid by filtration. The resultant solid was washed with water (200 ml) once, and further washed with methanol (200 ml) twice, and dried under reduced pressure, to obtain a yellow solid (64.59 g, purity: 96.23%). The resultant yellow solid was dissolved in dichloromethane, and the solution was allowed to pass through a silica gel column (silica gel amount: 292 g), and the resultant solution was concentrated, to obtain a mixture containing an intended substance (58.72 g, purity: 96.25%) as a yellow solid. The resultant mixture was purified by recrystallization (a mixed solvent of dichloromethane/methanol), and further purified by recrystallization (a mixed solvent of dichloromethane/ethyl acetate), to obtain a metal complex IM1 (48.66 g). To the resultant coarse metal complex IM1 was added ethyl acetate (487 ml), and the mixture was stirred under reflux with heating, then, methanol (487 ml) was dropped, the mixture was cooled down to room temperature to cause generation of a crystal which was then isolated by filtration, and this was washed with methanol and dried under reduced pressure, to obtain an intended metal complex IM1 (48.03 g, purity: 99.36%).
LC-MS (APPI: pos) : calcd. [C₃₆H₃₉BrsIrN₉] = 1027.05, measured = 1028.1 (m+H)

### (Synthesis Example 2-5) Synthesis of metal complex 4

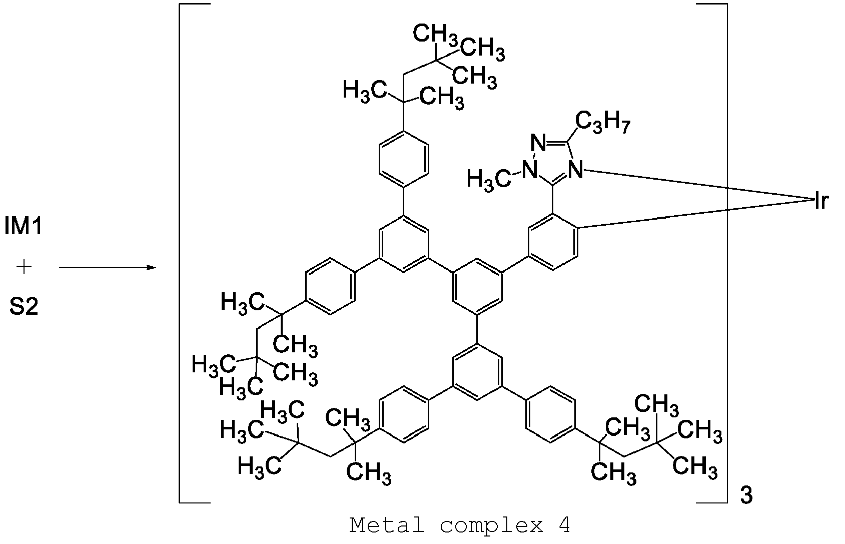

A nitrogen gas flow was prepared in a reaction vessel, then, a metal complex IM1 (2.50 g) and a compound S2 (8.89 g) were added, and this was dissolved in tetrahydrofuran (200 ml) at room temperature. Thereafter, to this were added a 20 wt% tetraethylammonium hydroxide aqueous solution (12.51 g) and tetrakis(triphenylphosphine)palladium(0) (56.1 mg), and the mixture was refluxed for 23 hours while shading. After cooling to room temperature, the resultant reaction mixture was poured into distilled water (200 ml), and extracted with toluene (150 ml). The resultant organic layer was washed with distilled water (200 ml) and saturated saline (350 ml) in this order. The resultant organic layer was dried over sodium sulfate, then, filtrated, and the filtrate was concentrated. The resultant residue was purified by silica gel column chromatography (a mixed solvent of hexane/ethyl acetate = 10/1 (by volume)), and concentrated under reduced pressure, to remove the solvent. To the resultant residue were added toluene (115 ml) and acetonitrile (655 ml), and the mixture was heated at 50°C for 1 hour while shading. Thereafter, this was filtrated, and dried under reduced pressure, to obtain a metal complex 4 (7.07 g) represented by the above-described formula.
¹H-NMR (CD₂Cl₂, 300 MHz) δ (ppm) = 8.00 (m, 9H), 7.95-7.93 (m, 15H), 7.87 (s, 6H), 7.67 (d, 24H), 7.47 (d, 24H), 7.31 (d, 3H), 6.97 (d, 3H), 4.29 (s, 9H), 2.31-2.21 (m, 3H), 2.02-1.92 (m, 3H), 1.77 (s, 24H), 1.51-1.19 (m, 78H), 0.78-0.71 (m, 117H) .

### <Synthesis Example 3> Synthesis of metal complex 5

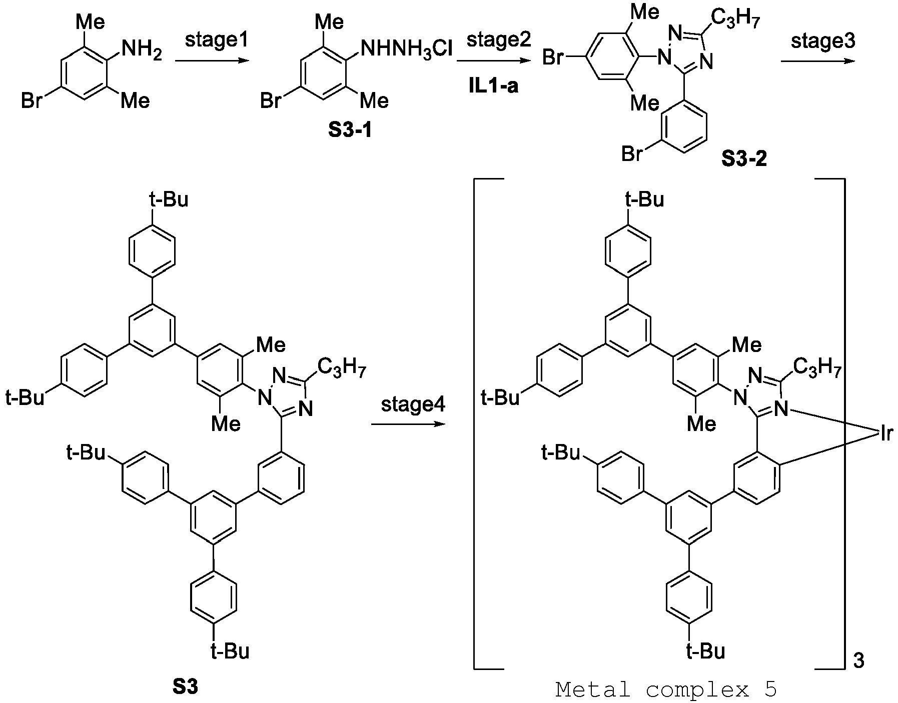

### <Stage 1>

In a reaction vessel, sodium nitrite (1.38 g) was weighed and dissolved in 11 mL of water of 0°C under a nitrogen gas atmosphere. Thereafter, 4-bromo-2,6-dimethylaniline (4.0 g) was suspended in 33 mL of concentrated hydrochloric acid, and the suspension was dropped into a nitrous acid aqueous solution so as not to exceed 5°C. Thereafter, the mixture was stirred at 0°C for 15 minutes, and 15 mL of a concentrated hydrochloric acid solution of tin(II) chloride (5.31 g) was added to the resultant reaction liquid, and the mixture was returned to room temperature and stirred for 6 hours. The resultant suspension was filtrated with suction, and washed with concentrated hydrochloric acid and cold water, and dried in a vacuum, to obtain 4.98 g of a compound S3-1 as a milky white solid.

### <Stage 2>

In a reaction vessel, a compound S3-1 (1.26 g), a compound IL1-a (1.19 g) and sodium acetate (410 mg) were weighed, and each 8 mL of acetic acid and dioxane were added, then, the mixture was placed under a nitrogen gas atmosphere. The resultant reaction mixture was heated at 90°C for 15 hours, then, left to cool. Thereafter, toluene was added to this before filtration with suction, and the filtrate was concentrated. The resultant coarse product was allowed to pass through a silica gel column, and separated and purified using a mixed solvent of hexane and ethyl acetate, to obtain 1.0 g of a compound S3-2 as a pale yellow liquid (yield: 56%). The results of ¹H-NMR analysis are shown below.
¹H-NMR (400 MHz/(CD₃)₂CO) δ (ppm) = 7.60 (dt, 1H), 7.49 (s, 2H), 7.34-7.27 (m, 3H), 2.74 (t, 2H), 1.95 (s, 6H), 1.83 (q, 2H), 0.99 (t, 3H).

### <Stage 3>

In a reaction vessel, a compound S3-2 (990 mg), 3,5-di(4-tert-butylphenyl)phenylboronic acid pinacol ester (2.2 g) and sodium carbonate 1.4 g (13 mmol) were weighed, and 5 mL of water and 15 mL of dioxane were added, then, the mixture was refluxed with heating for 6 hours under a nitrogen gas atmosphere. After left to cool, toluene was added to this and the solution was filtrated with suction, and the filtrate was concentrated. Thereafter, water and toluene were added and water-washing was performed, and the resultant oil layer was recovered, then, concentrated. The resultant coarse product was allowed to pass through a silica gel column and separated and purified using a mixed solvent of chloroform and ethyl acetate. The resultant eluent was concentrated, and recrystallized from hexane, to obtain 2.0 g of a compound S3 as a white solid (yield: 94%). The results of ¹H-NMR analysis are shown below.
¹H-NMR (400 MHz, CDCl₃) δ (ppm) = 7.97 (s, 1H), 7.82 (s, 1H), 7.75-7.70 (m, 4H), 7.62-7.54 (m, 11H), 7.49-7.46 (m, 6H), 7.42 (d, 1H), 7.37 (d, 4H), 2.88 (t, 2H), 2.10 (s, 6H), 1.92 (td, 2H), 1.37 (s, 18H), 1.31 (s, 18H), 1.06 (t, 3H).

### <Stage 4>

In a reaction vessel, iridium chloride (91 mg) and a compound S3 (500 mg) were weighed, and 10 mL of water and 10 mL of 2-butoxyethanol were added, then, the mixture was refluxed with heating for 18 hours under an argon gas atmosphere. After left to cool, water and methanol were poured into this, and the deposited precipitate was filtrated with suction. The resultant filtrated material was dried, to obtain 500 mg of a yellowish brown solid.

In another reaction vessel, 500 mg of this brown solid, a compound S3 (1.23 g) and 67 mg of silver trifluoromethanesulfonate were weighed, and 10 mL of diethylene glycol dimethyl ester was added, then, the mixture was refluxed with heating for 11 hours under an argon gas atmosphere. After left to cool, toluene was poured into this, and the solution was filtrated with suction. The resultant filtrate was concentrated before passing through a silica gel column, and separated and purified using a mixed solvent of toluene and hexane. The resultant eluent was concentrated, and recrystallized from a mixed solvent of toluene and hexane, to obtain 420 mg of a metal complex 5 (yield: 52%) as a powdery yellow solid. The results of ¹H-NMR analysis are shown below.
¹H-NMR (400 MHz, CDCl₃) δ (ppm) = 7.85-7.82 (m, 9H), 7.64 (s, 3H), 7.70 (s, 3H), 7.58-7.52 (m, 15H), 7.39-7.46 (m, 30H), 7.23-7.13 (m, 18H), 6.82 (d, 3H), 2.55 (m, 6H), 2.41 (s, 9H), 2.05 (s, 9H), 1.86-1.73 (m, 6H), 1.36 (s, 54H), 1.19 (s, 54H), 0.88 (t, 9H).

### <Synthesis Example 4> Synthesis of metal complexes 6 and 7

A metal complex 6 was synthesized according to a method described in Synthesis Example 3 described above.

A metal complex 7 was synthesized according to a method described in JP-A No. 2012-6914.

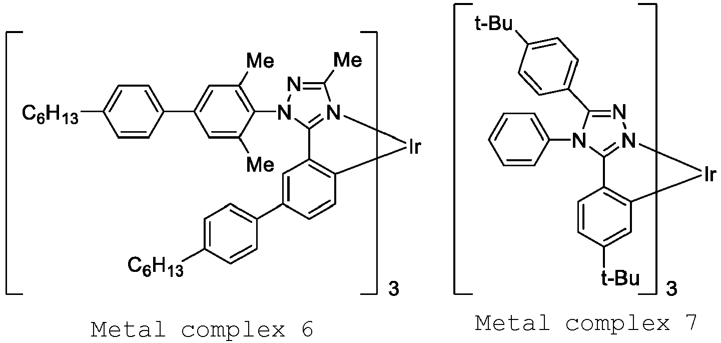

### <Synthesis Example 5> Synthesis of polymer compound HTL-1

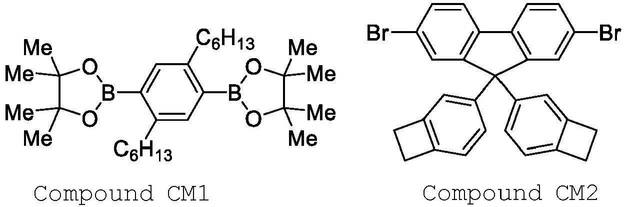

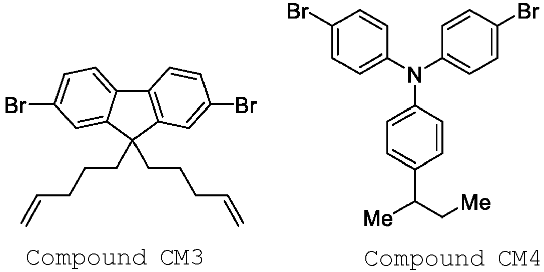

(Step 1) An inert gas atmosphere was prepared in a reaction vessel, then, a compound CM1 (0.995 g) synthesized according to a method described in JP-A No. 2010-189630, a compound CM2 (0.106 g) synthesized according to a method described in JP-A No. 2008-106241, a compound CM3 (0.0924 g) synthesized according to a method described in JP-A No. 2010-215886, a compound CM4 (0.736 g) synthesized according to a method described in International Publication WO2002/045184, dichlorobis[tris(2-methoxyphenyl)phosphine]palladium (1.8 mg) and toluene (50 ml) were added, and the mixture was heated at 105°C.

(Step 2) Into the resultant reaction liquid, a 20 wt% tetraethylammonium hydroxide aqueous solution (6.6 ml) was dropped, and the mixture was refluxed for 5.5 hours.

(Step 3) Thereafter, to this were added phenylboronic acid (24.4 mg), a 20 wt% tetraethylammonium hydroxide aqueous solution (6.6 ml) and dichlorobis[tris(2-methoxyphenyl)phosphine]palladium (1.8 mg), and the mixture was refluxed for 14 hours.

(Step 4) Thereafter, to this was added a sodium diethyldithiacarbamate aqueous solution, and the mixture was stirred at 80°C for 2 hours. The resultant reaction liquid was cooled, then, washed with water twice, with a 3 wt% acetic acid aqueous solution twice and with water twice, and the resultant solution was dropped into methanol, to cause precipitation. The resultant precipitate was dissolved in toluene, and the solution was allowed to pass through an alumina column and a silica gel column in this order to accomplish purification. The resultant solution was dropped into methanol, and the mixture was stirred, to cause precipitation. The resultant precipitate was isolated by filtration, and dried, to obtain 0.91 g of a polymer compound HTL-1. The polymer compound HTL-1 had a Mn of 5.2×10⁴ and a Mw of 2.5×10⁵.

The polymer compound HTL-1 is a copolymer constituted of a constitutional unit derived from a compound CM1, a constitutional unit derived from a compound CM2, a constitutional unit derived from a compound CM3 and a constitutional unit derived from a compound CM4 at a molar ratio of 50:5:5:40, according to theoretical values calculated from the amounts of charged raw materials.

### <Synthesis Example 6> Synthesis of polymer compound HTL-2

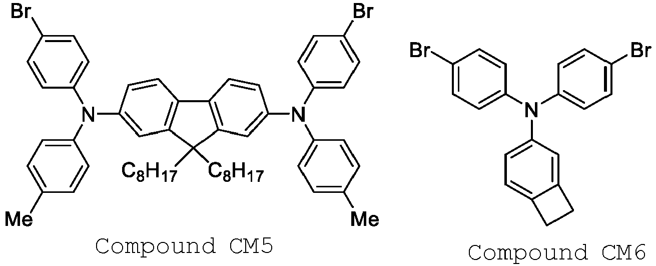

A nitrogen gas atmosphere was prepared in a reaction vessel, then, a compound CM1 (1.73 g), a compound CM5 (2.68 g) synthesized according to a method described in International Publication WO2005/049546, a compound CM6 (0.223 g) synthesized according to a method described in International Publication WO2011/049241 and toluene (73 ml) were added, and the mixture was heated at about 80°C. Thereafter, to this were added palladium acetate (0.77 mg), tris(2-methoxyphenyl)phosphine (4.90 mg) and a 20 wt% tetraethylammonium hydroxide aqueous solution (12.3 g), and the mixture was stirred for about 4 hours under reflux. Thereafter, to this were added phenylboronic acid (85.6 mg), palladium acetate (0.72 mg), tris(2-methoxyphenyl)phosphine (4.89 mg) and a 20 wt% tetraethylammonium hydroxide aqueous solution (12.3 g), and the mixture was further stirred for about 19.5 hours under reflux. Thereafter, to this was added a solution prepared by dissolving sodium N,N-diethyldithiocarbamate trihydrate (0.98 g) in ion exchanged water (20 ml), and the mixture was stirred for 2 hours while heating at 85°C. Thereafter, the organic layer was washed with 3.6 wt% hydrochloric acid twice, with 2.5 wt% ammonia water twice and with ion exchanged water five times, in series. The resultant organic layer was dropped into methanol to cause precipitation, and the precipitate was isolated by filtration, and dried, to obtain a solid. The resultant solid was dissolved in toluene, and the solution was allowed to pass through a silica gel column and an alumina column through which toluene had passed previously. The resultant solution was dropped into methanol to cause precipitation, and the filtrate was isolated by filtration, and dried, to obtain a polymer compound HTL-2 (2.907 g). The polystyrene-equivalent number-average molecular weight (Mn) and weight-average molecular weight (Mw) of the polymer compound HTL-2 were Mn = 1.9×10⁴ and Mw = 9.9×10⁴.

The polymer compound HTL-2 is a copolymer constituted of a constitutional unit derived from a compound CM1, a constitutional unit derived from a compound CM5 and a constitutional unit derived from a compound CM6 at a molar ratio of 50:42.5:7.5, according to theoretical values calculated from the charging amounts of monomers.

### <Synthesis Example 7> Synthesis of polymer compound HTL-3

### <Synthesis Example 7-1> Synthesis of compound Ma3

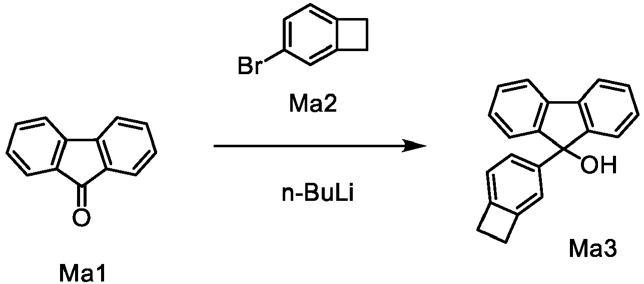

A gas in a flask equipped with a stirrer was purged with a nitrogen gas, then, a compound Ma2 (64.6 g) and tetrahydro furan (615 mL) were added, and the mixture was cooled down t o -70°C. Into this, a n-butyllithium hexane solution (1.6 M , 218 mL) was dropped over a period of 1 hour, then, the mixt ure was stirred at -70°C for 2 hours. To this, a compound Ma 1 (42.1 g) was added in several batches, then, the mixture w as stirred at -70°C for 2 hours. Into this, methanol (40 mL) was dropped over a period of 1 hour, then, the mixture was h eated up to room temperature. Thereafter, the solvent was d istilled off by concentrating under reduced pressure, and to luene and water were added. Thereafter, an aqueous layer wa s separated and the resultant organic layer was further wash ed with water. The resultant organic layer was concentrated under reduced pressure, and the resultant residue was purif ied by using a silica gel column (developing solvent: a mixe d solvent of hexane and ethyl acetate), thereby obtaining 71 g of a compound Ma3 as a colorless oil. The compound Ma3 ha d an HPLC area percentage value (UV: 254 nm) of 97.5%. This operation was repeated, thereby obtaining a necessary amount of the compound Ma3.
¹H-NMR (CDCl₃, 300 MHz) : δ (ppm) : 2.43 (1H, s), 3.07-3.13 (4H, m), 6.95 (1H, d),7.07 (1H. s), 7.18-7.28 (3H, m), 7.28-7.40 (4H, m), 7.66 (2H, s).

### <Synthesis Example 7-2> Synthesis of compound Ma4

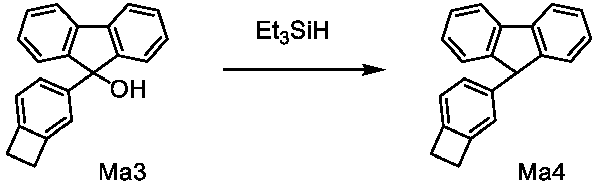

A gas in a flask equipped with a stirrer was purged with a nitrogen gas, then, the compound Ma3 (72.3 g), toluene (72 3 mL) and triethylsilane (118.0 g) were added, and the mixtu re was heated up to 70°C. Into this, methanesulfonic acid ( 97.7 g) was dropped over a period of 1.5 hours, then, the mix ture was stirred at 70°C for 0.5 hours. Thereafter, the mix ture was cooled down to room temperature, and toluene (1 L) and water (1 L) were added, then, an aqueous layer was separ ated. The resultant organic layer was washed with water, a 5 wt% sodium hydrogen carbonate aqueous solution and water i n this order. The resultant organic layer was concentrated under reduced pressure, and the resultant coarse product was recrystallized from a mixed solvent of toluene and ethanol, thereby obtaining 51.8 g of a compound Ma4 as a white solid.

The compound Ma4 had an HPLC area percentage value (UV: 254 nm) of 99.5% or more. This operation was repeated, thereby obtaining a necessary amount of the compound Ma4.
¹H-NMR (CDCl₃, 300 MHz): δ (ppm) : 3.03-3.14 (4H, m), 4.99 (1H, s), 6.68 (1H, s), 6.92-7.01 (2H, m), 7.20-7.28 (2H, m), 7.29-7.38 (4H, m), 7.78 (2H, d).

### <Synthesis Example 7-3> Synthesis of compound Mb3

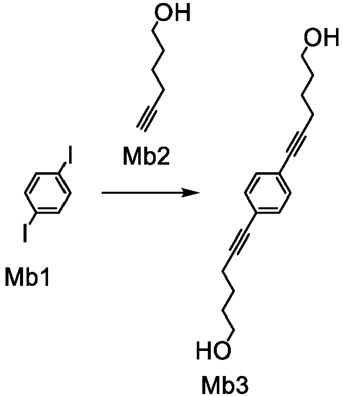

A gas in a flask equipped with a stirrer was purged with a nitrogen gas, then, a compound Mb1 (185.0 g), a compound M b2 (121.1 g), CuI (3.2 g), dichloromethane (185 mL) and trie thylamine (2.59 L) were added, and the mixture was heated up to the reflux temperature. Thereafter, the mixture was sti rred at the reflux temperature for 0.5 hours, and cooled dow n to room temperature. To this was added dichloromethane (1 .85 L), then, the mixture was filtrated through a filter pav ed with celite. To the resultant filtrate was added a 10 wt% sodium hydrogen carbonate aqueous solution, then, an aqueou s layer was separated. The resultant organic layer was wash ed with water twice, washed with a saturated NaCl aqueous so lution, then, magnesium sulfate was added. The resultant mi xture was filtrated, and the resultant filtrate was concentr ated under reduced pressure. The resultant residue was puri fied by using a silica gel column (developing solvent: a mix ed solvent of chloroform and ethyl acetate), thereby obtaini ng a coarse product. The resultant coarse product was disso lved in ethanol (1.4 L), then, activated carbon (5 g) was ad ded, and the mixture was filtrated. The resultant filtrate was concentrated under reduced pressure, and the resultant r esidue was recrystallized from hexane, thereby obtaining 99. 0 g of a compound Mb3 as a white solid. The compound Mb3 had an HPLC area percentage value (UV: 254 nm) of 99.5% or more. This operation was repeated, thereby obtaining a necessary amount of the compound Mb3.
¹H-NMR (DMSO-d₆, 300 MHz): δ (ppm) : 1.52-1.55 (8H, m), 2.42 (4H, t), 3.38-3.44 (4H, m), 4.39-4.43 (2H, m), 7.31 (4H, s).

### <Synthesis Example 7-4> Synthesis of compound Mb4

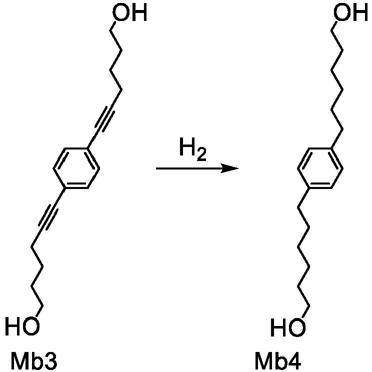

A gas in a flask equipped with a stirrer was purged with a nitrogen gas, then, the compound Mb3 (110.0 g), ethanol (1 .65 L) and palladium/carbon (Pd weight: 10%) (11.0 g) were a dded, and the mixture was heated up to 30°C. Thereafter, a g as in the flask was purged with a hydrogen gas. Thereafter, the mixture was stirred at 30°C for 3 hours while feeding a h ydrogen gas into the flask. Thereafter, a gas in the flask w as purged with a nitrogen gas. The resultant mixture was fi ltrated, and the resultant filtrate was concentrated under r educed pressure. The resultant residue was purified by usin g a silica gel column (developing solvent: a mixed solvent o f chloroform and ethyl acetate), thereby obtaining a coarse product. The resultant coarse product was recrystallized fr om hexane, thereby obtaining 93.4 g of a compound Mb4 as a wh ite solid. The compound Mb4 had an HPLC area percentage val ue (UV: 254 nm) of 98.3%.
¹H-NMR (CDCl₃, 300 MHz): δ (ppm): 1.30-1.40 (8H, m), 1.5 5-1.65 (8H, m), 2.58 (4H, t), 3.64 (4H, t), 7.09 (4H, s).
¹³C-NMR (CDCl₃, 75 MHz): δ (ppm): 25.53, 28.99, 31.39, 32.62, 35.37, 62.90, 128.18, 139.85.

### <Synthesis Example 7-5> Synthesis of compound Mb5

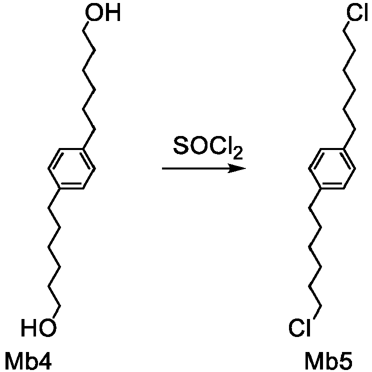

A gas in a flask equipped with a stirrer was purged with a nitrogen gas, then, the compound Mb4 (61.0 g), pyridine (0 .9 g) and toluene (732 mL) were added, and the mixture was he ated up to 60°C. Into this, thionyl chloride (91.4 g) was dr opped over a period of 1.5 hours, then, the mixture was stir red at 60°C for 5 hours. The resultant mixture was cooled do wn to room temperature, then, concentrated under reduced pre ssure. The resultant residue was purified by using a silica gel column (developing solvent: a mixed solvent of hexane a nd ethyl acetate), thereby obtaining 64.3 g of a compound Mb 5 as a colorless oil. The resultant compound Mb5 had an HPLC area percentage value (UV: 254 nm) of 97.2%.
¹H-NMR (CDCl₃, 300 MHz): δ (ppm): 1.35-1.40 (4H, m), 1.41-1.50 (4H, m), 1.60-1.68 (4H, m), 1.75-1.82 (4H, m), 2.60 (4H, t), 3.55 (4H, t), 7.11 (4H, s).

### <Synthesis Example 7-6> Synthesis of compound Mb6

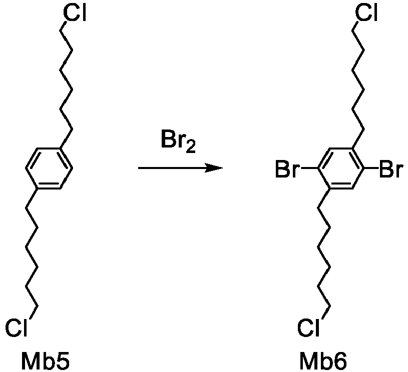

A gas in a flask equipped with a stirrer was purged with a nitrogen gas, then, the compound Mb5 (42.0 g), an iron pow der (1.7 g), iodine (0.3 g) and dichloromethane (800 mL) wer e added. Thereafter, the whole flask was light-shielded, an d cooled at 0 to 5°C. Into this, a mixed liquid of bromine ( 44.7 g) and dichloromethane (200 mL) was dropped over a peri od of 1 hour, then, the mixture was stirred at 0 to 5°C overn ight. The resultant mixed liquid was added to water (1.2 L) cooled at 0 to 5°C, then, an organic layer was separated. Th e resultant organic layer was washed with a 10 wt% sodium th iosulfate aqueous solution, and further, washed with a satur ated sodium chloride aqueous solution and water in this orde r. To the resultant organic layer was added sodium sulfate, then, the mixture was filtrated, and the resultant filtrate was concentrated under reduced pressure. The resultant res idue was purified by using a silica gel column (developing s olvent; hexane), thereby obtaining a coarse product. The re sultant coarse product was recrystallized from hexane, there by obtaining 47.0 g of a compound Mb6 as a white solid. The compound Mb6 had an HPLC area percentage value (UV: 254 nm) of 98.3%.
¹H-NMR (CDCl₃, 300 MHz): δ (ppm): 1.38-1.45 (4H, m), 1.47-1.55 (4H, m), 1.57-1.67 (4H, m), 1.77-1.84 (4H, m), 2.66 (4H, t), 3.55 (4H, t), 7.36 (2H, s).

### <Synthesis Example 7-7> Synthesis of compound Mb7

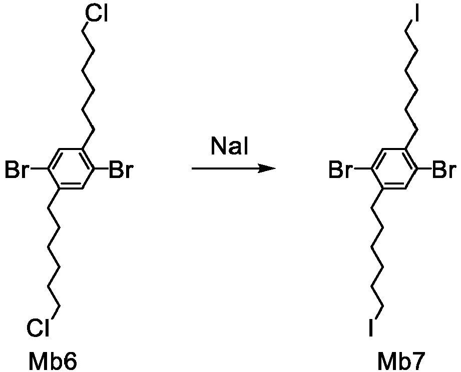

A gas in a flask equipped with a stirrer was purged with a nitrogen gas, then, sodium iodide (152.1 g) and acetone (6 00 mL) were added, and the mixture was stirred at room tempe rature for 0.5 hours. To this was added the compound Mb6 (40 .0 g), then, the mixture was heated up to the reflux tempera ture, and stirred at the reflux temperature for 24 hours. T hereafter, the mixture was cooled down to room temperature, and the resultant mixed liquid was added to water (1.2 L). T he deposited solid was separated by filtration, then, washed with water, thereby obtaining a coarse product. The result ant coarse product was recrystallized from a mixed liquid of toluene and methanol, thereby obtaining 46.0 g of a compoun d Mb7 as a white solid. The resultant compound Mb7 had an HP LC area percentage value (UV: 254 nm) of 99.4%. This operat ion was repeated, thereby obtaining a necessary amount of th e compound Mb7.
¹H-NMR (CDCl₃, 300 MHz): δ (ppm):1.35-1.50 (8H, m), 1.57-1.65 (4H, m), 1.80-1.89 (4H, m), 2.65 (4H, t), 3.20 (4H, t), 7.36 (2H, s).

### <Example 7-8> Synthesis of compound Mb8

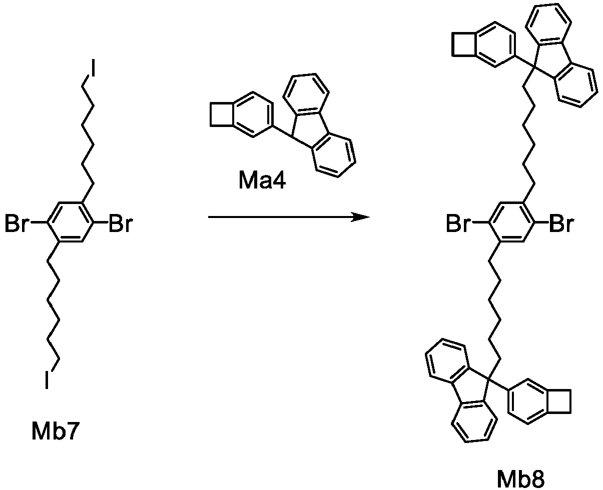

A gas in a flask equipped with a stirrer was purged with a nitrogen gas, then, sodium hydride (60 wt%, dispersed in 1 iquid paraffin) (9.4 g), tetrahydrofuran (110 mL) and the co mpound Mb7 (63.2 g) were added. To this, a compound Ma4 (55. 0 g) was added in several batches, then, the mixture was sti rred for 12 hours. To this were added toluene (440 mL) and w ater (220 mL), then, an aqueous layer was separated. The re sultant organic layer was washed with water, then, magnesium sulfate was added. The resultant mixed liquid was filtrate d, and the resultant filtrate was concentrated under reduced pressure, thereby obtaining a coarse product. The resultan t coarse product was purified by using a silica gel column ( developing solvent: a mixed solvent of hexane and toluene) . Thereafter, the product was recrystallized from heptane, th ereby obtaining 84.1 g of a compound Mb8 as a white solid. T he resultant compound Mb8 had an HPLC area percentage value (UV: 254 nm) of 99.5% or more.
¹H-NMR (CDCl₃, 300 MHz): δ (ppm):0.70-0.76 (4H, m), 1.10-1.21 (8H, m), 1.32-1.44 (4H, m), 2.39-2.58 (8H, m), 3.00-3.12 (8H, m), 6.82-6.94 (4H, m), 7.00-7.05 (2H, m), 7.17-7.28 (10H, m), 7.30-7.38 (4H, m), 7.71-7.77 (4H, m).

### <Example 7-9> Synthesis of compound CM7

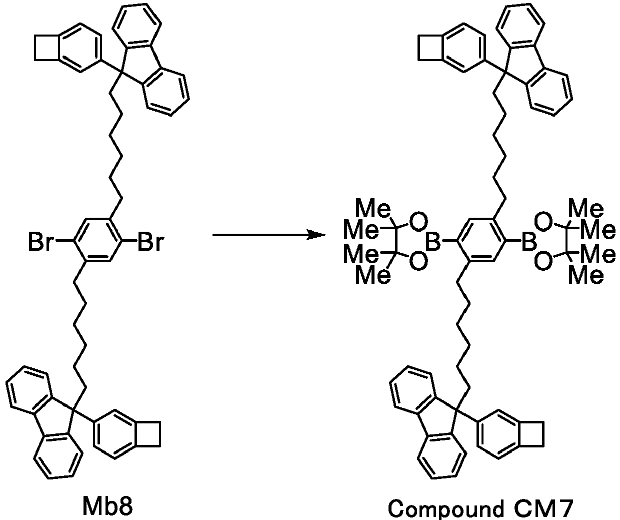

A gas in a flask equipped with a stirrer was purged with a nitrogen gas, then, the compound Mb8 (84.0 g), [1,1'-bis(d iphenylphosphino)ferrocene]palladium(II) dichloride dichlor omethane adduct (PdCl₂ (dppf) ·CH₂Cl₂, 2.2 g), bispinacolatodi boron (68.3 g), potassium acetate (52.8 g) and cyclopentyl m ethyl ether (840 mL) were added, and the mixture was heated up to the reflux temperature, then, stirred at the reflux te mperature for 5 hours. Thereafter, the mixture was cooled d own to room temperature, and toluene (500 mL) and water (300 mL) were added, then, an aqueous layer was separated. The r esultant organic layer was washed with water, then, activate d carbon (18.5 g) was added. The resultant mixed liquid was filtrated, and the resultant filtrate was concentrated under reduced pressure, thereby obtaining a coarse product. The resultant coarse product was purified by using a silica gel column (developing solvent: a mixed solvent of hexane and to luene). Thereafter, an operation of recrystallizing from a mixed liquid of toluene and acetonitrile was repeated, there by obtaining 45.8 g of a compound CM7 as a white solid. The resultant compound CM7 had an HPLC area percentage value (UV : 254 nm) of 99.4%.
¹H-NMR (CDCl₃, 300 MHz): δ (ppm):0.70-0.76 (4H, m), 1.24-1.40 (36H, m), 2.39-2.48 (4H, m), 2.66-2.75 (4H, m), 3.00-3.10 (8H, m), 6.76-6.90 (4H, m), 7.00-7.05 (2H, m), 7.19-7.30 (8H, m), 7.30-7.36 (4H, m), 7.43 (2H, s), 7.72 (4H, d) .

### (Synthesis Example 7-10) Synthesis of polymer compound HTL-3

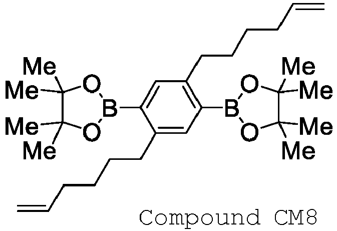

A polymer compound HTL-3 (1.05 g) was obtained by a method according to Synthesis of polymer compound HTL-1, excepting that (Step 1) in Synthesis of polymer compound HTL-1 was changed to "An inert gas atmosphere was prepared in a reaction vessel, then, a compound CM7 (0.12976 g), a compound CM8 (0.0620 g) synthesized according to a method described in International Publication WO2013/146806, a compound CM1 (0.493 g), a compound CM5 (1.15 g), dichlorobis(tris-o-methoxyphenylphosphine)palladium (2.20 mg) and toluene (30 ml) were added, and the mixture was heated at 105°C.".

The polymer compound HTL-3 had a polystyrene-equivalent number-average molecular weight of 2.4×10⁴ and a polystyrene-equivalent weight-average molecular weight of 1.8×10⁵.

The polymer compound HTL-3 is a copolymer constituted of a constitutional unit derived from a compound CM7, a constitutional unit derived from a compound CM8, a constitutional unit derived from a compound CM1 and a constitutional unit derived from a compound CM5 at a molar ratio of 5:5:40:50, according to theoretical values calculated from the amounts of charged raw materials.

### <Synthesis Example 8> Synthesis of polymer compound HTL-4

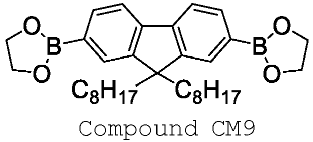

A polymer compound HTL-4 was synthesized according to a method described in International Publication WO2011/049241, using a compound CM9 synthesized according to a method described in International Publication WO2002/045184, and a compound CM4 and a compound CM6.

The polystyrene-equivalent number-average molecular weight and weight-average molecular weight of the polymer compound HTL-4 were Mn = 8.9×10⁴ and Mw = 4.2×10⁵, respectively.

The polymer compound HTL-4 is a copolymer constituted of a constitutional unit derived from a compound CM9, a constitutional unit derived from a compound CM4 and a constitutional unit derived from a compound CM6 at a molar ratio of 50:42.5:7.5, according to theoretical values calculated from the amounts of charged raw materials.

### <Synthesis Example 9> Synthesis of polymer compound HTL-5

A polymer compound HTL-5 was synthesized according to a method described in JP-A No. 2012-36381, using a compound CM9 and a compound CM4.

The polystyrene-equivalent number-average molecular weight and weight-average molecular weight of the polymer compound HTL-5 were Mn = 8.1×10⁴ and Mw = 3.4×10⁵, respectively.

The polymer compound HTL-5 is a copolymer constituted of a constitutional unit derived from a compound CM9 and a constitutional unit derived from a compound CM4 at a molar ratio of 50:50, according to theoretical values calculated from the amounts of charged raw materials.

### <Synthesis Example 10> Synthesis of polymer compound ETL-1

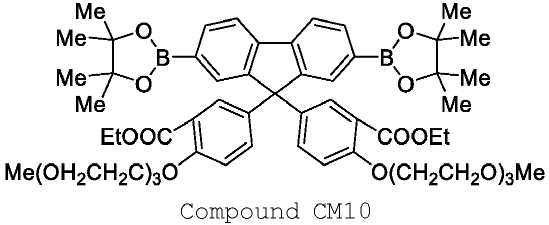

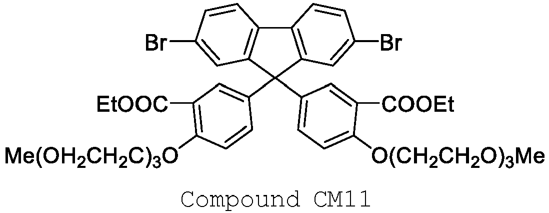

### (Synthesis of polymer compound ETL-1a)

A polymer compound ETL-1a was synthesized according to a method described in JP-ANo. 2012-33845, using a compound CM10 synthesized according to a method described in JP-A No. 2012-33845 and a compound CM11 synthesized according to a method described in JP-A No. 2012-33845.

The polymer compound ETL-1a had a Mn of 5.2×10⁴.

The polymer compound ETL-1a is a copolymer constituted of a constitutional unit derived from a compound CM10 and a constitutional unit derived from a compound CM11 at a molar ratio of 50:50, according to theoretical values calculated from the amounts of charged raw materials.

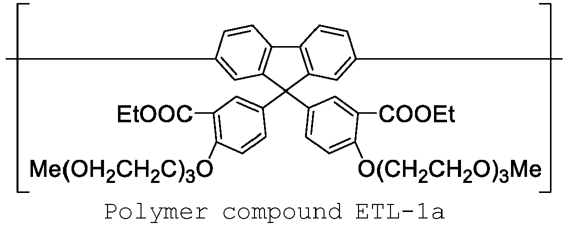

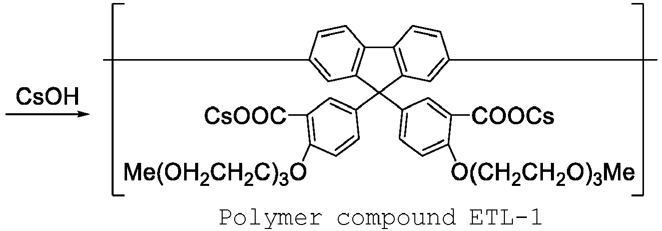

### (Synthesis of polymer compound ETL-1)

An inert gas atmosphere was prepared in a reaction vessel, then, a polymer compound ETL-1a (200 mg), tetrahydrofuran (20 ml) and ethanol (20 ml) were added, and the mixture was heated at 55°C. To this was added cesium hydroxide (200 mg) dissolved in water (2 ml), and the mixture was stirred at 55°C for 6 hours. Thereafter, the mixture was cooled down to room temperature, then, concentrated under reduced pressure, to obtain a solid. The resultant solid was washed with water, then, dried under reduced pressure, to obtain a polymer compound ETL-1 (150 mg, pale yellow solid) . It was confirmed that a signal derived from an ethyl group of an ethyl ester portion of a polymer compound ETL-1a disappeared completely, by the NMR spectrum of the resultant polymer compound ETL-1.

### <Example D1> Fabrication and evaluation of light emitting device D1

### (Formation of anode and hole injection layer)

An ITO film with a thickness of 45 nm was attached to a glass substrate by a sputtering method, to form an anode. On the anode, a polythiophene·sulfonic acid type hole injection material AQ-1200 (manufactured by Plextronics) was spin-coated to form a film with a thickness of 35 nm, and the film was heated on a hot plate at 170°C for 15 minutes under an air atmosphere, to form a hole injection layer.

### (Formation of hole transporting layer)

A polymer compound HTL-1 was dissolved at a concentration of 0.7 wt% in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

A low molecular weight compound SM1 (manufactured by Luminescense Technology) and a metal complex 1 (low molecular weight compound SM1/metal complex 1 = 75 wt%/25 wt%) were dissolved at a concentration of 2.0 wt% in toluene. The resultant toluene solution was spin-coated on the hole transporting layer to form a film with a thickness of 75 nm, and the film was heated at 130°C for 10 minutes under a nitrogen gas atmosphere, to form a light emitting layer. 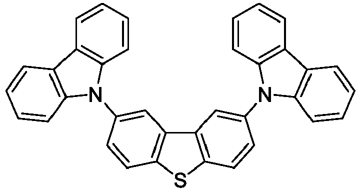 Low molecular weight compound SM1

### (Formation of cathode)

The substrate carrying the light emitting layer formed thereon was placed in a vapor deposition machine, and the pressure was reduced to 1.0×10⁻⁴ Pa or less, then, as a cathode, sodium fluoride was vapor-deposited with a thickness of about 7 nm on the light emitting layer, then, aluminum was vapor-deposited with a thickness of about 120 nm on the sodium fluoride layer. After vapor deposition, sealing was performed using a glass substrate, to fabricate a light emitting device D1.

### (Evaluation of light emitting device)

Voltage was applied to the light emitting device D1, to observe EL emission. The external quantum efficiency at 250 cd/m² was 3.23%, and the CIE chromaticity coordinate (x, y) was (0.15, 0.22).

### <Example D2> Fabrication and evaluation of light emitting device D2

### (Fabrication of light emitting device D2)

A light emitting device D2 was fabricated in the same manner as in Example D1, excepting that a low molecular weight compound SM1 (manufactured by Luminescense Technology) and a metal complex 2 (low molecular weight compound SM1/metal complex 2 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1.

Voltage was applied to the light emitting device D2, to observe EL emission. The external quantum efficiency at 250 cd/m² was 12.89%, and the CIE chromaticity coordinate (x, y) was (0.15, 0.32).

### <Example D3> Fabrication and evaluation of light emitting device D3

### (Fabrication of light emitting device D3)

A light emitting device D3 was fabricated in the same manner as in Example D1, excepting that a low molecular weight compound SM2 (manufactured by Luminescense Technology) and a metal complex 1 (low molecular weight compound SM2/metal complex 1 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1.

Voltage was applied to the light emitting device D3, to observe EL emission. The external quantum efficiency at 250 cd/m² was 1.75%, and the CIE chromaticity coordinate (x, y) was (0.18, 0.27). 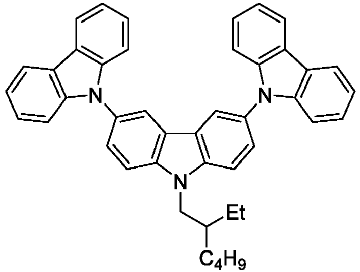 Low molecular weight compound SM2

### <Example D4> Fabrication and evaluation of light emitting device D4

### (Fabrication of light emitting device D4)

A light emitting device D4 was fabricated in the same manner as in Example D1, excepting that a low molecular weight compound SM1 (manufactured by Luminescense Technology) and a metal complex 4 (low molecular weight compound SM1/metal complex 4 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1.

Voltage was applied to the light emitting device D4, to observe EL emission. The external quantum efficiency at 250 cd/m² was 13.82%, and the CIE chromaticity coordinate (x, y) was (0.15, 0.32).

### <Example D5> Fabrication and evaluation of light emitting device D5

### (Fabrication of light emitting device D5)

A light emitting device D5 was fabricated in the same manner as in Example D1, excepting that a low molecular weight compound SM1 (manufactured by Luminescense Technology) and a metal complex 5 (low molecular weight compound SM1/metal complex 5 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1.

Voltage was applied to the light emitting device D5, to observe EL emission. The external quantum efficiency at 250 cd/m² was 18.68%, and the CIE chromaticity coordinate (x, y) was (0.15, 0.34).

### <Example D6> Fabrication and evaluation of light emitting device D6

### (Fabrication of light emitting device D6)

A light emitting device D6 was fabricated in the same manner as in Example D1, excepting that a low molecular weight compound SM1 (manufactured by Luminescense Technology) and a metal complex 6 (low molecular weight compound SM1/metal complex 6 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1,.

Voltage was applied to the light emitting device D6, to observe EL emission. The external quantum efficiency at 250 cd/m² was 11.52%, and the CIE chromaticity coordinate (x, y) was (0.15, 0.35).

### <Example D7> Fabrication and evaluation of light emitting device D7

### (Fabrication of light emitting device D7)

A light emitting device D7 was fabricated in the same manner as in Example D2, excepting that a polymer compound HTL-2 was used instead of the polymer compound HTL-1 in Example D2.

Voltage was applied to the light emitting device D7, to observe EL emission. The external quantum efficiency at 250 cd/m² was 5.23%, and the CIE chromaticity coordinate (x, y) was (0.15, 0.30).

### <Example D8> Fabrication and evaluation of light emitting device D8

### (Fabrication of light emitting device D8)

A light emitting device D8 was fabricated in the same manner as in Example D2, excepting that a polymer compound HTL-3 was used instead of the polymer compound HTL-1 in Example D2.

Voltage was applied to the light emitting device D8, to observe EL emission. The external quantum efficiency at 250 cd/m² was 5.95%, and the CIE chromaticity coordinate (x, y) was (0.15, 0.31).

### <Example D9> Fabrication and evaluation of light emitting device D9

### (Fabrication of light emitting device D9)

A light emitting device D9 was fabricated in the same manner as in Example D1, excepting that a polymer compound HTL-4 was used instead of the polymer compound HTL-1 in Example D1.

Voltage was applied to the light emitting device D9, to observe EL emission. The external quantum efficiency at 250 cd/m² was 2.99%, and the CIE chromaticity coordinate (x, y) was (0.15, 0.23).

### <Comparative Example CD1> Fabrication and evaluation of light emitting device CD1

### (Fabrication of light emitting device CD1)

A light emitting device CD1 was fabricated in the same manner as in Example D1, excepting that (Formation of light emitting layer) in Example D1 was changed to "A low molecular weight compound SM3 (manufactured by DOJINDO Molecular Technologies, Inc.) and a metal complex 1 (low molecular weight compound SM3/metal complex 1 = 75 wt%/25 wt%) were dissolved at a concentration of 0.7 wt% in chloroform. The resultant chloroform solution was spin-coated on the hole transporting layer to form a film with a thickness of 75 nm, and the film was heated at 130°C for 10 minutes under a nitrogen gas atmosphere, to form a light emitting layer.".

Voltage was applied to the light emitting device CD1, to observe EL emission. The external quantum efficiency at 250 cd/m² was 0.49%, and the CIE chromaticity coordinate (x, y) was (0.17, 0.25). 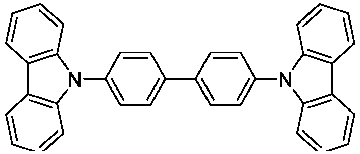 Low molecular weight compound SM3

### <Comparative Example CD2> Fabrication and evaluation of light emitting device CD2

### (Fabrication of light emitting device CD2)

A light emitting device CD2 was fabricated in the same manner as in Example D1, excepting that a low molecular weight compound SM1 (manufactured by Luminescense Technology) and a metal complex 3 (low molecular weight compound SM1/metal complex 3 =7 5 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D1.

Voltage was applied to the light emitting device CD2, to observe EL emission. The external quantum efficiency at 250 cd/m² was 1.03%, and the CIE chromaticity coordinate (x, y) was (0.24, 0.50).

**[Table 8]**

| | hole transporting layer | light emitting layer | | external quantum efficiency (250 cd/m²) |
|---|---|---|---|---|
| light emitting device D1 | polymer compound HTL-1 | low molecular weight compound SM1 | metal complex 1 | 3.23% |
| light emitting device D2 | polymer compound HTL-1 | low molecular weight compound SM1 | metal complex 2 | 12.89% |
| light emitting device D3 | polymer compound HTL-1 | low molecular weight compound SM2 | metal complex 1 | 1.75% |
| light emitting device D4 | polymer compound HTL-1 | low molecular weight compound | metal complex 4 | 13.82% |
| | | SM1 | | |
| light emitting device D5 | polymer compound HTL-1 | low molecular weight compound SM1 | metal complex 5 | 18.68% |
| light emitting device D6 | polymer compound HTL-1 | low molecular weight compound SM1 | metal complex 6 | 11.52% |
| light emitting device D7 | polymer compound HTL-2 | low molecular weight compound SM1 | metal complex 2 | 5.23% |
| light emitting device D8 | polymer compound HTL-3 | low molecular weight compound SM1 | metal complex 2 | 5.95% |
| light emitting device | polymer compound HTL-4 | low molecular weight | metal complex 1 | 2.99% |
| D9 | | compound SM1 | | |
| light emitting device CD1 | polymer compound HTL-1 | low molecular weight compound SM3 | metal complex 1 | 0.49% |
| light emitting device CD2 | polymer compound HTL-1 | low molecular weight compound SM1 | metal complex 3 | 1.03% |

### <Example D10> Fabrication and evaluation of light emitting device D10

### (Formation of anode and hole injection layer)

An ITO film with a thickness of 45 nm was attached to a glass substrate by a sputtering method, to form an anode. On the anode, a polythiophene·sulfonic acid type hole injection material AQ-1200 (manufactured by Plextronics) was spin-coated to form a film with a thickness of 35 nm, and the film was heated on a hot plate at 170°C for 15 minutes under an air atmosphere, to form a hole injection layer.

### (Formation of hole transporting layer)

A polymer compound HTL-1 was dissolved at a concentration of 0.7 wt% in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

A low molecular weight compound SM1 (manufactured by Luminescense Technology) and a metal complex 1 (low molecular weight compound SM1/metal complex 1 = 75 wt%/25 wt%) were dissolved at a concentration of 2.0 wt% in toluene. The resultant toluene solution was spin-coated on the hole transporting layer to form a film with a thickness of 75 nm, and the film was heated at 130°C for 10 minutes under a nitrogen gas atmosphere, to form a light emitting layer.

### (Formation of electron transporting layer)

A polymer compound ETL-1 was dissolved at a concentration of 0.25 wt% in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure was reduced to 1.0×10⁻⁴ Pa or less, then, as a cathode, sodium fluoride was vapor-deposited with a thickness of about 7 nm on the electron transporting layer, then, aluminum was vapor-deposited with a thickness of about 120 nm on the sodium fluoride layer. After vapor deposition, sealing was performed using a glass substrate, to fabricate a light emitting device D10.

### (Evaluation of light emitting device)

Voltage was applied to the light emitting device D10, to observe EL emission. The external quantum efficiency at 2000 cd/m² was 4.60%, and the CIE chromaticity coordinate (x, y) was (0.16, 0.25).

### <Example D11> Fabrication and evaluation of light emitting device D11

### (Fabrication of light emitting device D11)

A light emitting device D11 was fabricated in the same manner as in Example D10, excepting that a low molecular weight compound SM1 (manufactured by Luminescense Technology) and a metal complex 2 (low molecular weight compound SM1/metal complex 2 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D10.

Voltage was applied to the light emitting device D11, to observe EL emission. The external quantum efficiency at 2000 cd/m² was 10.98%, and the CIE chromaticity coordinate (x, y) was (0.17, 0.38).

### <Example D12> Fabrication and evaluation of light emitting device D12

### (Fabrication of light emitting device D12)

A light emitting device D12 was fabricated in the same manner as in Example D10, excepting that a low molecular weight compound SM2 (manufactured by Luminescense Technology) and a metal complex 1 (low molecular weight compound SM2/metal complex 1 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D10.

Voltage was applied to the light emitting device D12, to observe EL emission. The external quantum efficiency at 2000 cd/m² was 4.35%, and the CIE chromaticity coordinate (x, y) was (0.18, 0.27).

### <Example D13> Fabrication and evaluation of light emitting device D13

### (Fabrication of light emitting device D13)

A light emitting device D13 was fabricated in the same manner as in Example D10, excepting that a low molecular weight compound SM4 and a metal complex 1 (low molecular weight compound SM4/metal complex 1 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D10. 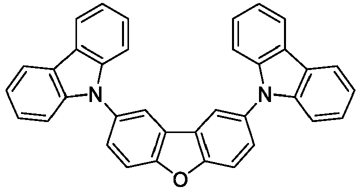 Low molecular weight compound SM4

Voltage was applied to the light emitting device D13, to observe EL emission. The external quantum efficiency at 2000 cd/m² was 3.23%, and the CIE chromaticity coordinate (x, y) was (0.16, 0.25).

### <Example D14> Fabrication and evaluation of light emitting device D14

### (Fabrication of light emitting device D14)

A light emitting device D14 was fabricated in the same manner as in Example D10, excepting that a low molecular weight compound SM1 and a metal complex 7 (low molecular weight compound SM1/metal complex 7 = 75 wt%/25 wt%) were used instead of the low molecular weight compound SM1 (manufactured by Luminescense Technology) and the metal complex 1 (low molecular weight compound SM1/metal complex 1 = 75 wt%/25 wt%) in Example D10.

Voltage was applied to the light emitting device D14, to observe EL emission. The external quantum efficiency at 2000 cd/m² was 1.93%, and the CIE chromaticity coordinate (x, y) was (0.30, 0.55).

### <Comparative Example CD3> Fabrication and evaluation of light emitting device CD3

### (Fabrication of light emitting device CD3)

A light emitting device CD3 was fabricated in the same manner as in Example D10, excepting that (Formation of light emitting layer) in Example D10 was changed to "A low molecular weight compound SM3 (manufactured by DOJINDO Molecular Technologies, Inc.) and a metal complex 1 (low molecular weight compound SM3/metal complex 1 = 75 wt%/25 wt%) were dissolved at a concentration of 0.7 wt% in chloroform. The resultant chloroform solution was spin-coated on the hole transporting layer to form a film with a thickness of 75 nm, and the film was heated at 130°C for 10 minutes under a nitrogen gas atmosphere, to form a light emitting layer.".

Voltage was applied to the light emitting device CD3, to observe EL emission. The external quantum efficiency at 2000 cd/m² was 1.28%, and the CIE chromaticity coordinate (x, y) was (0.17, 0.28).

**[Table 9]**

| | hole transporting layer | light emitting layer | | external quantum efficiency (2000 cd/m²) |
|---|---|---|---|---|
| light emitting device D10 | polymer compound HTL-1 | low molecular weight compound SM1 | metal complex 1 | 4.60% |
| light emitting device D11 | polymer compound HTL-1 | low molecular weight compound SM1 | metal complex 2 | 10.98% |
| light emitting device D12 | polymer compound HTL-1 | low molecular weight compound SM2 | metal complex 1 | 4.35% |
| light emitting device D13 | polymer compound HTL-1 | low molecular weight compound | metal complex 1 | 3.23% |
| | | SM4 | | |
| light emitting device D14 | polymer compound HTL-1 | low molecular weight compound SM1 | metal complex 7 | 1.93% |
| light emitting device CD3 | polymer compound HTL-1 | low molecular weight compound SM3 | metal complex 1 | 1.28% |

### <Example D15> Fabrication and evaluation of light emitting device D15

### (Formation of anode and hole injection layer)

An ITO film with a thickness of 45 nm was attached to a glass substrate by a sputtering method, to form an anode. On the anode, a polythiophene·sulfonic acid type hole injection material AQ-1200 (manufactured by Plextronics) was spin-coated to form a film with a thickness of 35 nm, and the film was heated on a hot plate at 170°C for 15 minutes under an air atmosphere, to form a hole injection layer.

### (Formation of hole transporting layer)

A polymer compound HTL-1 was dissolved at a concentration of 0.7 wt% in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

A low molecular weight compound SM1 (manufactured by Luminescense Technology) and a metal complex 2 (low molecular weight compound SM1/metal complex 2 = 70 wt%/30 wt%) were dissolved at a concentration of 2.0 wt% in toluene. The resultant toluene solution was spin-coated on the hole transporting layer to form a film with a thickness of 60 nm, and the film was heated at 130°C for 10 minutes under a nitrogen gas atmosphere, to form a light emitting layer.

### (Formation of electron transporting layer)

A polymer compound ETL-1 was dissolved at a concentration of 0.25 wt% in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure was reduced to 1.0×10⁻⁴ Pa or less, then, as a cathode, sodium fluoride was vapor-deposited with a thickness of about 7 nm on the electron transporting layer, then, aluminum was vapor-deposited with a thickness of about 120 nm on the sodium fluoride layer. After vapor deposition, sealing was performed using a glass substrate, to fabricate a light emitting device D15.

### (Evaluation of light emitting device)

Voltage was applied to the light emitting device D15, to observe EL emission. The external quantum efficiency at 1000 cd/m² was 13.32%, and the CIE chromaticity coordinate (x, y) was (0.15, 0.30).

### <Example D16> Fabrication and evaluation of light emitting device D16

### (Fabrication of light emitting device D16)

A light emitting device D16 was fabricated in the same manner as in Example D15, excepting that a polymer compound HTL-1 and a metal complex 2 (polymer compound HTL-1/metal complex 2 = 95 wt%/5 wt%) were used instead of the polymer compound HTL-1 in Example D15.

Voltage was applied to the light emitting device D16, to observe EL emission. The external quantum efficiency at 1000 cd/m² was 8.77%, and the CIE chromaticity coordinate (x, y) was (0.15, 0.30).

### <Example D17> Fabrication and evaluation of light emitting device D17

### (Fabrication of light emitting device D17)

A light emitting device D17 was fabricated in the same manner as in Example D15, excepting that a polymer compound HTL-1 and a metal complex 2 (polymer compound HTL-1/metal complex 2 = 85 wt%/15 wt%) were used instead of the polymer compound HTL-1 in Example D15.

Voltage was applied to the light emitting device D17, to observe EL emission. The external quantum efficiency at 1000 cd/m² was 7.88%, and the CIE chromaticity coordinate (x, y) was (0.15, 0.30).

### <Example D18> Fabrication and evaluation of light emitting device D18

### (Fabrication of light emitting device D18)

A light emitting device D18 was fabricated in the same manner as in Example D15, excepting that a polymer compound HTL-1 and a metal complex 2 (polymer compound HTL-1/metal complex 2 = 70 wt%/30 wt%) were used instead of the polymer compound HTL-1 in

### Example D15.

Voltage was applied to the light emitting device D18, to observe EL emission. The external quantum efficiency at 1000 cd/m² was 7.18%, and the CIE chromaticity coordinate (x, y) was (0.15, 0.29).

### <Example D19> Fabrication and evaluation of light emitting device D19

### (Formation of anode and hole injection layer)

An ITO film with a thickness of 45 nm was attached to a glass substrate by a sputtering method, to form an anode. On the anode, a polythiophene·sulfonic acid type hole injection material AQ-1200 (manufactured by Plextronics) was spin-coated to form a film with a thickness of 35 nm, and the film was heated on a hot plate at 170°C for 15 minutes under an air atmosphere, to form a hole injection layer.

### (Formation of hole transporting layer)

A polymer compound HTL-4 was dissolved at a concentration of 0.7 wt% in xylene. The resultant xylene solution was spin-coated on the hole injection layer to form a film with a thickness of 20 nm, and the film was heated on a hot plate at 180°C for 60 minutes under a nitrogen gas atmosphere, to form a hole transporting layer.

### (Formation of light emitting layer)

A low molecular weight compound SM1 (manufactured by Luminescense Technology) and a metal complex 7 (low molecular weight compound SM1/metal complex 7 = 75 wt%/25 wt%) were dissolved at a concentration of 2.0 wt% in chlorobenzene. The resultant chlorobenzene solution was spin-coated on the hole transporting layer to form a film with a thickness of 75 nm, and the film was heated at 130°C for 10 minutes under a nitrogen gas atmosphere, to form a light emitting layer.

### (Formation of electron transporting layer)

A polymer compound ETL-1 was dissolved at a concentration of 0.25 wt% in 2,2,3,3,4,4,5,5-octafluoro-1-pentanol. The resultant 2,2,3,3,4,4,5,5-octafluoro-1-pentanol solution was spin-coated on the light emitting layer to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine, and the pressure was reduced to 1.0×10⁻⁴ Pa or less, then, as a cathode, sodium fluoride was vapor-deposited with a thickness of about 7 nm on the electron transporting layer, then, aluminum was vapor-deposited with a thickness of about 120 nm on the sodium fluoride layer. After vapor deposition, sealing was performed using a glass substrate, to fabricate a light emitting device D19.

### (Evaluation of light emitting device)

Voltage was applied to the light emitting device D19, to observe EL emission. The external quantum efficiency at 50 cd/m² was 3.04%, and the CIE chromaticity coordinate (x, y) was (0.29, 0.55).

### <Comparative Example CD4> Fabrication and evaluation of light emitting device CD4

### (Fabrication of light emitting device CD4)

A light emitting device CD4 was fabricated in the same manner as in Example D19, excepting that a polymer compound HTL-5 was used instead of the polymer compound HTL-4 in Example D19.

Voltage was applied to the light emitting device CD4, to observe EL emission. The external quantum efficiency at 50 cd/m² was 1.84%, and the CIE chromaticity coordinate (x, y) was (0.28, 0.53).

**[Table 10]**

| | hole transporting layer | light emitting layer | | external quantum efficiency (50 cd/m²) |
|---|---|---|---|---|
| light emitting device D19 | polymer compound HTL-4 | low molecular weight compound SM1 | metal complex 7 | 3.04% |
| light emitting device CD4 | polymer compound HTL-5 | low molecular weight compound SM1 | metal complex 7 | 1.84% |

### Industrial Applicability

According to the present invention, a light emitting device excellent in external quantum efficiency is obtained.

## Claims

1. A light emitting device comprising
an anode,
a cathode,
a first organic layer disposed between the anode and the cathode and
a second organic layer disposed between the anode and the cathode,
wherein the first organic layer is a layer obtained by using a composition comprising a compound represented by the formula (H-A) and a metal complex represented by the formula (1), and
the second organic layer is a layer obtained by using a polymer compound comprising a constitutional unit having a crosslinkable group: 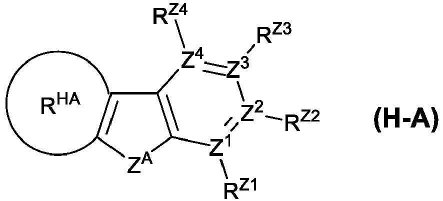 wherein
Z^{A} represents a group represented by -C(R^{ZA})₂-, a group represented by -Si(R^{ZA})₂-, a group represented by -N(R^{ZA})-, a group represented by -B(R^{ZA})-, a group represented by -P(R^{ZA})-, a group represented by -P(=O)(R^{ZA})-, a sulfur atom or an oxygen atom, and R^{ZA} represents a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and when a plurality of R^{ZA} are present, they may be the same or different and may be combined together to form a ring together with the atoms to which they are attached,
Z¹, Z², Z³ and Z⁴ each independently represent a carbon atom or a nitrogen atom, and at least one of Z¹, Z², Z³ and Z⁴ is a carbon atom,
R^{Z1}, R^{Z2}, R^{Z3} and R^{Z4} each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and R^{Z1} is not present when Z¹ is a nitrogen atom, R^{Z2} is not present when Z² is a nitrogen atom, R^{Z3} is not present when Z³ is a nitrogen atom, and R^{Z4} is not present when Z⁴ is a nitrogen atom, and at least one of R^{Z1}, R^{Z2}, R^{Z3} and R^{Z4} is a monovalent heterocyclic group represented by the formula (H-1),
the ring R^{HA} represents an aromatic hydrocarbon ring or an aromatic heterocyclic ring and these rings each optionally have a substituent, and when a plurality of the substituents are present, they may be the same or different and may be combined together to form a ring together with the atoms to which they are attached, and
R^{Z1} and R^{Z2}, R^{Z2} and R^{Z3}, R^{Z3} and R^{Z4}, R^{Z1} and R^{ZA}, a substituent which the ring R^{HA} optionally has and R^{ZA}, and a substituent which the ring R^{HA} optionally has and R^{Z4} each may be combined together to form a ring together with the atoms to which they are attached: 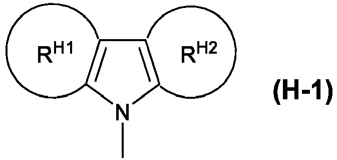 wherein
the ring R^{H1} and the ring R^{H2} each independently represent an aromatic hydrocarbon ring or an aromatic heterocyclic ring and these rings each optionally have a substituent, and when a plurality of the substituents are present, they may be the same or different and may be combined together to form a ring together with the atoms to which they are attached: 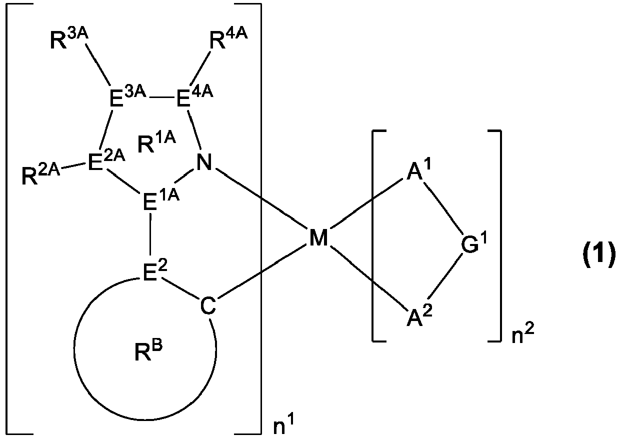 wherein
M represents a ruthenium atom, a rhodium atom, a palladium atom, an iridium atom or a platinum atom,
n¹ represents an integer of 1 or more, n² represents an integer of 0 or more, and n¹+n² is 2 or 3, and n¹+n² is 3 when M is a ruthenium atom, a rhodium atom or an iridium atom, while n¹+n² is 2 when M is a palladium atom or a platinum atom,
E^{1A} represents a carbon atom, E^{2A}, E^{3A} and E^{4A} each independently represent a nitrogen atom or a carbon atom, and two of E^{2A}, E^{3A} and E^{4A} are a nitrogen atom and the remaining one is a carbon atom, and when a plurality of E^{2A}, E^{3A} and E^{4A} are present, they may be the same or different at each occurrence,
E² represents a carbon atom or a nitrogen atom,
R^{2A} represents a hydrogen atom, an alkyl group, a cycloalkyl group, an alkoxy group, a cycloalkoxy group, an aryl group, an aryloxy group, a monovalent heterocyclic group, a halogen atom or a dendron and these groups each optionally have a substituent, R^{3A} and R^{4A} each independently represent an alkyl group, a cycloalkyl group, an alkoxy group, a cycloalkoxy group, an aryl group, an aryloxy group, a monovalent heterocyclic group, a halogen atom or a dendron and these groups each optionally have a substituent, and when a plurality of R^{2A}, R^{3A} and R^{4A} are present, they may be the same or different at each occurrence, and R^{2A} and R^{3A}, R^{3A} and R^{4A}, and a substituent which the ring R^{B} optionally has and R^{2A} each may be combined together to form a ring together with the atoms to which they are attached, and R^{2A} may be either present or not present when E^{2A} is a nitrogen atom, R^{3A} may be either present or not present when E^{3A} is a nitrogen atom, and R^{4A} may be either present or not present when E^{4A} is a nitrogen atom,
the ring R^{1A} represents a triazole ring constituted of a nitrogen atom, E^{1A}, E^{2A}, E^{3A} and E^{4A},
the ring R^{B} represents a 5-membered or 6-membered aromatic hydrocarbon ring or a 5-membered or 6-membered aromatic heterocyclic ring and these rings each optionally have a substituent, and when a plurality of the substituents are present, they may be the same or different and may be combined together to form a ring together with the atoms to which they are attached, and when a plurality of the rings R^{B} are present, they may be the same or different, and E² is a carbon atom when the ring R^{B} is a 6-membered aromatic heterocyclic ring,and
A¹-G¹-A² represents an anionic bidentate ligand, and G¹ represents an atomic group constituting a bidentate ligand together with A¹ and A², and A¹ and A² each independently represent a carbon atom, an oxygen atom or a nitrogen atom and these atoms each may be a carbon atom, an oxygen atom or a nitrogen atom constituting a ring, and when a plurality of A¹-G¹-A² are present, they may be the same or different.

2. The light emitting device according to claim 1, wherein the first organic layer and the second organic layer are adjacent.

3. The light emitting device according to claim 1 or 2, wherein the second organic layer is a layer disposed between the anode and the first organic layer.

4. The light emitting device according to any one of claims 1 to 3, wherein the compound represented by the formula (H-A) is a compound represented by the formula (H-A1): 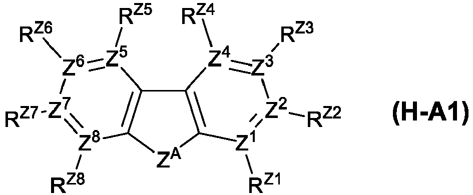 wherein
Z^{A}, Z¹, Z², Z³, Z⁴, R^{Z1}, R^{Z2}, R^{Z3} and R^{Z4} represent the same meaning as described above,
Z⁵, Z⁶, Z⁷ and Z⁸ each independently represent a carbon atom or a nitrogen atom,
R^{Z5}, R^{Z6}, R^{Z7} and R^{Z8} each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and R^{Z5} is not present when Z⁵ is a nitrogen atom, R^{Z6} is not present when Z⁶ is a nitrogen atom, R^{Z7} is not present when Z⁷ is a nitrogen atom, and R^{Z8} is not present when Z⁸ is a nitrogen atom, and
R^{Z4} and R^{Z5}, R^{Z5} and R^{Z6}, R^{Z6} and R^{Z7}, R^{Z7} and R^{Z8}, and R^{Z8} and R^{ZA} each may be combined together to form a ring together with the atoms to which they are attached.

5. The light emitting device according to claim 4, wherein Z¹, Z², Z³, Z⁴, Z⁵, Z⁶, Z⁷ and Z⁸ are each a carbon atom.

6. The light emitting device according to any one of claims 1 to 5, wherein R^{Z3} is a group represented by the formula (H-1).

7. The light emitting device according to any one of claims 1 to 6, wherein Z^{A} is a group represented by -N(R^{ZA})-, a sulfur atom or an oxygen atom.

8. The light emitting device according to any one of claims 1 to 7, wherein the group represented by the formula (H-1) is a group represented by the formula (H-2): 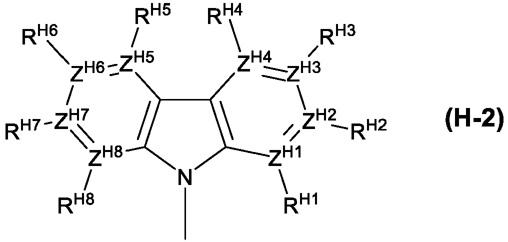 wherein
Z^{H1}, Z^{H2}, Z^{H3}, Z^{H4}, Z^{H5}, Z^{H6}, Z^{H7} and Z^{H8} each independently represent a carbon atom or a nitrogen atom,
R^{H1}, R^{H2}, R^{H3}, R^{H4}, R^{H5}, R^{H6}, R^{H7} and R^{H8} each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent,
R^{H1} is not present when Z^{H1} is a nitrogen atom, R^{H2} is not present when Z^{H2} is a nitrogen atom, R^{H3} is not present when Z^{H3} is a nitrogen atom, R^{H4} is not present when Z^{H4} is a nitrogen atom, R^{H5} is not present when Z^{H5} is a nitrogen atom, R^{H6} is not present when Z^{H6} is a nitrogen atom, R^{H7} is not present when Z^{H7} is a nitrogen atom, and R^{H8} is not present when Z^{H8} is a nitrogen atom, and
R^{H1} and R^{H2}, R^{H2} and R^{H3}, R^{H3} and R^{H4}, R^{H4} and R^{H5}, R^{H5} and R^{H6}, R^{H6} and R^{H7}, and R^{H7} and R^{H8} each may be combined together to form a ring together with the carbon atoms to which they are attached.

9. The light emitting device according to claim 8, wherein Z^{H1}, Z^{H2}, Z^{H3}, Z^{H4}, Z^{H5}, Z^{H6}, Z^{H7} and Z^{H8} are each a carbon atom.

10. The light emitting device accoridng to any one of claims 1 to 9, wherein the metal complex represented by the formula (1) is a metal complex represented by the forumula (1-A): 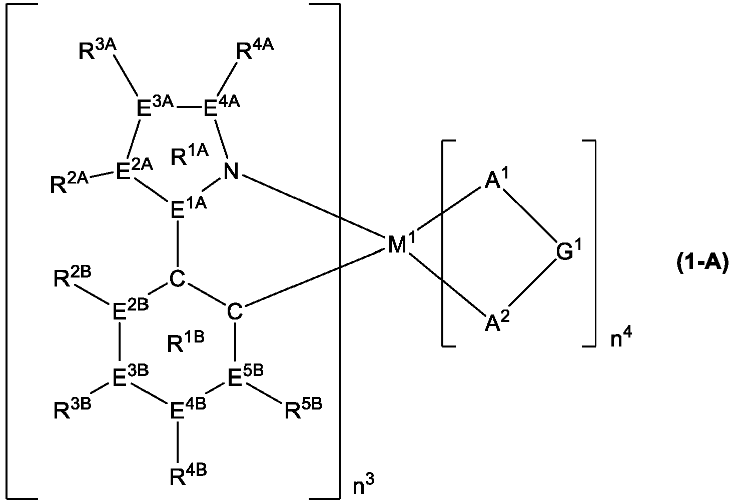 wherein
E^{1A}, E^{2A}, E^{3A}, E^{4A}, R^{2A}, R^{3A}, R^{4A}, the ring R^{1A} and A¹-G¹-A² represent the same meaning as described above,
M¹ represents an iridium atom or a platinum atom,
n³ represents an integer of 1 or more, n⁴ represents an integer of 0 or more, and n³+n⁴ is 2 or 3, and n³+n⁴ is 3 when M¹ is an iridium atom, while n³+n⁴ is 2 when M¹ is a platinum atom,
E^{2B}, E^{3B}, E^{4B} and E^{5B} each independently represent a nitrogen atom or a carbon atom, and a plurality of E^{2B}, E^{3B}, E^{4B} and E^{5B} are present, they may be the same or different at each occurrence, and R^{2B} is not present when E^{2B} is a nitrogen atom, R^{3B} is not present when E^{3B} is a nitrogen atom, R^{4B} is not present when E^{4B} is a nitrogen atom, and R^{5B} is not present when E^{5B} is a nitrogen atom,
R^{2B}, R^{3B}, R^{4B} and R^{5B} each independently represent a hydrogen atom, an alkyl group, a cycloalkyl group, an alkoxy group, a cycloalkoxy group, an aryl group, an aryloxy group, a monovalent heterocyclic group, a halogen atom or a dendron and these groups each optionally have a substituent, and when a plurality of R^{2B}, R^{3B}, R^{4B} and R^{5B} are present, they may be the same or different at each occurrence, and R^{2A} and R^{3A}, R^{3A} and R^{4A}, R^{2A} and R^{2B}, R^{2B} and R^{3B}, R^{3B} and R^{4B}, and R^{4B} and R^{5B} each may be combined together to form a ring together with the atoms to which they are attached, and
the ring R^{1B} represents a benzene ring, a pyridine ring or a pyrimidine ring constituted of two carbon atoms, E^{2B}, E^{3B}, E^{4B} and E^{5B}.

11. The light emitting device according to any one of claims 1 to 10, wherein the constitutional unit having a crosslinkable group is a constitutional unit having at least one crosslinkable group selected from Group A of crosslinkable group:
(Group A of crosslinkable group) 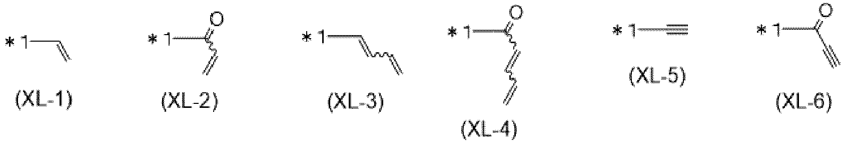 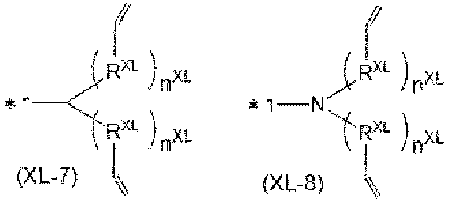 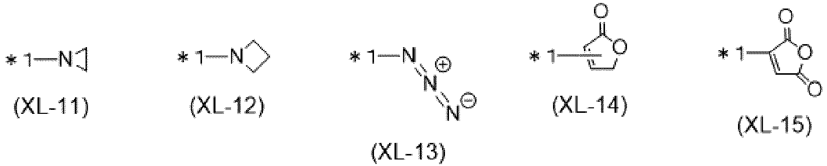 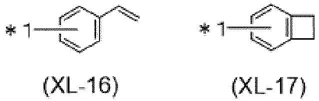 wherein R^{XL} represents a methylene group, an oxygen atom or a sulfur atom, and n^{XL} represents an integer of 0 to 5, and when a plurality of R^{XL} are present, they may be the same or different, and when a plurality of n^{XL} are present, they may be the same or different, and *1 represents a binding position, and these crosslinkable groups each optionally have a substituent.

12. The light emitting device according to claim 11, wherein the constitutional unit having a crosslinkable group is a constitutional unit represented by the formula (2) or a constitutional unit represented by the formula (2'): 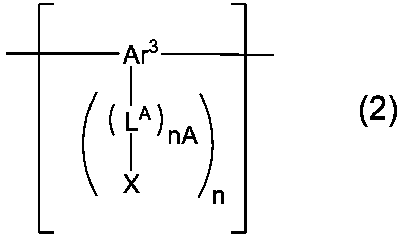 wherein
nA represents an integer of 0 to 5, and n represents 1 or 2,
Ar³ represents an aromatic hydrocarbon group or a heterocyclic group and these groups each optionally have a substituent,
L^{A} represents an alkylene group, a cycloalkylene group, an arylene group, a divalent heterocyclic group, a group represented by -NR'-, an oxygen atom or a sulfur atom and these groups each optionally have a substituent, and R' represents a hydrogen atom, an alkyl group, a cycloalkyl group, an aryl group or a monovalent heterocyclic group and these groups each optionally have a substituent, and when a plurality of L^{A} are present, they may be the same or different, and
X represents a crosslinkable group selected from Group A of crosslinkable group, and when a plurality of X are present, they may be the same or different: 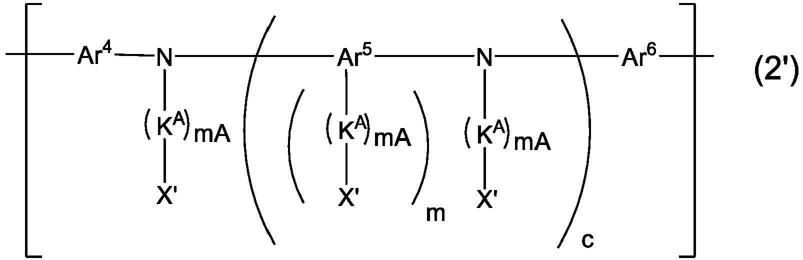 wherein
mA represents an integer of 0 to 5, m represents an integer of 1 to 4, and c represents an integer of 0 or 1, and when a plurality of mA are present, they may be the same or different,
Ar⁵ represents an aromatic hydrocarbon group, a heterocyclic group or a group in which at least one aromatic hydrocarbon ring and at least one heterocyclic ring are bonded directly to each other, and these groups each optionally have a substituent,
Ar⁴ and Ar⁶ each independently represent an arylene group or a divalent heterocyclic group and these groups each optionally have a substituent,
each group of Ar⁴, Ar⁵ and Ar⁶ may be bonded directly or via an oxygen atom or a sulfur atom to a group that is different from that group and that is attached to the nitrogen atom to which that group is attached, thereby forming a ring,
K^{A} represents an alkylene group, a cycloalkylene group, an arylene group, a divalent heterocyclic group, a group represented by -NR'-, an oxygen atom or a sulfur atom and these groups each optionally have a substituent, and R' represents a hydrogen atom, an alkyl group, a cycloalkyl group, an aryl group or a monovalent heterocyclic group and these groups each optionally have a substituent, and when a plurality of K^{A} are present, they may be the same or different, and
X' represents a crosslinkable group selected from Group A of crosslinkable group, a hydrogen atom, an alkyl group, a cycloalkyl group, an aryl group or a monovalent heterocyclic group and these groups each optionally have a substituent, and at least one X' is a crosslinkable group selected from Group A of crosslinkable group.

13. The light emitting device according to claim 11 or 12, wherein the constitutional unit having a crosslinkable group is a constitutional unit having a crosslinkable group represented by the forumula (XL-17).

14. A composition comprising
a compound represented by the formula (H-B) and
a metal complex represented by the formula (1-A1): 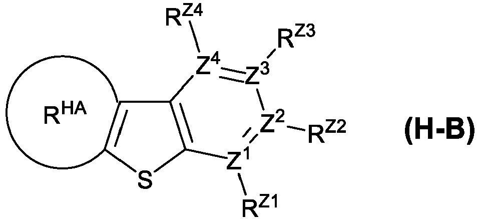 wherein
Z¹, Z², Z³ and Z⁴ each independently represent a carbon atom or a nitrogen atom, and at least one of Z¹, Z², Z³ and Z⁴ is a carbon atom,
R^{Z1}, R^{Z2}, R^{Z3} and R^{Z4} each independently represent a hydrogen atom, an alkyl group, a cycloalkyl group, an alkoxy group, a cycloalkoxy group, an aryl group, an aryloxy group, a monovalent heterocyclic group or a halogen atom and these groups each optionally have a substituent, and R^{Z1} is not present when Z¹ is a nitrogen atom, R^{Z2} is not present when Z² is a nitrogen atom, R^{Z3} is not present when Z³ is a nitrogen atom, and R^{Z4} is not present when Z⁴ is a nitrogen atom, and at least one of R^{Z1}, R^{Z2}, R^{Z3} and R^{Z4} is a monovalent heterocyclic group represented by the formula (H-1),
the ring R^{HA} represents an aromatic hydrocarbon ring or an aromatic heterocyclic ring and these rings each optionally have a substituent, and when a plurality of the substituents are present, they may be the same or different and may be combined together to form a ring together with the atoms to which they are attached, and
R^{Z1} and R^{Z2}, R^{Z2} and R^{Z3}, R^{Z3} and R^{Z4}, R^{Z1} and R^{ZA}, and a substituent which the ring R^{HA} optionally has and R^{Z4} each may be combined together to form a ring together with the atoms to which they are attached: 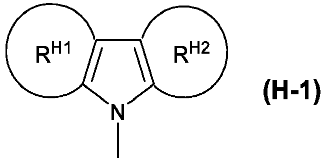 wherein
the ring R^{H1} and the ring R^{H2} each independently represent an aromatic hydrocarbon ring or an aromatic heterocyclic ring and these rings each optionally have a substituent, and when a plurality of the substituents are present, they may be the same or different and may be combined together to form a ring together with the atoms to which they are attached: 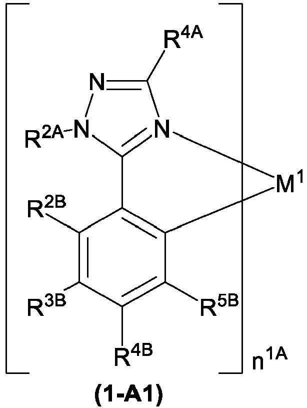 wherein
M¹ represents an iridium atom or a platinum atom,
n^{1A} represents an integer of 2 or 3, and n^{1A} is 3 when M¹ is iridium, while n^{1A} is 2 when M¹ is platinum,
R^{2A}, R^{2B}, R^{3B}, R^{4B} and R^{5B} each independently represent a hydrogen atom, an alkyl group, a cycloalkyl group, an alkoxy group, a cycloalkoxy group, an aryl group, an aryloxy group, a monovalent heterocyclic group, a halogen atom or a dendron and these groups each optionally have a substituent, and R^{4A} represents an alkyl group, a cycloalkyl group, an aryl group, a monovalent heterocyclic group or a dendron and these groups each optionally have a substituent, and when a plurality of R^{2A}, R^{4A}, R^{2B}, R^{3B}, R^{4B} and R^{5B} are present, they may be the same or different at each occurrence, and R^{2A} and R^{2B}, R^{2B} and R^{3B}, R^{3B} and R^{4B}, and R^{4B} and R^{5B} each may be combined together to form a ring together with the atoms to which they are attached, and at least one of R^{2B}, R^{3B} and R^{4B} is a dendron.

## Patentansprüche

1. Lichtemittierende Vorrichtung, die Folgendes umfasst:
eine Anode,
eine Kathode,
eine erste organische Schicht, die zwischen der Anode und der Kathode angeordnet ist, und
eine zweite organische Schicht, die zwischen der Anode und der Kathode angeordnet ist,
wobei die erste organische Schicht eine Schicht ist, die unter Verwendung einer Zusammensetzung erhalten wird, die eine Verbindung der Formel (H-A) und einen Metallkomplex der Formel (1) umfasst, und
die zweite organische Schicht eine Schicht ist, die unter Verwendung einer Polymerverbindung erhalten wird, die eine konstitutionelle Einheit mit einer vernetzbaren Gruppe umfasst: 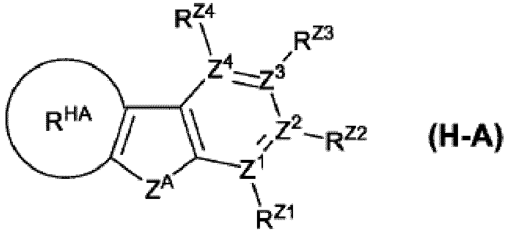 wobei
Z^{A} Folgendes darstellt: eine durch -C(R^{ZA})₂- dargestellte Gruppe, eine durch - Si(R^{ZA})₂- dargestellte Gruppe, eine durch -N(R^{ZA})- dargestellte Gruppe, eine durch - B(R^{ZA})- dargestellte Gruppe, eine durch -P(R^{ZA})- dargestellte Gruppe, eine durch - P(=O)(R^{ZA})- dargestellte Gruppe, ein Schwefelatom oder ein Sauerstoffatom, und R^{ZA} Folgendes darstellt: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom, wobei diese Gruppen jeweils optional einen Substituenten aufweisen, und wenn mehrere R^{ZA} vorhanden sind, diese gleich oder verschieden sein können und zusammen mit den Atomen, an die sie gebunden sind, zu einem Ring zusammengefasst sein können,
Z¹, Z², Z³ und Z⁴ jeweils unabhängig ein Kohlenstoffatom oder ein Stickstoffatom darstellen und mindestens eines von Z¹, Z², Z³ und Z⁴ ein Kohlenstoffatom ist,
R^{Z1}, R^{Z2}, R^{Z3} und R^{Z4} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom, wobei diese Gruppen jeweils optional einen Substituenten aufweisen, und wobei R^{Z1} nicht vorhanden ist, wenn Z¹ ein Stickstoffatom ist, R^{Z2} nicht vorhanden ist, wenn Z² ein Stickstoffatom ist, R^{Z3} nicht vorhanden ist, wenn Z³ ein Stickstoffatom ist, und R^{Z4} nicht vorhanden ist, wenn Z⁴ ein Stickstoffatom ist, und mindestens eines von R^{Z1}, R^{Z2}, R^{Z3} und R^{Z4} eine einwertige heterocyclische Gruppe der Formel (H-1) ist,
der Ring R^{HA} einen aromatischen Kohlenwasserstoffring oder einen aromatischen heterocyclischen Ring darstellt und diese Ringe jeweils optional einen Substituenten aufweisen, und wenn mehrere der Substituenten vorhanden sind, diese gleich oder verschieden sein können und zusammen mit den Atomen, an die sie gebunden sind, einen Ring bilden können, und
R^{Z1} und R^{Z2}, R^{Z2} und R^{Z3}, R^{Z3} und R^{Z4}, R^{Z1} und R^{ZA}, ein Substituent, den der Ring R^{HA} optional aufweist, und R^{ZA}, und ein Substituent, den der Ring R^{HA} optional aufweist, und R^{Z4} jeweils miteinander kombiniert sein können, um zusammen mit den Atomen, an die sie gebunden sind, einen Ring zu bilden: 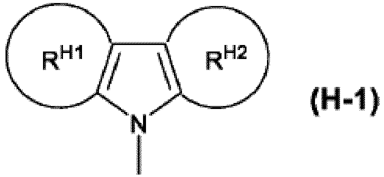 wobei
der Ring R^{H1} und der Ring R^{H2} jeweils unabhängig voneinander einen aromatischen Kohlenwasserstoffring oder einen aromatischen heterocyclischen Ring darstellen und diese Ringe jeweils optional einen Substituenten aufweisen, und wenn mehrere der Substituenten vorhanden sind, diese gleich oder verschieden sein können und zusammen mit den Atomen, an die sie gebunden sind, einen Ring bilden können: 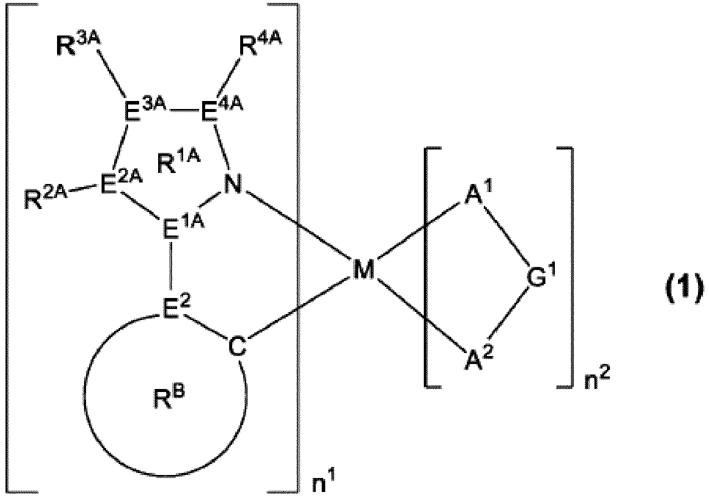 wobei
M ein Rutheniumatom, ein Rhodiumatom, ein Palladiumatom, ein Iridiumatom oder ein Platinatom darstellt,
n¹ eine ganze Zahl von 1 oder mehr darstellt, n² eine ganze Zahl von 0 oder mehr darstellt und n¹+n² 2 oder 3 ist, und n¹+n² 3 ist, wenn M ein Rutheniumatom, ein Rhodiumatom oder ein Iridiumatom ist, während n¹+n² 2 ist, wenn M ein Palladiumatom oder ein Platinatom ist,
E^{1A} ein Kohlenstoffatom darstellt, E^{2A}, E^{3A} und E^{4A} jeweils unabhängig voneinander ein Stickstoffatom oder ein Kohlenstoffatom darstellen, und zwei von E^{2A}, E^{3A} und E^{4A} ein Stickstoffatom sind und das verbleibende ein Kohlenstoffatom ist, und wenn mehrere E^{2A}, E^{3A} und E^{4A} vorhanden sind, sie bei jedem Auftreten gleich oder verschieden sein können,
E² ein Kohlenstoffatom oder ein Stickstoffatom darstellt,
R^{2A} Folgendes darstellt: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, ein Halogenatom oder ein Dendron, wobei diese Gruppen jeweils optional einen Substituenten aufweisen, R^{3A} und R^{4A} jeweils unabhängig voneinander eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, ein Halogenatom oder ein Dendron darstellen und diese Gruppen jeweils optional einen Substituenten aufweisen, und wenn mehrere R^{2A}, R^{3A} und R^{4A} vorhanden sind, diese bei jedem Auftreten gleich oder verschieden sein können, und R^{2A} und R^{3A}, R^{3A} und R^{4A} und ein Substituent, den der Ring R^{B} optional aufweist, und R^{2A} jeweils zusammen mit den Atomen, an die sie gebunden sind, zu einem Ring kombiniert sein können, und R^{2A} entweder vorhanden sein kann oder nicht vorhanden sein kann, wenn E^{2A} ein Stickstoffatom ist, R^{3A} entweder vorhanden sein kann oder nicht vorhanden sein kann, wenn E^{3A} ein Stickstoffatom ist, und R^{4A} entweder vorhanden sein kann oder nicht vorhanden sein kann, wenn E^{4A} ein Stickstoffatom ist,
der Ring R^{1A} einen Triazolring darstellt, der aus einem Stickstoffatom, E^{1A}, E^{2A}, E^{3A} und E^{4A} besteht,
der Ring R^{B} einen 5-gliedrigen oder 6-gliedrigen aromatischen Kohlenwasserstoffring oder einen 5-gliedrigen oder 6-gliedrigen aromatischen heterocyclischen Ring darstellt und diese Ringe jeweils optional einen Substituenten aufweisen, und wenn mehrere der Substituenten vorhanden sind, diese gleich oder verschieden sein können und zusammen mit den Atomen, an die sie gebunden sind, einen Ring bilden können, und wenn mehrere der Ringe R^{B} vorhanden sind, diese gleich oder verschieden sein können und E² ein Kohlenstoffatom ist, wenn der Ring R^{B} ein 6-gliedriger aromatischer heterocyclischer Ring ist,und
A¹-G¹-A² einen anionischen zweizähnigen Liganden darstellt und G¹ eine Atomgruppe darstellt, die zusammen mit A¹ und A² einen zweizähnigen Liganden bildet, und A¹ und A² jeweils unabhängig voneinander ein Kohlenstoffatom, ein Sauerstoffatom oder ein Stickstoffatom darstellen, wobei diese Atome jeweils ein Kohlenstoffatom, ein Sauerstoffatom oder ein Stickstoffatom sein können, die einen Ring bilden, und wenn mehrere A¹-G¹-A² vorhanden sind, sie gleich oder verschieden sein können.

2. Lichtemittierende Vorrichtung nach Anspruch 1, wobei die erste organische Schicht und die zweite organische Schicht benachbart sind.

3. Lichtemittierende Vorrichtung nach Anspruch 1 oder 2, wobei die zweite organische Schicht eine Schicht ist, die zwischen der Anode und der ersten organischen Schicht angeordnet ist.

4. Lichtemittierende Vorrichtung nach einem der Ansprüche 1 bis 3, wobei die durch die Formel (H-A) dargestellte Verbindung eine durch die Formel (H-A1) dargestellte Verbindung ist: 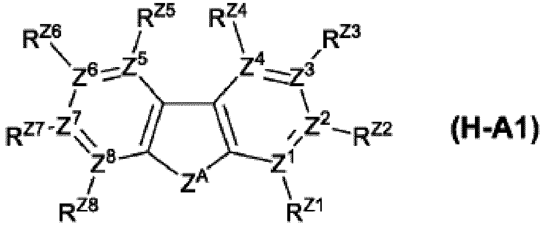 wobei
Z^{A}, Z¹, Z², Z³, Z⁴, R^{Z1}, R^{Z2}, R^{Z3} und R^{Z4} dieselbe Bedeutung wie oben beschrieben haben,
Z⁵, Z⁶, Z⁷ und Z⁸ jeweils unabhängig ein Kohlenstoffatom oder ein Stickstoffatom darstellen,
R^{Z5}, R^{Z6}, R^{Z7} und R^{Z8} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom, wobei diese Gruppen jeweils optional einen Substituenten aufweisen, und R^{Z5} nicht vorhanden ist, wenn Z⁵ ein Stickstoffatom ist, R^{Z6} nicht vorhanden ist, wenn Z⁶ ein Stickstoffatom ist, R^{Z7} nicht vorhanden ist, wenn Z⁷ ein Stickstoffatom ist, und R^{Z8} nicht vorhanden ist, wenn Z⁸ ein Stickstoffatom ist, und
R^{Z4} und R^{Z5}, R^{Z5} und R^{Z6}, R^{Z6} und R^{Z7}, R^{Z7} und R^{Z8}, und R^{Z8} und R^{ZA} jeweils miteinander kombiniert werden können, um zusammen mit den Atomen, an die sie gebunden sind, einen Ring zu bilden.

5. Lichtemittierende Vorrichtung nach Anspruch 4, wobei Z¹, Z², Z³, Z⁴, Z⁵, Z⁶, Z⁷ und Z⁸ jeweils ein Kohlenstoffatom sind.

6. Lichtemittierende Vorrichtung nach einem der Ansprüche 1 bis 5, wobei R^{Z3} eine durch die Formel (H-1) dargestellte Gruppe ist.

7. Lichtemittierende Vorrichtung nach einem der Ansprüche 1 bis 6, wobei Z^{A} eine durch -N(R^{ZA})- dargestellte Gruppe, ein Schwefelatom oder ein Sauerstoffatom ist.

8. Lichtemittierende Vorrichtung nach einem der Ansprüche 1 bis 7, wobei die durch die Formel (H-1) dargestellte Gruppe eine durch die Formel (H-2) dargestellte Gruppe ist: 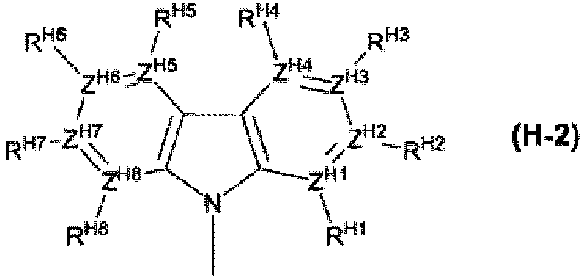 wobei
Z^{H1}, Z^{H2}, Z^{H3} Z^{H4}, Z^{H5}, Z^{H6}, Z^{H7} und Z^{H8} jeweils unabhängig voneinander ein Kohlenstoffatom oder ein Stickstoffatom darstellen,
R^{H1}, R^{H2}, R^{H3}, R^{H4}, R^{H5}, R^{H6}, R^{H7} und R^{H8} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom, wobei diese Gruppen jeweils optional einen Substituenten aufweisen,
R^{H1} nicht vorhanden ist, wenn Z^{H1} ein Stickstoffatom ist, R^{H2} nicht vorhanden ist, wenn Z^{H2} ein Stickstoffatom ist, R^{H3} nicht vorhanden ist, wenn Z^{H3} ein Stickstoffatom ist, R^{H4} nicht vorhanden ist, wenn Z^{H4} ein Stickstoffatom ist, R^{H5} nicht vorhanden ist, wenn Z^{H5} ein Stickstoffatom ist, R^{H6} nicht vorhanden ist, wenn Z^{H6} ein Stickstoffatom ist, R^{H7} nicht vorhanden ist, wenn Z^{H7} ein Stickstoffatom ist, und R^{H8} nicht vorhanden ist, wenn Z^{H8} ein Stickstoffatom ist, und
R^{H1} und R^{H2} , R^{H2} und R^{H3}, R^{H3} und R^{H4}, R^{H4} und R^{H5}, R^{H5} und R^{H6} , R^{H6} und R^{H7}, und R^{H7} und R^{H8} jeweils miteinander verbunden sein können, um einen Ring mit den Kohlenstoffatomen zu bilden, an die sie gebunden sind.

9. Lichtemittierende Vorrichtung nach Anspruch 8, wobei Z^{H} , Z^{H2}, Z^{H3}, Z^{H4}, Z^{H5}, Z^{H6}, Z^{H7} und Z^{H8} jeweils ein Kohlenstoffatom sind.

10. Lichtemittierende Vorrichtung nach einem der Ansprüche 1 bis 9, wobei der Metallkomplex der Formel (1) ein Metallkomplex der Formel (1-A) ist 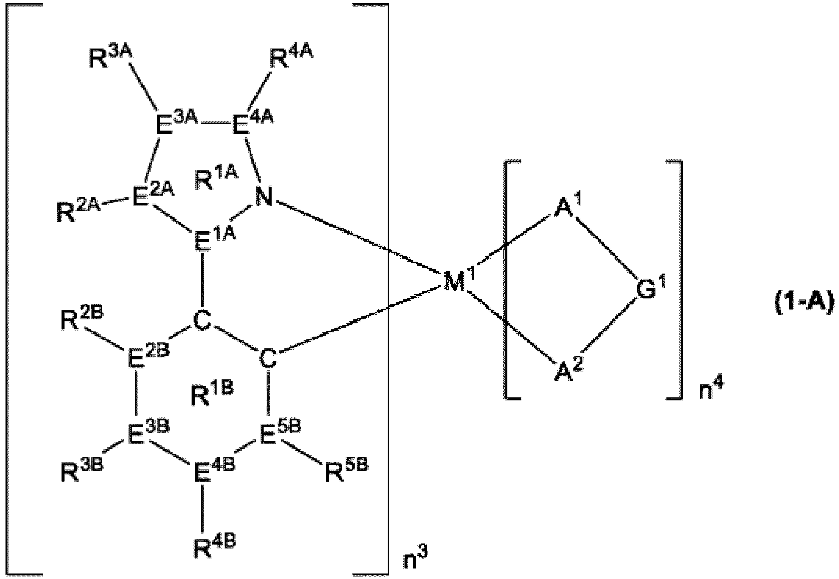 wobei
E^{1A}, E^{2A}, E^{3A}, E^{4A}, R^{2A}, R^{3A}, R^{4A}, der Ring R^{1A} und A¹-G¹-A² die gleiche Bedeutung wie oben beschrieben haben,
M¹ ein Iridiumatom oder ein Platinatom darstellt,
n³ eine ganze Zahl von 1 oder mehr darstellt, n⁴ eine ganze Zahl von 0 oder mehr darstellt und n³ + n⁴ 2 oder 3 ist, und n³ + n⁴ 3 ist, wenn M¹ ein Iridiumatom ist, während n³ + n⁴ 2 ist, wenn M¹ ein Platinatom ist,
E^{2B}, E^{3B}, E^{4B} und E^{5B} jeweils unabhängig voneinander ein Stickstoffatom oder ein Kohlenstoffatom darstellen und mehrere E^{2B}, E^{3B}, E^{4B} und E^{5B} vorhanden sind, sie bei jedem Auftreten gleich oder verschieden sein können, und R^{2B} nicht vorhanden ist, wenn E^{2B} ein Stickstoffatom ist, R^{3B} nicht vorhanden ist, wenn E^{3B} ein Stickstoffatom ist, R^{4B} nicht vorhanden ist, wenn E^{4B} ein Stickstoffatom ist, und R^{5B} nicht vorhanden ist, wenn E^{5B} ein Stickstoffatom ist,
R^{2B}, R^{3B}, R^{4B} und R^{5B} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, ein Halogenatom oder ein Dendron und diese Gruppen jeweils optional einen Substituenten aufweisen, und wenn mehrere R^{2B}, R^{3B}, R^{4B} und R^{5B} vorhanden sind, diese bei jedem Auftreten gleich oder verschieden sein können, und R^{2A} und R^{3A}, R^{3A} und R^{4A}, R^{2A} und R^{2B}, R^{2B} und R^{3B}, R^{3B} und R^{4B}, und R^{4B} und R^{5B} jeweils miteinander verbunden sein können, um zusammen mit den Atomen, an die sie gebunden sind, einen Ring zu bilden, und
der Ring R^{1B} einen Benzolring, einen Pyridinring oder einen Pyrimidinring darstellt, der aus zwei Kohlenstoffatomen besteht, E^{2B}, E^{3B}, E^{4B} und E^{5B}.

11. Lichtemittierende Vorrichtung nach einem der Ansprüche 1 bis 10, wobei die konstitutionelle Einheit mit einer vernetzbaren Gruppe eine konstitutionelle Einheit mit mindestens einer vernetzbaren Gruppe ist, ausgewählt aus Gruppe A der vernetzbaren Gruppe:
(Gruppe A der vernetzbaren Gruppe) 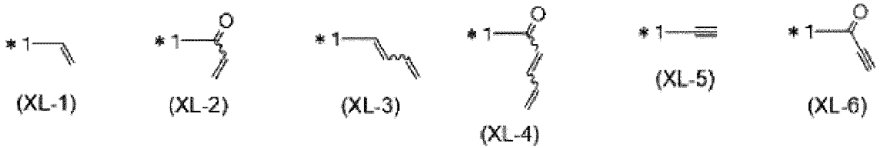 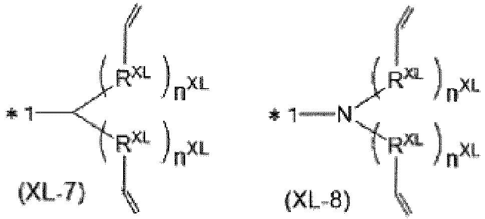 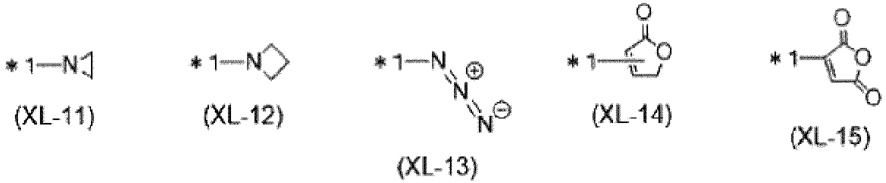 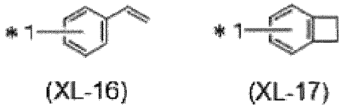 wobei R^{XL} eine Methylengruppe, ein Sauerstoffatom oder ein Schwefelatom darstellt, und n^{XL} eine ganze Zahl von 0 bis 5 darstellt und wenn mehrere R^{XL} vorhanden sind, diese gleich oder verschieden sein können, wenn mehrere n^{XL} vorhanden sind, sie gleich oder verschieden sein können, und *1 eine Bindungsposition darstellt, und diese vernetzbaren Gruppen jeweils optional einen Substituenten auf weisen.

12. Lichtemittierende Vorrichtung nach Anspruch 11, wobei die konstitutionelle Einheit mit einer vernetzbaren Gruppe eine konstitutionelle Einheit der Formel (2) oder eine konstitutionelle Einheit der Formel (2') ist: 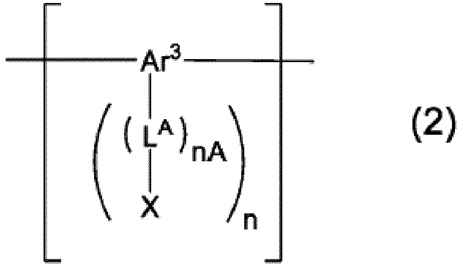 wobei
nA eine ganze Zahl von 0 bis 5 darstellt und n 1 oder 2 darstellt,
Ar³ eine aromatische Kohlenwasserstoffgruppe oder eine heterocyclische Gruppe darstellt und diese Gruppen jeweils optional einen Substituenten aufweisen,
L^{A} Folgendes darstellt: eine Alkylengruppe, eine Cycloalkylengruppe, eine Arylengruppe, eine zweiwertige heterocyclische Gruppe, eine durch -NR'- dargestellte Gruppe, ein Sauerstoffatom oder ein Schwefelatom und wobei diese Gruppen jeweils optional einen Substituenten aufweisen, und R' Folgendes darstellt: ein Wasserstoffatom, eine Alkylgruppe, eine Cycloalkylgruppe, eine Arylgruppe oder eine einwertige heterocyclische Gruppe und diese Gruppen jeweils optional einen Substituenten aufweisen, und wenn mehrere L^{A} vorhanden sind, diese gleich oder verschieden sein können und
X eine vernetzbare Gruppe darstellt, die aus der Gruppe A der vernetzbaren Gruppe ausgewählt ist, und wenn mehrere X vorhanden sind, sie gleich oder verschieden sein können: 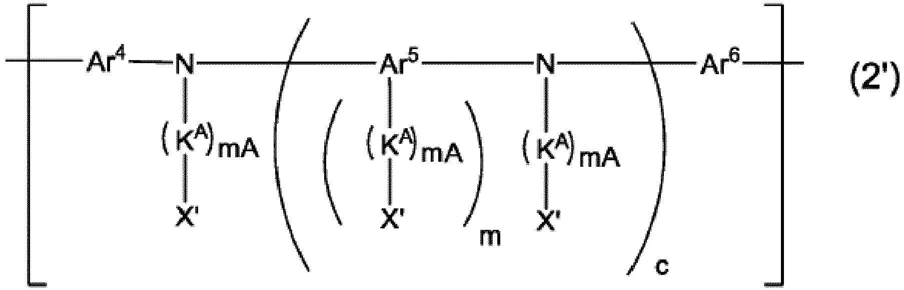 wobei
mA eine ganze Zahl von 0 bis 5 darstellt, m eine ganze Zahl von 1 bis 4 darstellt und c eine ganze Zahl von 0 oder 1 darstellt, und wenn mehrere mA vorhanden sind, sie gleich oder verschieden sein können,
Ar⁵ eine aromatische Kohlenwasserstoffgruppe, eine heterocyclische Gruppe oder eine Gruppe darstellt, in der mindestens ein aromatischer Kohlenwasserstoffring und mindestens ein heterocyclischer Ring direkt aneinander gebunden sind, und diese Gruppen jeweils optional einen Substituenten aufweisen,
Ar4 und Ar⁶ jeweils unabhängig voneinander eine Arylengruppe oder eine zweiwertige heterocyclische Gruppe darstellen und diese Gruppen jeweils optional einen Substituenten aufweisen,
jede Gruppe von Ar⁴, Ar⁵ und Ar⁶ direkt oder über ein Sauerstoffatom oder ein Schwefelatom an eine Gruppe gebunden sein kann, die von dieser Gruppe verschieden ist, und die an das Stickstoffatom gebunden ist, an das diese Gruppe gebunden ist, wodurch ein Ring gebildet wird,
K^{A} Folgendes darstellt: eine Alkylengruppe, eine Cycloalkylengruppe, eine Arylengruppe, eine zweiwertige heterocyclische Gruppe, eine durch -NR'- dargestellte Gruppe, ein Sauerstoffatom oder ein Schwefelatom und wobei diese Gruppen jeweils optional einen Substituenten aufweisen, und R' ein Wasserstoffatom, eine Alkylgruppe, eine Cycloalkylgruppe, eine Arylgruppe oder eine einwertige heterocyclische Gruppe darstellt und diese Gruppen jeweils optional einen Substituenten aufweisen, und wenn mehrere K^{A} vorhanden sind, diese gleich oder verschieden sein können und
X' eine vernetzbare Gruppe, ausgewählt aus Gruppe A einer vernetzbaren Gruppe, ein Wasserstoffatom, eine Alkylgruppe, eine Cycloalkylgruppe, eine Arylgruppe oder eine einwertige heterocyclische Gruppe darstellt und diese Gruppen jeweils optional einen Substituenten aufweisen und mindestens ein X' eine vernetzbare Gruppe ist, ausgewählt aus Gruppe A der vernetzbaren Gruppe.

13. Lichtemittierende Vorrichtung nach Anspruch 11 oder 12, wobei die konstitutionelle Einheit mit einer vernetzbaren Gruppe eine konstitutionelle Einheit mit einer vernetzbaren Gruppe ist, die durch die Forumula (XL-17) dargestellt wird.

14. Zusammensetzung, die Folgendes umfasst:
eine Verbindung der Formel (H-B) und
einen Metallkomplex der Formel (1-A1) 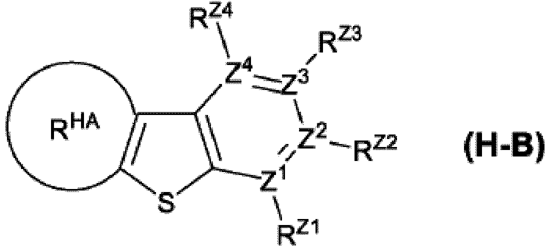 wobei
Z¹, Z², Z³ und Z⁴ jeweils unabhängig ein Kohlenstoffatom oder ein Stickstoffatom darstellen und mindestens eines von Z¹, Z², Z³ und Z⁴ ein Kohlenstoffatom ist,
R^{Z1}, R^{Z2}, R^{Z3} und R^{Z4} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe oder ein Halogenatom, diese Gruppen jeweils optional einen Substituenten aufweisen, und R^{Z1} nicht vorhanden ist, wenn Z¹ ein Stickstoffatom ist, R^{Z2} nicht vorhanden ist, wenn Z² ein Stickstoffatom ist, R^{Z3} nicht vorhanden ist, wenn Z³ ein Stickstoffatom ist, und R^{Z4} nicht vorhanden ist, wenn Z⁴ ein Stickstoffatom ist, und mindestens eines von R^{Z1}, R^{Z2}, R^{Z3} und R^{Z4} eine einwertige heterocyclische Gruppe der Formel (H-1) ist,
der Ring R^{HA} einen aromatischen Kohlenwasserstoffring oder einen aromatischen heterocyclischen Ring darstellt und diese Ringe jeweils optional einen Substituenten aufweisen, und wenn mehrere der Substituenten vorhanden sind, diese gleich oder verschieden sein können und zusammen mit den Atomen, an die sie gebunden sind, zu einem Ring kombiniert werden können, und
R^{Z1} und R^{Z2}, R^{Z2} und R^{Z3}, R^{Z3} und R^{Z4}, R^{Z1} und R^{ZA} und ein Substituent, den der Ring R^{HA} optional aufweist, und R^{Z4} jeweils miteinander kombiniert sein können, um zusammen mit den Atomen, an die sie gebunden sind, einen Ring zu bilden: 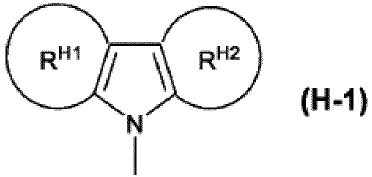 wobei
der Ring R^{H1} und der Ring R^{H2} jeweils unabhängig voneinander einen aromatischen Kohlenwasserstoffring oder einen aromatischen heterocyclischen Ring darstellen und diese Ringe jeweils optional einen Substituenten aufweisen, und wenn mehrere der Substituenten vorhanden sind, diese gleich oder verschieden sein können und zusammen mit den Atomen, an die sie gebunden sind, zu einem Ring kombiniert werden können; 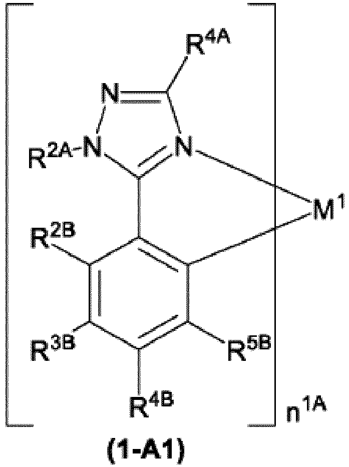 wobei
M¹ ein Iridiumatom oder ein Platinatom darstellt,
n^{1A} eine ganze Zahl von 2 oder 3 darstellt, und n^{1A} 3 ist, wenn M¹ Iridium ist, während n^{1A} 2 ist, wenn M¹ Platin ist,
R^{2A}, R^{2B}, R^{3B}, R^{4B} und R^{5B} jeweils unabhängig voneinander Folgendes darstellen: ein Wasserstoffatom, eine Alkylgruppe, eine Cycloalkylgruppe, eine Alkoxygruppe, eine Cycloalkoxygruppe, eine Arylgruppe, eine Aryloxygruppe, eine einwertige heterocyclische Gruppe, ein Halogenatom oder ein Dendron und diese Gruppen jeweils optional einen Substituenten aufweisen, und R^{4A} eine Alkylgruppe, eine Cycloalkylgruppe, eine Arylgruppe, eine einwertige heterocyclische Gruppe oder ein Dendron darstellt und diese Gruppen jeweils optional einen Substituenten aufweisen, und wenn mehrere R^{2A}, R^{4A}, R^{2B}, R^{3B}, R^{4B} und R^{5B} vorhanden sind, diese bei jedem Auftreten gleich oder verschieden sein können, und R^{2A} und R^{2B}, R^{2B} und R^{3B}, R^{3B} und R^{4B}, und R^{4B} und R^{5B} jeweils miteinander kombiniert werden können, um zusammen mit den Atomen, an die sie gebunden sind, einen Ring zu bilden, wobei mindestens eines von R^{2B}, R^{3B} und R^{4B} ein Dendron ist.

## Revendications

1. Dispositif électroluminescent comprenant
une anode,
une cathode,
une première couche organique disposée entre l'anode et la cathode et
une seconde couche organique disposée entre l'anode et la cathode,
dans lequel la première couche organique est une couche obtenue en utilisant une composition comprenant un composé représenté par la formule (H-A) et un complexe métallique représenté par la formule (1), et
la seconde couche organique est une couche obtenue en utilisant un composé polymère comprenant une unité constitutionnelle ayant un groupe réticulable : 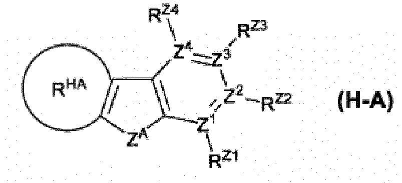 dans lequel
Z^{A} représente un groupe représenté par -C(R^{ZA})₂-, un groupe représenté par -Si(R^{ZA})₂-, un groupe représenté par -N(R^{ZA})-, un groupe représenté par -B(R^{ZA})-, un groupe représenté par -P(R^{ZA})-, un groupe représenté par -P(=O)(R^{ZA})-, un atome de soufre ou un atome d'oxygène, et R^{ZA} représente un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant, et lorsqu'une pluralité de R^{ZA} sont présents, ils peuvent être identiques ou différents et peuvent être combinés ensemble pour former un cycle avec les atomes auxquels ils sont attachés,
Z¹, Z², Z³ et Z⁴ représentent chacun indépendamment un atome de carbone ou un atome d'azote, et au moins l'un de Z¹, Z², Z³ et Z⁴ est un atome de carbone,
R^{Z1}, R^{Z1}, R^{Z3} et R^{Z4} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant, et R^{Z1} n'est pas présent lorsque Z¹ est un atome d'azote, R^{Z2} n'est pas présent lorsque Z² est un atome d'azote, R^{Z3} n'est pas présent lorsque Z³ est un atome d'azote, et R^{Z4} n'est pas présent lorsque Z⁴ est un atome d'azote, et au moins l'un de R^{Z1}, R^{Z1}, R^{Z3} et R^{Z4} est un groupe hétérocyclique monovalent représenté par la formule (H-1),
le cycle R^{HA} représente un cycle hydrocarboné aromatique ou cycle hétérocyclique aromatique et ces cycles ont chacun éventuellement un substituant, et lorsqu'une pluralité de substituants sont présents, ils peuvent être identiques ou différents et peuvent être combinés ensemble pour former un cycle avec les atomes auxquels ils sont attachés, et
R^{Z1} et R^{Z1}, R^{Z2} et R^{Z3}, R^{Z3} et R^{Z4}, R^{Z1} et R^{ZA}, un substituant que le cycle R^{HA} a éventuellement et R^{ZA}, et un substituant que le cycle R^{HA} a éventuellement et R^{Z4} peuvent chacun être combinés ensemble pour former un cycle avec les atomes auxquels ils sont attachés : 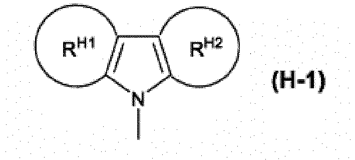 dans lequel
le cycle R^{H1} et le cycle R^{H2} représentent chacun indépendamment un cycle hydrocarboné aromatique ou un cycle hétérocyclique aromatique et ces cycles ont chacun éventuellement un substituant, et lorsque plusieurs substituants sont présents, ils peuvent être identiques ou différents et peuvent être combinés ensemble pour former un cycle avec les atomes auxquels ils sont attachés : 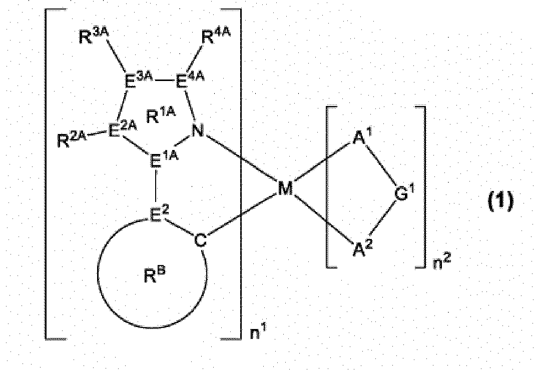 dans lequel
M représente un atome de ruthénium, un atome de rhodium, un atome de palladium, un atome d'iridium ou un atome de platine,
n¹ représente un entier de 1 ou plus, n² représente un entier de 0 ou plus, et n¹+n² vaut 2 ou 3, et n¹+n² vaut 3 lorsque M est un atome de ruthénium, un atome de rhodium ou un atome d'iridium, tandis que n¹+n² est 2 lorsque M est un atome de palladium ou un atome de platine,
E^{1A} représente un atome de carbone, E^{2A}, E^{3A} et E^{4A} chacun représentent indépendamment un atome d'azote ou un atome de carbone, et deux de E^{2A}, E^{3A} et E^{4A} sont un atome d'azote et l'atome restant est un atome de carbone, et lorsqu'une pluralité de E^{2A}, E^{3A} et E^{4A} sont présents, ils peuvent être identiques ou différent à chaque occurrence,
E² représente un atome de carbone ou un atome d'azote,
R^{2A} représente un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un atome d'halogène ou un dendron et ces groupes ont chacun éventuellement un substituant, R^{3A} et R^{4A} représentent chacun indépendamment un groupe alkyle, un groupe cycloalkyle, un groupe alcoxy, un groupe cycloalcoxy, un groupe aryle, un groupe aryloxy, un groupe hétérocyclique monovalent, un atome d'halogène ou un dendron et ces groupes ont chacun éventuellement un substituant, et lorsqu'une pluralité de R^{2A}, R^{3A} et R^{4A} sont présents, ils peuvent être identiques ou différents à chaque occurrence, et R^{2A} et R^{3A}, R^{3A} et R^{4A}, et un substituant que le cycle R^{B} a éventuellement et R^{2A} chacun peuvent être combinés ensemble pour former un cycle avec les atomes auxquels ils sont attachés, et R^{2A} peut être présent ou non lorsque E^{2A} est un atome d'azote, R^{3A} peut être présent ou non lorsque E^{3A} est un atome d'azote, et R^{4A} peut être présent ou non lorsque E^{4A} est un atome d'azote,
le cycle R^{1A} représente un cycle triazole constitué d'un atome d'azote, E^{1A}, E^{2A}, E^{3A} et E^{4A},
le cycle R^{B} représente un cycle hydrocarboné aromatique à 5 ou 6 chaînons ou un cycle hétérocyclique aromatique à 5 ou 6 chaînons et ces cycles ont chacun éventuellement un substituant, et lorsqu'une pluralité de substituants sont présents, ils peuvent être identiques ou différents et peuvent être combinés ensemble pour former un cycle avec les atomes auxquels ils sont attachés, et lorsqu'une pluralité de cycles R^{B} sont présents, ils peuvent être identiques ou différents, et E² est un atome de carbone lorsque le cycle R^{B} est un cycle hétérocyclique aromatique à 6 chaînons, et
A¹-G¹-A² représente un ligand bidenté anionique, et G¹ représente un groupe atomique constituant un ligand bidenté avec A¹ et A², et A¹ et A² représentent chacun indépendamment un atome de carbone, un atome d'oxygène ou un atome d'azote et ces atomes peuvent chacun être un atome de carbone, un atome d'oxygène ou un atome d'azote constituant un cycle, et lorsqu'une pluralité de A¹-G¹-A² sont présents, ils peuvent être identiques ou différents.

2. Dispositif électroluminescent selon la revendication 1, dans lequel la première couche organique et la seconde couche organique sont adjacentes.

3. Dispositif électroluminescent selon la revendication 1 ou 2, dans lequel la seconde couche organique est une couche disposée entre l'anode et la première couche organique.

4. Dispositif électroluminescent selon l'une quelconque des revendications 1 à 3, dans lequel le composé représenté par la formule (H-A) est un composé représenté par la formule (HA1) : 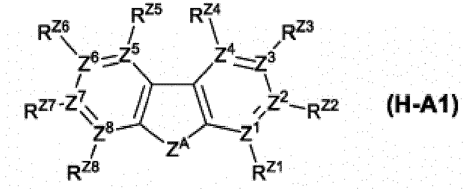 dans lequel
Z^{A}, Z¹, Z², Z³, Z⁴, R^{Z1}, R^{Z1}, R^{Z3} et R^{Z4} ont la même signification que celle indiquée ci-dessus, Z⁵, Z⁶, Z⁷ et Z⁸ représentent chacun indépendamment un atome de carbone ou un atome d'azote, R^{Z5}, R^{Z6}, R^{Z7} et R^{Z8} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant, et R^{Z5} n'est pas présent lorsque Z⁵ est un atome d'azote, R^{Z6} n'est pas présent lorsque Z⁶ est un atome d'azote, R^{Z7} n'est pas présent lorsque Z⁷ est un atome d'azote et R^{Z8} n'est pas présent lorsque Z⁸ est un atome d'azote, et
R^{Z4} et R^{Z5}, R^{Z5} et R^{Z6}, R^{Z6} et R^{Z7}, R^{Z7} et R^{Z8}, et R^{Z8} et R^{ZA} peuvent chacun être combinés ensemble pour former un cycle avec les atomes auxquels ils sont attachés.

5. Dispositif électroluminescent selon la revendication 4, dans lequel Z¹, Z², Z³, Z⁴, Z⁵, Z⁶, Z⁷ et Z⁸ sont chacun un atome de carbone.

6. Dispositif électroluminescent selon l'une quelconque des revendications 1 à 5, dans lequel R^{Z3} est un groupe représenté par la formule (H-1).

7. Dispositif électroluminescent selon l'une quelconque des revendications 1 à 6, dans lequel Z^{A} est un groupe représenté par -N(R^{ZA})-, un atome de soufre ou un atome d'oxygène.

8. Dispositif électroluminescent selon l'une quelconque des revendications 1 à 7, dans lequel le groupe représenté par la formule (H-1) est un groupe représenté par la formule (H-2) : 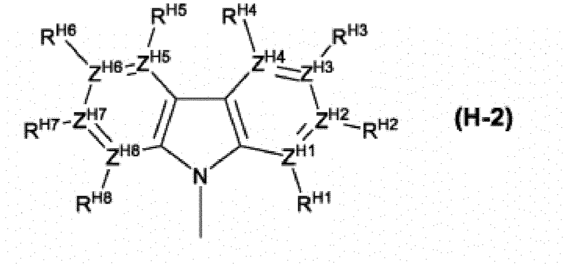 dans lequel
Z^{H1}, Z^{H2}, Z^{H3}, Z^{H4}, Z^{H5}, Z^{H6}, Z^{H7} et Z^{H8} représentent chacun indépendamment un atome de carbone ou un atome d'azote,
R^{H1}, R^{H2}, R^{H3}, R^{H4}, R^{H5}, R^{H6}, R^{H7} et R^{H8} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant,
R^{H1} n'est pas présent lorsque Z^{H1} est un atome d'azote, R^{H2} n'est pas présent lorsque Z^{H2} est un atome d'azote, R^{H3} n'est pas présent lorsque Z^{H3} est un atome d'azote, R^{H4} n'est pas présent lorsque Z^{H4} est un atome d'azote, R^{H5} n'est pas présent lorsque Z^{H5} est un atome d'azote, R^{H6} n'est pas présent lorsque Z^{H6} est un atome d'azote, R^{H7} n'est pas présent lorsque Z^{H7} est un atome d'azote, et R^{H8} n'est pas présent lorsque Z^{H8} est un atome d'azote, et
R^{H1} et R^{H2}, R^{H2} et R^{H3}, R^{H3} et R^{H4}, R^{H4} et R^{H5}, R^{H5} et R^{H6}, R^{H6} et R^{H7}, et R^{H7} et R^{H8} peuvent chacun être combinés ensemble pour former un cycle avec les atomes de carbone auxquels ils sont attachés.

9. Dispositif électroluminescent selon la revendication 8, dans lequel Z^{H1}, Z^{H2}, Z^{H3}, Z^{H4}, Z^{H5}, Z^{H6}, Z^{H7} et Z^{H8} sont chacun un atome de carbone.

10. Dispositif électroluminescent selon l'une quelconque des revendications 1 à 9, dans lequel le complexe métallique représenté par la formule (1) est un complexe métallique représenté par la formule (1-A) : 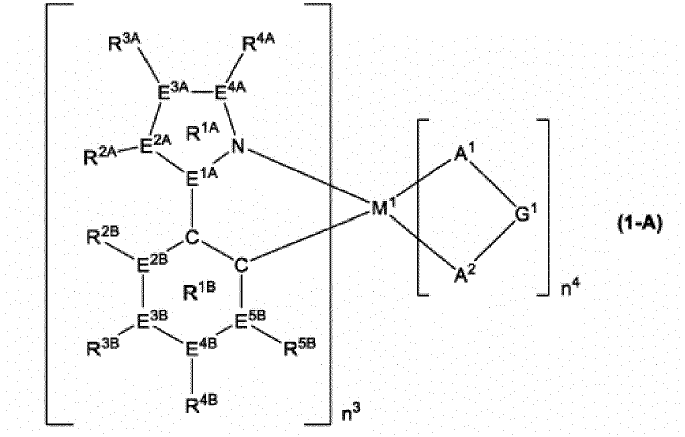 dans lequel
E^{1A}, E^{2A}, E^{3A}, E^{4A}, R^{2A}, R^{3A}, R^{4A}, le cycle R^{1A} et A¹-G¹-A² ont la même signification que celle indiquée ci-dessus,
M¹ représente un atome d'iridium ou un atome de platine,
n³ représente un entier de 1 ou plus, n⁴ représente un entier de 0 ou plus , et n³+n⁴ vaut 2 ou 3, et n³+n⁴ vaut 3 lorsque M¹ est un atome d'iridium, tandis que n³+n⁴ vaut 2 lorsque M¹ est un atome de platine,
E^{2B}, E^{3B}, E^{4B} et E^{5B} représentent chacun indépendamment un atome d'azote ou un atome de carbone, et une pluralité de E^{2B}, E^{3B}, E^{4B} et E^{5B} sont présents, ils peuvent être identiques ou différents à chaque occurrence, et R^{2B} n'est pas présent lorsque E^{2B} est un atome d'azote, R^{3B} n'est pas présent lorsque E^{3B} est un atome d'azote, R^{4B} n'est pas présent lorsque E^{4B} est un atome d'azote, et R^{5B} n'est pas présent lorsque E^{5B} est un atome d'azote,
R^{2B}, R^{3B}, R^{4B} et R^{5B} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un atome d'halogène ou un dendron et ces groupes ont chacun éventuellement un substituant, et lorsqu'une pluralité de R^{2B}, R^{3B}, R^{4B} et R^{5B} sont présents, ils peuvent être identiques ou différents à chaque occurrence, et R^{2A} et R^{3A}, R^{3A} et R^{4A}, R^{2A} et R^{2B}, R^{2B} et R^{3B}, R^{3B} et R^{4B}, et R^{4B} et R^{5B} peuvent chacun être combinés pour former un cycle avec les atomes auxquels ils sont liés, et
le cycle R^{1B} représente un cycle benzénique, un cycle pyridine ou un cycle pyrimidine constitué de deux atomes de carbone, E^{2B}, E^{3B}, E^{4B} et E^{5B}.

11. Dispositif électroluminescent selon l'une quelconque des revendications 1 à 10, dans lequel l'unité constitutionnelle ayant un groupe réticulable est une unité constitutionnelle ayant au moins un groupe réticulable choisi dans le Groupe A de groupe réticulable :
(Groupe A de groupe réticulable) 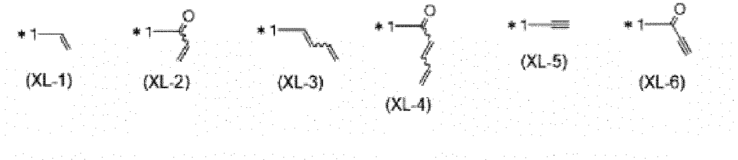 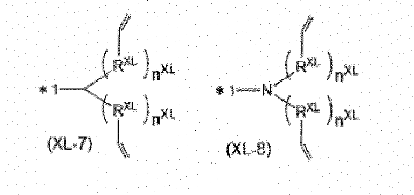 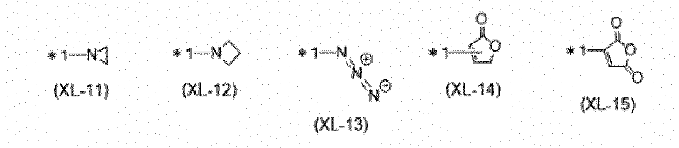 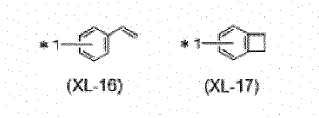 dans lequel R^{XL} représente un groupe méthylène, un atome d'oxygène ou un atome de soufre, et n^{XL} représente un nombre entier de 0 à 5, et lorsqu'une pluralité de R^{XL} sont présents, ils peuvent être identiques ou différents, et lorsqu'une pluralité de n^{XL} sont présents, ils peuvent être identiques ou différents, et *1 représente une position de liaison, et ces groupes réticulables ont chacun éventuellement un substituant.

12. Dispositif électroluminescent selon la revendication 11, dans lequel l'unité constitutionnelle ayant un groupe réticulable est une unité constitutionnelle représentée par la formule (2) ou une unité constitutionnelle représentée par la formule (2') : 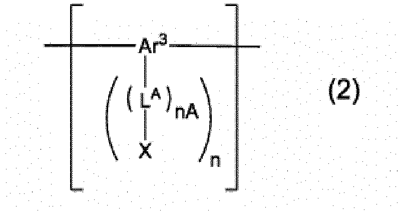 dans lequel
nA représente un nombre entier de 0 à 5, et n représente 1 ou 2,
Ar³ représente un groupe hydrocarboné aromatique ou un groupe hétérocyclique et ces groupes ont chacun éventuellement un substituant,
L^{A} représente un groupe alkylène, un groupe cycloalkylène, un groupe arylène, un groupe hétérocyclique divalent, un groupe représenté par -NR'-, un atome d'oxygène ou un atome de soufre et ces groupes ont chacun éventuellement un substituant, et R' représente un atome d'hydrogène, un groupe alkyle, un groupe cycloalkyle, un groupe aryle ou un groupe hétérocyclique monovalent et ces groupes ont chacun éventuellement un substituant, et lorsqu'une pluralité de L^{A} sont présents, ils peuvent être identiques ou différents, et
X représente un groupe réticulable choisi dans le groupe A de groupe réticulable, et lorsqu'une pluralité de X sont présents, ils peuvent être identiques ou différents : 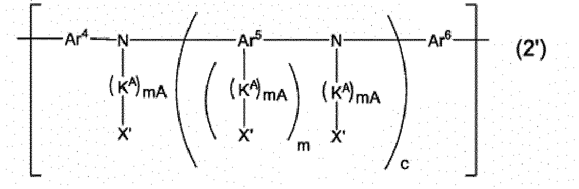 dans lequel
mA représente un nombre entier de 0 à 5, m représente un nombre entier de 1 à 4, et c représente un nombre entier de 0 ou 1, et lorsqu'une pluralité de mA sont présents, ils peuvent être identiques ou différents,
Ar⁵ représente un groupe hydrocarboné aromatique, un groupe hétérocyclique ou un groupe dans lequel au moins un cycle hydrocarboné aromatique et au moins un cycle hétérocyclique sont liés directement l'un à l'autre, et ces groupes ont chacun éventuellement un substituant,
Ar⁴ et Ar⁶ représentent chacun indépendamment un groupe arylène ou un groupe hétérocyclique divalent et ces groupes ont chacun éventuellement un substituant,
chaque groupe de Ar⁴, Ar⁵ et Ar⁶ peut être lié directement ou par l'intermédiaire d'un atome d'oxygène ou d'un atome de soufre à un groupe différent de ce groupe et qui est attaché à l'atome d'azote auquel ce groupe est attaché, formant ainsi un cycle,
K^{A} représente un groupe alkylène, un groupe cycloalkylène, un groupe arylène, un groupe hétérocyclique divalent, un groupe représenté par -NR'-, un atome d'oxygène ou un atome de soufre et ces groupes ont chacun éventuellement un substituant, et R' représente un atome d'hydrogène, un groupe alkyle, un groupe cycloalkyle, un groupe aryle ou un groupe hétérocyclique monovalent et ces groupes ont chacun éventuellement un substituant, et lorsqu'une pluralité de K^{A} sont présents, ils peuvent être identiques ou différents, et
X' représente un groupe réticulable choisi dans le groupe A de groupe réticulable, un atome d'hydrogène, un groupe alkyle, un groupe cycloalkyle, un groupe aryle ou un groupe hétérocyclique monovalent et ces groupes ont chacun éventuellement un substituant, et au moins un X' est un groupe réticulable choisi dans le groupe A de groupe réticulable.

13. Dispositif électroluminescent selon la revendication 11 ou 12, dans lequel l'unité constitutionnelle ayant un groupe réticulable est une unité constitutionnelle ayant un groupe réticulable représenté par la formule (XL-17).

14. Composition comprenant
un composé représenté par la formule (H-B) et
un complexe métallique représenté par la formule (1-A1) : 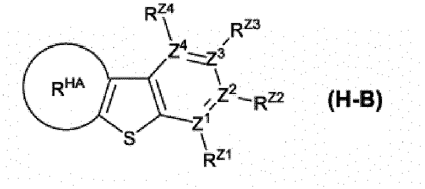 dans lequel
Z¹, Z², Z³ et Z⁴ représentent chacun indépendamment un atome de carbone ou un atome d'azote, et au moins l'un de Z¹, Z², Z³ et Z⁴ est un atome de carbone,
R^{Z1}, R^{Z1}, R^{Z3} et R^{Z4} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent ou un atome d'halogène et ces groupes ont chacun éventuellement un substituant, et R^{Z1} n'est pas présent lorsque Z¹ est un atome d'azote, R^{Z2} n'est pas présent lorsque Z² est un atome d'azote, R^{Z3} n'est pas présent lorsque Z³ est un atome d'azote, et R^{Z4} n'est pas présent lorsque Z⁴ est un atome d'azote, et au moins l'un de R^{Z1}, R^{Z1}, R^{Z3} et R^{Z4} est un groupe hétérocyclique monovalent représenté par la formule (H-1), le cycle R^{HA} représente un cycle hydrocarboné aromatique ou un hétérocycle aromatique et ces cycles ont chacun éventuellement un substituant, et lorsqu'une pluralité de substituants sont présents, ils peuvent être identiques ou différents et peuvent être combinés ensemble pour former un cycle avec les atomes auxquels ils sont liés, et
R^{Z1} et R^{Z1}, R^{Z2} et R^{Z3}, R^{Z3} et R^{Z4}, R^{Z1} et R^{ZA}, et un substituant que le cycle R^{HA} a éventuellement et R^{Z4} chacun peuvent être combinés ensemble pour former un cycle avec les atomes auxquels ils sont attachés : 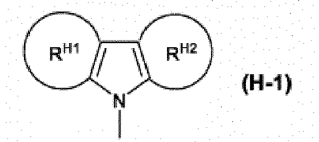 dans lequel
le cycle R^{H1} et le cycle R^{H2} représentent chacun indépendamment un cycle hydrocarboné aromatique ou un cycle aromatique hétérocyclique et ces cycles ont chacun éventuellement un substituant, et lorsqu'une pluralité de substituants sont présents, ils peuvent être identiques ou différents et peuvent être combinés ensemble pour former un cycle avec les atomes auxquels ils sont attachés : 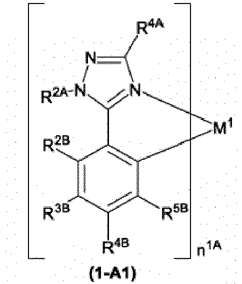 dans lequel
M¹ représente un atome d'iridium ou un atome de platine,
n^{1A} représente un nombre entier de 2 ou 3, et n^{1A} vaut 3 lorsque M¹ est l'iridium, tandis que n^{1A} vaut 2 lorsque M¹ est le platine,
R^{2A}, R^{2B}, R^{3B}, R^{4B} et R^{5B} représentent chacun indépendamment un atome d'hydrogène, un groupe alkyle, un groupe cycloalkyle, un groupe alcoxy, un groupe cycloalcoxy, un groupe aryle, un groupe aryloxy, un groupe hétérocyclique monovalent, un atome d'halogène ou un dendron et ces groupes ont chacun éventuellement un substituant, et R^{4A} représente un groupe alkyle, un groupe cycloalkyle, un groupe aryle, un groupe hétérocyclique monovalent ou un dendron et ces groupes ont chacun éventuellement un substituant, et lorsqu'une pluralité de R^{2A}, R^{4A}, R^{2B}, R^{3B}, R^{4B} et R^{5B} sont présents, ils peuvent être identiques ou différents à chaque occurrence, et R^{2A} et
R^{2B}, R^{2B} et R^{3B}, R^{3B} et R^{4B}, et R^{4B} et R^{5B} peuvent chacun être combinés pour former un cycle avec les atomes auxquels ils sont liés, et au moins l'un de R^{2B}, R^{3B} et R^{4B} est un dendron.
